# EUROPEAN PATENT APPLICATION

(11) **EP 4 579 750 A1**
(43) Date of publication of application: **02.07.2025**
(21) Application number: 23857170.7
(22) Date of filing: 07.08.2023
(51) Int. Cl.: H01L 27/146, H04N 25/70

(54) **IMAGING ELEMENT AND DISTANCE MEASURING DEVICE**

(30) Priority: 24.08.2022 JP 2022133369
(71) Applicant: Sony Semiconductor Solutions Corporation, Atsugi-shi, Kanagawa 243-0014 (JP)
(72) Inventor: SATO, Yusuke, Atsugi-shi, Kanagawa 243-0014 (JP); OKADA, Chihiro, Atsugi-shi, Kanagawa 243-0014 (JP); YOKOGAWA, Sozo, Atsugi-shi, Kanagawa 243-0014 (JP); ITO, Hiroshi, Atsugi-shi, Kanagawa 243-0014 (JP); TSUKIMURA, Gouki, Atsugi-shi, Kanagawa 243-0014 (JP)
(74) Representative: Müller Hoffmann & Partner
(86) International application number: PCT/JP2023/028738
(87) International publication number: WO 2024/043056

(57) **Abstract**

The present technology relates to an imaging element and a distance measuring device capable of making uniform parasitic capacitances generated between wirings for each wiring.

There are provided with a photoelectric conversion unit configured to perform photoelectric conversion; first and second charge storage units configured to store a charge obtained by the photoelectric conversion unit; a first transfer unit configured to transfer the charge from the photoelectric conversion unit to the first charge storage unit;
a second transfer unit configured to transfer the charge from the photoelectric conversion unit to the second charge storage unit; and
a wiring layer provided with a plurality of wirings, in which a first wiring connected to the first transfer unit and a second wiring connected to the second transfer unit are arranged in the wiring layer, a drive wiring configured to supply a drive signal or/and a fixed voltage wiring configured to supply a predetermined voltage are arranged therein, and the number of the drive wirings or/and the fixed voltage wirings adjacent to the first wiring, and the number of the drive wirings or/and the fixed voltage wirings adjacent to the second wiring are the same. The present technology can be applied to, for example, an imaging element having a plurality of taps and performing distance measurement.

## Description

### TECHNICAL FIELD

The present technology relates to an imaging element and a distance measuring device, and for example, relates to an imaging element suitable for use in the distance measuring device and a distance measuring device.

### BACKGROUND ART

In recent years, with the progress of semiconductor technology, miniaturization of a distance measuring module for measuring a distance to an object has progressed. This makes it possible to mount the distance measuring module on, for example, a mobile terminal such as a so-called smartphone, which is a small information processing apparatus having a communication function.

In general, as a distance measuring method in the distance measuring module, in a ToF method including a time of flight (TOF) method, light emitted toward an object and reflected on a surface of the object is detected, and a distance to the object is calculated on the basis of a measurement value obtained by measuring a flight time of the light. An imaging element that measures the distance to the object by the ToF method is known. In the imaging element of the ToF method, reflected light obtained by light emitted from a light source hitting an object and being reflected is photoelectrically converted by a photodiode. Signal charges generated by the photoelectric conversion is distributed to two floating diffusions (FDs) by a pair of alternately driven gate electrodes (see, for example, Patent Document 1)..

### CITATION LIST

### PATENT DOCUMENT

Patent Document 1: Japanese Patent Application Laid-Open No. 2021-97214

### SUMMARY OF THE INVENTION

### PROBLEMS TO BE SOLVED BY THE INVENTION

In the imaging element of the ToF method, signal charges generated by photoelectric conversion are distributed to two floating diffusions by a pair of gate electrodes alternately driven. Therefore, two wirings for supplying signals for driving the pair of gate electrodes are provided. The imaging element includes a plurality of wirings in addition to these wirings.

In a case where a plurality of wirings is arranged in a wiring layer, there is a possibility that a parasitic capacitance is generated between adjacent wirings. As the imaging element is downsized, a distance between the wirings is also narrowed, and there is a possibility that a parasitic capacitance is likely to occur. If the parasitic capacitances generated in the wirings to two gate electrodes are different, there is a possibility that a difference occurs in charge distribution performance to two floating diffusions, and distance measurement accuracy is reduced.

The present technology has been made in view of such a situation, and is to make parasitic capacitances generated in predetermined wirings uniform.

### SOLUTIONS TO PROBLEMS

An imaging element according to one aspect of the present technology includes: a photoelectric conversion unit configured to perform photoelectric conversion; first and second charge storage units configured to store a charge obtained by the photoelectric conversion unit; a first transfer unit configured to transfer the charge from the photoelectric conversion unit to the first charge storage unit; a second transfer unit configured to transfer the charge from the photoelectric conversion unit to the second charge storage unit; and a wiring layer provided with a plurality of wirings, in which a first wiring connected to the first transfer unit and a second wiring connected to the second transfer unit are arranged in the wiring layer, and a drive wiring configured to supply a drive signal or/and a fixed voltage wiring configured to supply a predetermined voltage are arranged, and the number of the drive wirings or/and the fixed voltage wirings adjacent to the first wiring, and the number of the drive wirings or/and the fixed voltage wirings adjacent to the second wiring are the same.

A distance measuring device according to another aspect of the present technology includes: a light emitting unit that emits irradiation light; and a light receiving element that receives reflected light obtained by reflecting light from the light emitting unit to an object, in which the light receiving element includes: a photoelectric conversion unit configured to perform photoelectric conversion; first and second charge storage units configured to store a charge obtained by the photoelectric conversion unit; a first transfer unit configured to transfer the charge from the photoelectric conversion unit to the first charge storage unit; a second transfer unit configured to transfer the charge from the photoelectric conversion unit to the second charge storage unit; and a wiring layer provided with a plurality of wirings, in which a first wiring connected to the first transfer unit and a second wiring connected to the second transfer unit are arranged in the wiring layer, and a drive wiring configured to supply a drive signal or/and a fixed voltage wiring configured to supply a predetermined voltage are arranged, and the number of the drive wirings or/and the fixed voltage wirings adjacent to the first wiring, and the number of the drive wirings or/and the fixed voltage wirings adjacent to the second wiring are the same.

An imaging element according to still another aspect of the present technology includes a photoelectric conversion unit that performs photoelectric conversion, first and second charge storage units that store a charge obtained by the photoelectric conversion unit, a first transfer unit that transfers the charge from the photoelectric conversion unit to the first charge storage unit, a second transfer unit that transfers the charge from the photoelectric conversion unit to the second charge storage unit, and a wiring layer provided with a plurality of wirings. In the wiring layer, a first wiring connected to the first transfer unit and a second wiring connected to the second transfer unit are arranged, a drive wiring that supplies a drive signal or/and a fixed voltage wiring that supplies a predetermined voltage are arranged, and the number of the drive wirings or/and fixed voltage wirings adjacent to the first wiring and the number of the drive wirings or/and fixed voltage wirings adjacent to the second wiring are the same.

A distance measuring device according to yet another aspect of the present technology includes a light emitting unit that emits irradiation light and a light receiving element that receives reflected light obtained by reflecting light from the light emitting unit to an object. The light receiving element includes:
a photoelectric conversion unit configured to perform photoelectric conversion; first and second charge storage units configured to store a charge obtained by the photoelectric conversion unit; a first transfer unit configured to transfer the charge from the photoelectric conversion unit to the first charge storage unit;
a second transfer unit configured to transfer the charge from the photoelectric conversion unit to the second charge storage unit; and
a wiring layer provided with a plurality of wirings, in which a first wiring connected to the first transfer unit and a second wiring connected to the second transfer unit are arranged in the wiring layer, a drive wiring configured to supply a drive signal or/and a fixed voltage wiring configured to supply a predetermined voltage are arranged therein, and the number of the drive wirings or/and the fixed voltage wirings adjacent to the first wiring, and the number of the drive wirings or/and the fixed voltage wirings adjacent to the second wiring are the same.

Note that the distance measuring device may be an independent device or an internal block configuring one apparatus.

### BRIEF DESCRIPTION OF DRAWINGS

Fig. 1 is a diagram illustrating a configuration of an imaging element.
Fig. 2 is a diagram illustrating an arrangement of a power supply circuit of the imaging element.
Fig. 3 is a diagram illustrating a circuit configuration example of a pixel.
Fig. 4 is a diagram illustrating a planar configuration example of the pixel.
Fig. 5 is a diagram illustrating a planar configuration example of the pixel.
Fig. 6 is a diagram illustrating a cross-sectional configuration example of the pixel.
Fig. 7 is a diagram illustrating a cross-sectional configuration example of the pixel.
Fig. 8 is a diagram illustrating a circuit configuration example of the pixel.
Fig. 9 is a diagram illustrating a circuit configuration example of the pixel.
Fig. 10 is a diagram illustrating a planar configuration example of the pixel.
Fig. 11 is a diagram illustrating a planar configuration example of the pixel.
Fig. 12 is a diagram illustrating the arrangement of wirings.
Fig. 13 is a diagram illustrating the arrangement of wirings.
Fig. 14 is a diagram illustrating the arrangement of wirings.
Fig. 15 is a diagram illustrating the arrangement of wirings.
Fig. 16 is a diagram illustrating the arrangement of wirings.
Fig. 17 is a diagram illustrating the arrangement of wirings.
Fig. 18 is a diagram illustrating the arrangement of wirings.
Fig. 19 is a diagram illustrating the arrangement of wirings.
Fig. 20 is a diagram illustrating a circuit configuration example of a pixel.
Fig. 21 is a diagram illustrating a circuit configuration example of the pixel.
Fig. 22 is a diagram illustrating a planar configuration example of the pixel.
Fig. 23 is a diagram illustrating a circuit configuration example of the pixel.
Fig. 24 is a diagram illustrating a cross-sectional configuration example of a CAPD pixel.
Fig. 25 is a diagram illustrating switching of conversion efficiency.
Fig. 26 is a diagram illustrating switching of conversion efficiency.
Fig. 27 is a diagram illustrating switching of conversion efficiency.
Fig. 28 is a diagram illustrating a circuit configuration example of a pixel.
Fig. 29 is a diagram illustrating a circuit configuration example of the pixel.
Fig. 30 is a diagram illustrating switching of conversion efficiency.
Fig. 31 is a diagram illustrating switching of conversion efficiency.
Fig. 32 is a diagram illustrating switching of conversion efficiency.
Fig. 33 is a diagram illustrating a circuit configuration example of the pixel.
Fig. 34 is a diagram illustrating a circuit configuration example of the pixel.
Fig. 35 is a diagram illustrating a circuit configuration example of the pixel.
Fig. 36 is a diagram illustrating a circuit configuration example of the pixel.
Fig. 37 is a diagram illustrating a circuit configuration example of the pixel.
Fig. 38 is a diagram illustrating the arrangement of a link, an I pixel, and a Q pixel.
Fig. 39 is a diagram illustrating the arrangement of a link, an I pixel, and a Q pixel.
Fig. 40 is a diagram illustrating the arrangement of a link, an I pixel, and a Q pixel.
Fig. 41 is a diagram illustrating the arrangement of a link, an I pixel, and a Q pixel.
Fig. 42 is a diagram illustrating the arrangement of a link, an I pixel, and a Q pixel.
Fig. 43 is a diagram illustrating the arrangement of a link, an I pixel, and a Q pixel.
Fig. 44 is a diagram illustrating a planar configuration example of the pixel.
Fig. 45 is a diagram illustrating a conventional distance measuring method.
Fig. 46 is a diagram illustrating a distance measuring method.
Fig. 47 is a flowchart illustrating processing relating to generation of a distance measurement image.
Fig. 48 is a diagram illustrating addition processing.
Fig. 49 is a diagram illustrating addition processing.
Fig. 50 is a diagram illustrating demosaic processing.
Fig. 51 is a diagram illustrating another arrangement example of IQ mosaic.
Fig. 52 is a block diagram illustrating a configuration example of a distance measuring module.
Fig. 53 is a block diagram illustrating a configuration example of a smartphone as an electronic device.
Fig. 54 is a block diagram illustrating an example of a schematic configuration of a vehicle control system.
Fig. 55 is an explanatory diagram illustrating an example of installation positions of an outside-vehicle information detection unit and an imaging section.

### MODE FOR CARRYING OUT THE INVENTION

Hereinafter, modes for carrying out the present technology (hereinafter referred to as embodiments) will be described.

### <Configuration of imaging element>

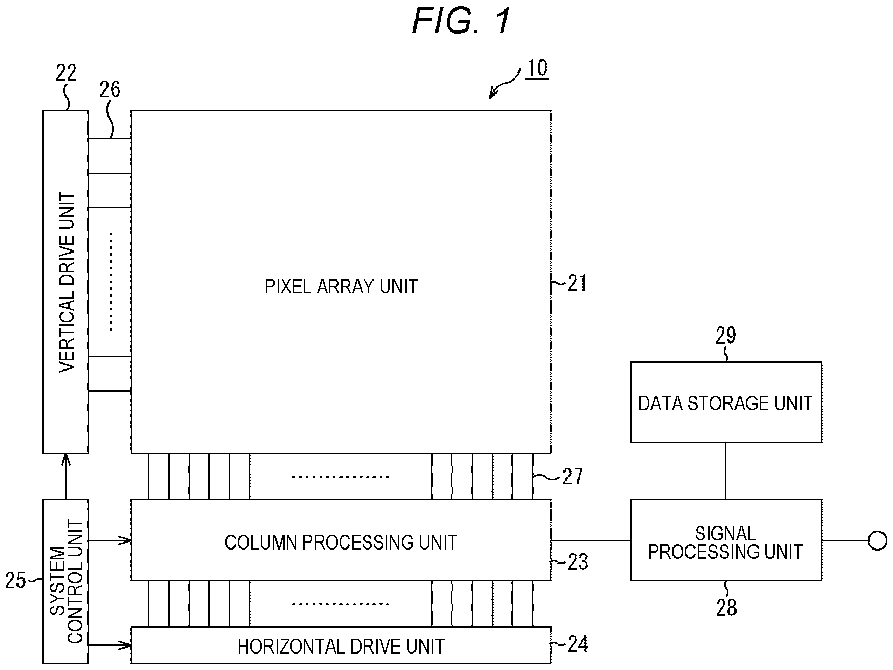

Fig. 1 is a block diagram illustrating a configuration example of a complementary metal oxide semiconductor (CMOS) image sensor as an imaging element to which the present invention is applied.

An imaging element 10 includes a pixel array unit 21, a vertical drive unit 22, a column processing unit 23, a horizontal drive unit 24, and a system control unit 25. The pixel array unit 21, the vertical drive unit 22, the column processing unit 23, the horizontal drive unit 24, and the system control unit 25 are formed on a semiconductor substrate (chip) (not illustrated).

In the pixel array unit 21, unit pixels (hereinafter, referred to as pixel 40) having photoelectric conversion elements that generate and store therein photoelectric charges of a charge amount according to the amount of incident light are two-dimensionally arranged in a matrix. Note that there is a case where the photocharge in the charge amount corresponding to the amount of incident light is simply referred to as "charge" hereinafter, and the unit pixel is simply referred to as "pixel".

In the pixel array unit 21, a pixel drive line 26 is further formed for each row along the left-right direction (the array direction of the pixels in a pixel row) in the drawing with respect to the pixel array in the matrix form, and a vertical signal line 27 is formed for each column along the up-down direction (the array direction of the pixels in the pixel column) in the drawing. One end of the pixel drive line 26 is connected to an output end corresponding to each row of the vertical drive unit 22.

The imaging element 10 further includes a signal processing unit 28 and a data storage unit 29. The signal processing unit 28 and the data storage unit 29 may be an external signal processing unit provided on a substrate different from that of the imaging element 10, for example, a digital signal processor (DSP) or processing by software, or may be mounted on the same substrate as the imaging element 10.

The vertical drive unit 22 is a pixel drive unit that includes a shift register, an address decoder, and so on, and drives each pixel of the pixel array unit 21 at the same time for all pixels, in units of rows, or the like. Although a specific configuration of the vertical drive unit 22 is not illustrated, the vertical drive unit 22 is configured to have a read scanning system, a sweep scanning system, or batch sweeping and batch transfer.

The read scanning system sequentially selects and scans the unit pixels of the pixel array unit 21 row by row in order to read a signal from the unit pixel. In a case of row driving (a rolling shutter operation), in the sweep operation, a sweep scanning operation is performed on a read row which is subjected to a read scanning operation by the read scanning system, prior to the read scanning operation by a time corresponding to a shutter speed. Furthermore, in a case of global exposure (a global shutter operation), a batch sweep operation is performed prior to a batch transfer operation by the time corresponding to a shutter speed.

Due to the sweeping operation, unnecessary charges are swept (reset) from the photoelectric conversion elements of the unit pixels in the read row. Then, a so-called electronic shutter operation is performed by sweeping (resetting) the unnecessary charge. Here, the electronic shutter operation is intended to mean an operation of discharging the optical charges of the photoelectric conversion elements and newly starting exposure (starting accumulating optical charges).

The signal which is read by the read operation of the read scanning system corresponds to an amount of light which is received immediately before the read operation or received after the electronic shutter operation. In a case of row driving, a period from the reading time by the preceding read operation or the sweeping time by the electronic shutter operation to the reading time by the current read operation is set to an accumulation period (an exposure period) of photoelectric charges in the unit pixel. In a case of the global exposure, a period from a batch sweep to a batch transfer is set to the accumulation period (the exposure period).

The pixel signal output from each unit pixel of the pixel row selectively scanned by the vertical drive unit 22 is supplied to the column processing unit 23 through each of the vertical signal lines 27. The column processing unit 23 performs predetermined signal processing on the pixel signal output from each unit pixel of the selected row through the vertical signal line 27 for each pixel column of the pixel array unit 21, and temporarily holds the pixel signal after the signal processing.

Specifically, as the signal processing, the column processing unit 23 performs at least noise removal processing, for example, Correlated Double Sampling (CDS) processing. By the correlated double sampling by the column processing unit 23, fixed pattern noise unique to the pixel such as reset noise and threshold variation of an amplification transistor is removed. Note that the column processing unit 23 can have, for example, an analog-digital (AD) conversion function in addition to the noise removal processing, and can output a signal level as a digital signal.

The horizontal drive unit 24 includes a shift register, an address decoder, and the like, and sequentially selects unit circuits in the column processing unit 23 corresponding to the pixel columns. The selective scanning is performed by the horizontal drive unit 24, so that the pixel signals subjected to the signal processing by the column processing unit 23 are sequentially output to the signal processing unit 28.

The system control unit 25 includes a timing generator that generates various timing signals, and performs drive control for the vertical drive unit 22, the column processing unit 23, the horizontal drive unit 24, and the like based on the various timing signals generated by the timing generator.

The signal processing unit 28 has at least an addition processing function, and performs various signal processing such as addition processing on the pixel signal output from the column processing unit 23. The data storage unit 29 temporarily stores data necessary for signal processing in the signal processing unit 28.

### < Arrangement of power supply circuit >

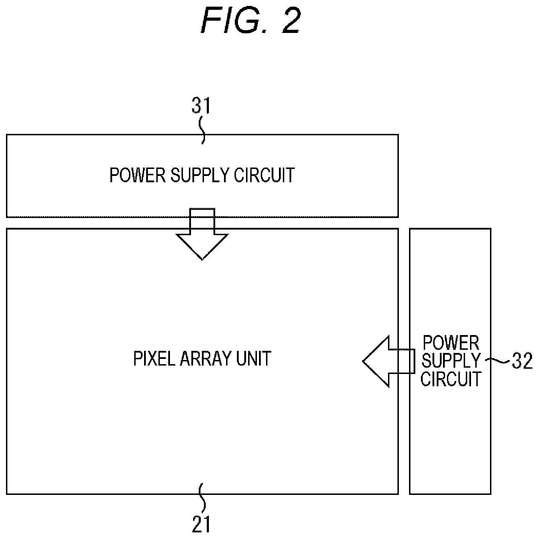

Fig. 2 is a diagram illustrating an arrangement of a power supply circuit of the imaging element 10. In the imaging element 10, power supply circuits are arranged on two sides of the pixel array unit 21. In the example illustrated in Fig. 2, a power supply circuit 31 is provided on an upper side of the pixel array unit 21, and a power supply circuit 32 is provided on a right side. The power supply circuit 31 and the power supply circuit 32 are different in transistors that supply power.

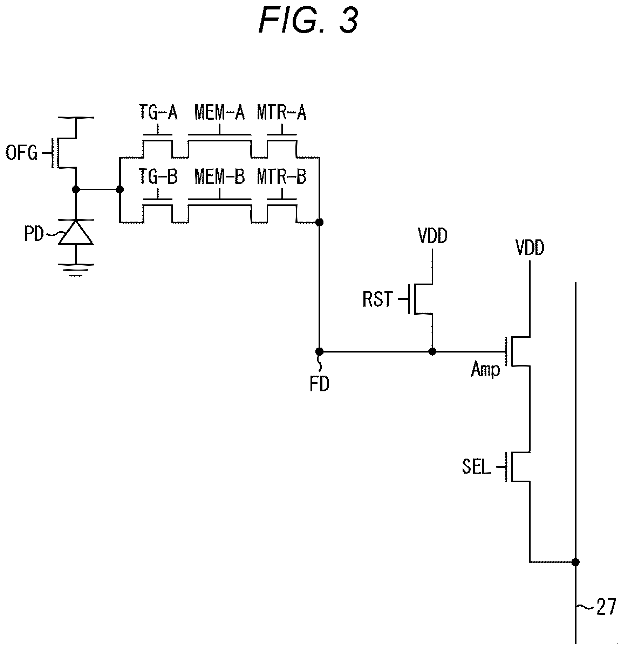

As described with reference to Fig. 3, a pixel 40 includes a plurality of transistors. For example, the pixel 40 includes a transfer transistor, a reset transistor, an amplification transistor, a selection transistor, an Overflow (OF) transistor, and the like.

For example, the power supply circuit 31 is connected to a transfer gate of the transfer transistor and an OF gate of the OF transistor, and supplies power to the transfer gate and the OF gate, respectively. For example, the power supply circuit 31 is connected to a reset gate of the reset transistor, an amplification gate of the amplification transistor, and a selection gate of the selection transistor, and supplies power to the reset gate, the amplification gate, and the selection gate, respectively.

The power supply circuit 31 and the power supply circuit 32 are provided so that power can be supplied from the same power supply circuit to transistors having similar required characteristics. In this case, time constants (= rise time/fall time) of the transfer gate and the OF gate are made uniform so that an error component at the start of exposure can be reduced.

There is a need that the transfer gate can be driven at a high speed, and the transfer gate is configured to operate with a strong power supply and thick wiring. The OF gate can also be moved by the same power source as the transfer gate, here the power supply circuit 31, to improve the characteristics.

The drive wiring is configured to be supplied with power from the same power supply circuit so that the drive capability of the driver can be made uniform.

### <First circuit configuration example of pixel>

Next, a specific structure of the pixels 40 arranged in a matrix in the pixel array unit 21 will be described. The present technology can be applied to a distance measuring sensor that outputs distance measurement information by an indirect ToF method. The circuit configuration example of the pixel 40 illustrated in Fig. 3 is a configuration example in the indirect TOF method, and is a diagram illustrating a configuration example of a pixel having a two-tap structure called a 2-tap method or the like.

The pixel 40 includes a photodiode PD that is a photoelectric conversion element, and is configured such that charges generated in the photodiode PD are distributed to a tap A and a tap B. The tap A includes a first transfer transistor TG-A, a memory MEM-A, and a second transfer transistor MTR-A. The tap B includes a first transfer transistor TG-B, a memory MEM-B, and a second transfer transistor MTR-B.

A floating diffusion FD, a reset transistor RST, an amplification transistor AMP, and a selection transistor SEL are shared by the tap A and the tap B. An overflow transistor OFG shared by the tap A and the tap B is also connected to the photodiode PD.

A first transistor TG is a transfer transistor that transfers the charge generated in a photodiode PD to a memory MEM. A second transistor MTR is a transfer transistor that transfers the charge accumulated in the memory MEM to the floating diffusion FD.

Here, the description will be continued with an example including the memory MEM and the second transistor MTR, but a configuration not including the memory MEM and the second transistor MTR is also possible. That is, the charge generated in the photodiode PD may be transferred to the floating diffusion FD by the first transistor TG.

### <First planar configuration example of pixel>

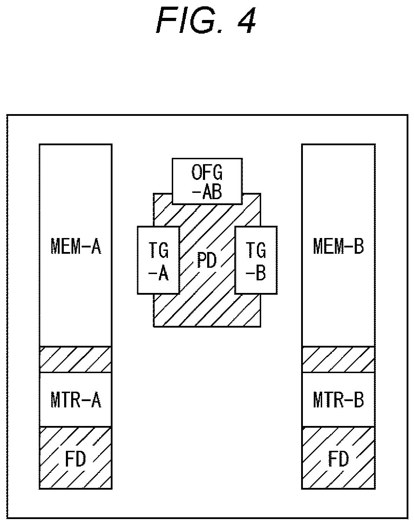

Fig. 4 is a planar configuration example of the pixel 40 having the circuit configuration illustrated in Fig. 3. The photodiode PD is provided near the center of the pixel 40, (the gate of) the first transfer transistor TG-A is provided on a left side in the drawing, and (the gate of) the first transfer transistor TG-B is provided on a right side in the drawing. An overflow transistor OFG-AB is provided on an upper side of the photodiode PD in the drawing. Here, since the tap A and the tap B share the overflow transistor OFG, they are referred to as overflow transistors OFG-AB.

The memory MEM-A and (the gate of) the second transfer transistor MTR-A are formed on the left side of the pixel 40 in the drawing, and the floating diffusion FD is connected to the second transfer transistor MTR-A. Similarly, the memory MEM-B and (the gate of) the second transfer transistor MTR-B are formed on the right side of the pixel 40 in the drawing, and the floating diffusion FD is connected to the second transfer transistor MTR-B.

Although not illustrated in Fig. 4, the reset transistor RST, the amplification transistor AMP, the selection transistor SEL, and the like are also formed around the photodiode PD. The transistors are arranged so as to be line-symmetric about the photodiode PD.

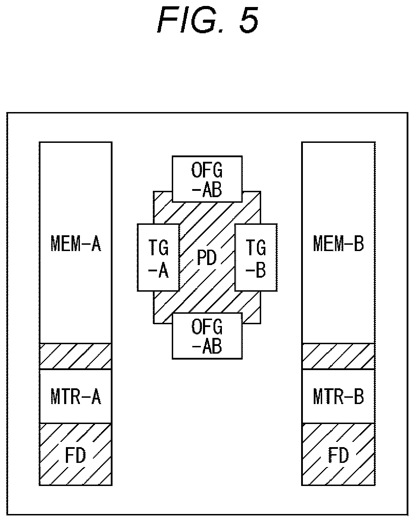

As illustrated in Fig. 5, two gates of the overflow transistor OFG may be provided. In the example illustrated in Fig. 5, the gates OFG-AB of the overflow transistors are provided above and below the photodiode PD, respectively.

### <First cross-sectional configuration example of pixel>

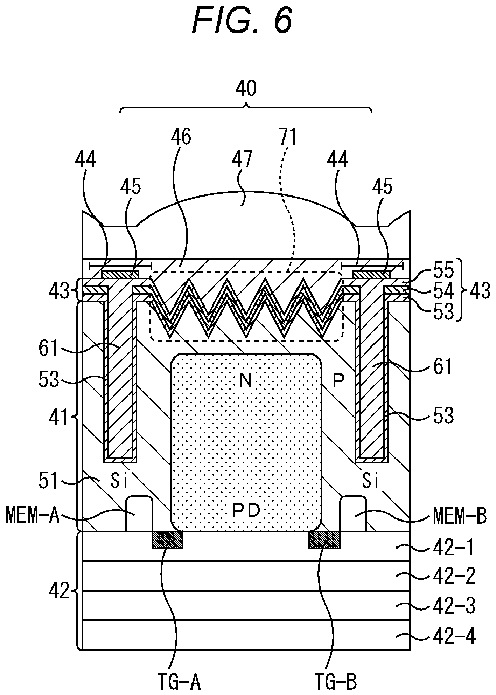

Fig. 6 is a diagram illustrating a first cross-sectional configuration example of the pixel 40 arranged in the pixel array unit 21.

The pixel 40 includes a semiconductor substrate 41 and a multilayer wiring layer 42 formed on a front surface side thereof (lower side in the drawing).

The semiconductor substrate 41 includes, for example, silicon (hereinafter, referred to as Si), and is formed to have a thickness of, for example, 1 to 10 µm. In the semiconductor substrate 41, for example, an N-type (second conductivity type) semiconductor region 52 is formed in a P-type (first conductivity type) semiconductor region 51 in units of pixels, so that photodiodes PD are formed in units of pixels.

An upper surface of the semiconductor substrate 41 on an upper side in Fig. 6 is a back surface of the semiconductor substrate 41 and is a light incident surface on which light is incident. An antireflection film 43 is formed on the upper surface on the back surface side of the semiconductor substrate 41.

The antireflection film 43 has a laminated structure obtained by lamination of a fixed charge film and an oxidized film, for example, for example, and a high dielectric constant (high-k) insulating thin film by an atomic layer deposition (ALD) method may be used, for example. Specifically, hafnium oxide (HfO2), aluminum oxide (Al2O3), titanium oxide (TiO2), strontium titan oxide (STO), or the like can be used. In the example of Fig. 6, the antireflection film 43 is formed by laminating a hafnium oxide film 53, an aluminum oxide film 54, and a silicon oxide film 55.

An inter-pixel light shielding film 45 that prevents incident light from entering an adjacent pixel is formed on an upper surface of the antireflection film 43 and at a boundary 44 (hereinafter, also referred to as a pixel boundary 44) between adjacent pixels 40 of the semiconductor substrate 41. A material of the inter-pixel light shielding film 45 only needs to be a material that shields light, and for example, a metal material such as tungsten (W), aluminum (Al), or copper (Cu) can be used.

On the upper surface of the antireflection film 43 and an upper surface of the inter-pixel light shielding film 45, a planarization film 46 is formed by, for example, an insulating film such as silicon oxide (SiO2), silicon nitride (SiN), or silicon oxynitride (SiON), or an organic material such as resin.

Then, on an upper surface of the planarization film 46, an on-chip lens 47 is formed for each pixel. The on-chip lens 47 includes, for example, a resin material such as a styrene resin, an acrylic resin, a styrene-acrylic copolymer resin, or a siloxane resin. The light condensed by the on-chip lens 47 is efficiently incident on the photodiode PD.

An uneven structure portion 71 in which fine unevenness is periodically formed is formed on the back surface of the semiconductor substrate 41 and above a formation region of the photodiode PD. The antireflection film 43 formed on the upper surface of the uneven structure portion 71 of the semiconductor substrate 41 is also formed with an uneven structure corresponding to the uneven structure portion 71. The uneven structure portion 71 of the semiconductor substrate 41 has, for example, a configuration in which a plurality of quadrangular pyramid regions having substantially the same shape and substantially the same size is regularly provided (in a lattice shape).

The uneven structure portion 71 is formed in, for example, an inverse pyramid structure in which a plurality of quadrangular pyramidal regions having apexes on the photodiode PD side is arranged so as to be regularly arranged.

Alternatively, the uneven structure portion 71 may have a forward pyramid structure in which a plurality of quadrangular pyramidal regions having apexes on the on-chip lens 47 side is arranged so as to be regularly arranged. The size and arrangement of the plurality of quadrangular pyramids may be randomly formed without being regularly arranged. In addition, each recess or each protrusion of each quadrangular pyramid of the uneven structure portion 71 may have a curvature to some extent and may have a rounded shape. The uneven structure portion 71 only needs to have a structure in which the uneven structure is periodically or randomly repeated, and the shape of the recess or the protrusion is arbitrary.

As described above, the uneven structure portion 71 is formed as a diffraction structure for diffracting the incident light on the light incident surface of the semiconductor substrate 41, making it possible to alleviate a rapid change in refractive index at the substrate interface and reduce the influence of the reflected light.

At the pixel boundary 44 on the back surface side of the semiconductor substrate 41, an inter-pixel isolation portion 61 that isolates adjacent pixels in the depth direction of the semiconductor substrate 41 from each other from the back surface side (the side of the on-chip lens 47) of the semiconductor substrate 41 to a predetermined depth in the substrate depth direction is formed. Note that the depth in the substrate thickness direction at which the inter-pixel isolation portion 61 is formed can be any depth, and may penetrate from the back surface side to the front surface side of the semiconductor substrate 41 and be completely isolated into pixel units. An outer peripheral portion including a bottom surface and a side wall of the inter-pixel isolation portion 61 is covered with the hafnium oxide film 53 which is a part of the antireflection film 43. The inter-pixel isolation portion 61 prevents incident light from penetrating into the adjacent pixel 40, confines the incident light in the pixel, and prevents leakage of incident light from the adjacent pixel 40.

In the example of Fig. 6, since the silicon oxide film 55, which is the material of the uppermost layer of the antireflection film 43, is embedded in a trench (groove) dug from the back surface side to simultaneously form the silicon oxide film 55 and the inter-pixel isolation portion 61, the silicon oxide film 55, which is a part of the laminated film as the antireflection film 43, and the inter-pixel isolation portion 61 include the same material, but are not necessarily the same. The material to be embedded in the trench (groove) dug from the back surface side as the inter-pixel isolation portion 61 may be, for example, a metal material of tungsten (W), aluminum (Al), titanium (Ti), titanium nitride (TiN) and the like.

On the other hand, on the front surface side of the semiconductor substrate 41 on which the multilayer wiring layer 42 is formed, two transfer transistors TG-A and TG-B are formed for one photodiode PD formed in each pixel 40. Furthermore, on the front surface side of the semiconductor substrate 41, the memories MEM-A and MEM-B as charge holding units that temporarily hold the charge transferred from the photodiode PD are formed by, for example, a high-concentration N-type semiconductor region (N-type diffusion region).

The multilayer wiring layer 42 includes a plurality of metal films M and an interlayer insulating film therebetween. Fig. 6 illustrates an example including four wiring layers 42-1 to 42-4, but the number of wiring layers 42 is not limited to four. Here, the layer in which the gate of the transistor is formed is also described as the wiring layer 42.

As described above, the imaging element 10 has a back surface irradiation type structure in which the semiconductor substrate 41 as a semiconductor layer is arranged between the on-chip lens 47 and the multilayer wiring layer 42, and incident light is made incident on the photodiode PD from the back surface side on which the on-chip lens 47 is formed.

The pixel 40 includes the two transfer transistors TG-A and TG-B for the photodiode PD provided in each pixel, and is configured to be able to distribute charges (electrons) generated by photoelectric conversion by the photodiode PD to the memory MEM-A or MEM-B.

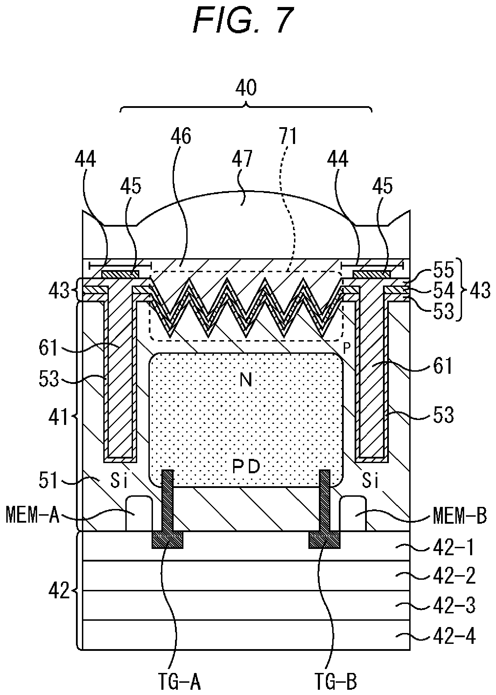

The transfer transistor TG may have a configuration in which a gate is also provided in the vertical direction as illustrated in Fig. 7. Referring to Fig. 7, the photodiode PD is configured as an embedded photodiode PD, and a part of the transfer transistor TG is provided until reaching a part of the photodiode PD.

The transfer transistor TG-A includes a gate (gate provided in the horizontal direction) provided in the wiring layer 42-1 and a gate (gate provided in the vertical direction) provided up to the inside of the N-type semiconductor region 52 of the photodiode PD in the semiconductor substrate 41. The transfer transistor TG-B also includes gates provided in the horizontal direction and the vertical direction.

A vertical transistor having a gate also in the vertical direction can be used. Here, the case where the first transfer transistor TG is a vertical transistor has been described as an example, but the present technology can also be applied to a case where a transistor other than the first transfer transistor TG is a vertical transistor.

### <Second circuit configuration example of pixel>

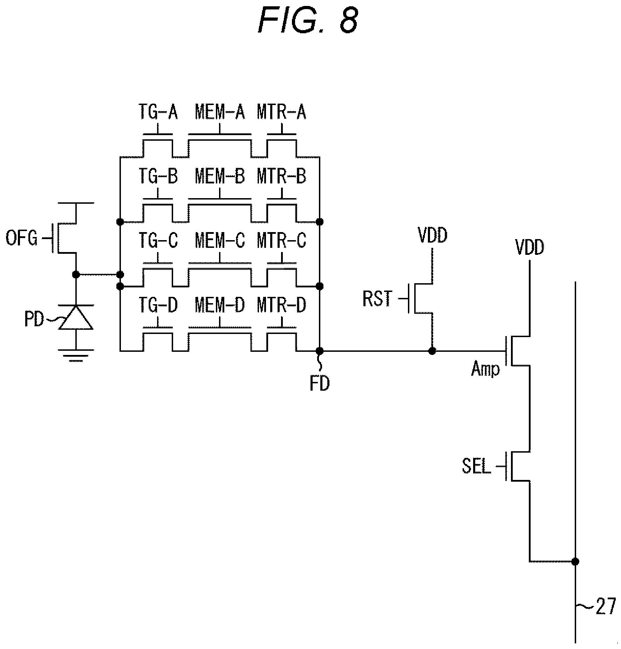

The present technology is also applicable to other than the 2-tap pixel 40 in the indirect TOF method. Fig. 8 is a diagram illustrating a circuit configuration of a 4-tap pixel 40.

The pixel 40 includes a photodiode PD that is a photoelectric conversion element, and is configured such that charges generated in the photodiode PD are distributed to a tap A, a tap B, a tap C, and a tap D.

The tap A includes a first transfer transistor TG-A, a memory MEM-A, and a second transfer transistor MTR-A. The tap B includes a first transfer transistor TG-B, a memory MEM-B, and a second transfer transistor MTR-B.

The tap C includes a first transfer transistor TG-C, a memory MEM-C, and a second transfer transistor MTR-C. The tap C includes a first transfer transistor TG-D, a memory MEM-D, and a second transfer transistor MTR-D.

The floating diffusion FD, the reset transistor RST, the amplification transistor AMP, and the selection transistor SEL are shared by the tap A, the tap B, the tap C, and the tap D. The overflow transistor OFG shared by the tap A, the tap B, the tap C, and the tap D is also connected to the photodiode PD.

The present technology can also be applied to the pixel 40 having such a 4-tap configuration.

### <Third circuit configuration example of pixel>

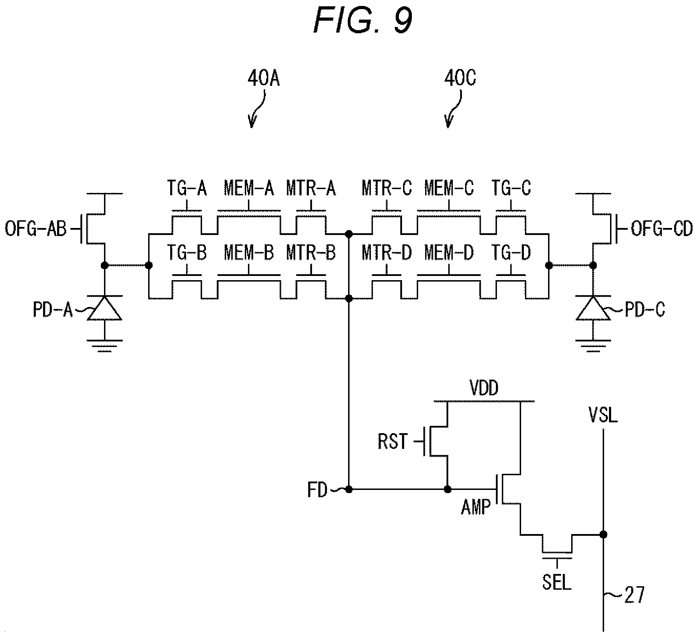

The present technology can be applied not only to the 2-tap or 4-tap pixel 40 in the indirect TOF method, but also to the pixel 40 in which the floating diffusion FD is shared by a plurality of pixels. Fig. 9 is a circuit diagram of the pixel 40 in a case where one pixel 40 has a 2-tap configuration and the floating diffusion FD is shared by such two pixels 40.

A pixel 40A and a pixel 40C are pixels adjacent to each other in the lateral direction. The pixel 40A includes a photodiode PD-A as a photoelectric conversion element, and is configured such that charges generated in the photodiode PD-A are distributed to the tap A and the tap B. The tap A includes a first transfer transistor TG-A, a memory MEM-A, and a second transfer transistor MTR-A. The tap B includes a first transfer transistor TG-B, a memory MEM-B, and a second transfer transistor MTR-B.

The pixel 40C includes a photodiode PD-C as a photoelectric conversion element, and is configured such that charges generated in the photodiode PD-C are distributed to the tap C and the tap D. The tap C includes a first transfer transistor TG-C, a memory MEM-C, and a second transfer transistor MTR-C. The tap D includes a first transfer transistor TG-D, a memory MEM-D, and a second transfer transistor MTR-D.

The pixel 40A and the pixel 40C are connected to one floating diffusion FD. That is, the floating diffusion FD is shared by the pixel 40A and the pixel 40C. Furthermore, the reset transistor RST, the amplification transistor AMP, and the selection transistor SEL are also shared by the pixel 40A and the pixel 40C.

The present technology can also be applied to a configuration in which the pixel 40 having such a two-tap configuration shares the floating diffusion FD, the reset transistor RST, the amplification transistor AMP, and the selection transistor SEL in the two pixels 40.

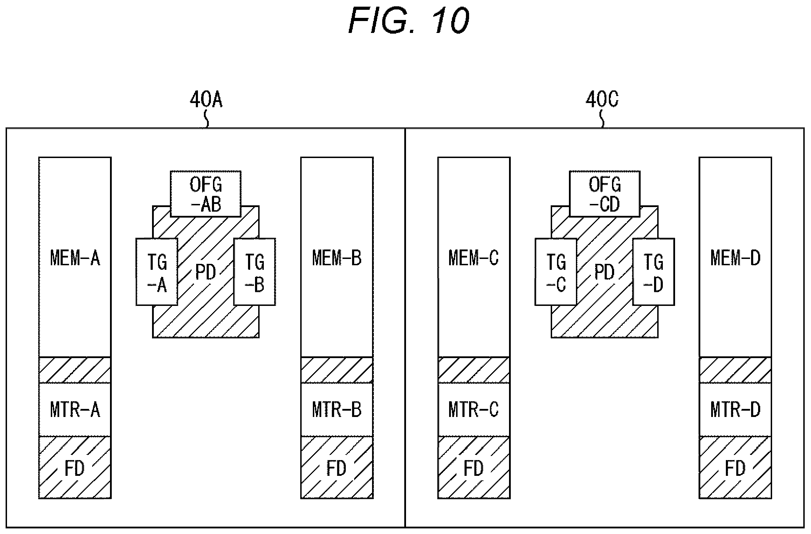

Fig. 10 illustrates a planar configuration example of the pixel 40A and the pixel 40B having the circuit configuration illustrated in Fig. 9. The photodiode PD-A is provided near the center of the pixel 40A, (the gate of) the first transfer transistor TG-A is provided on the left side, and (the gate of) the first transfer transistor TG-B is provided on the right side in the drawing. An overflow transistor OFG-AB is provided on an upper side of the photodiode PD in the drawing.

The memory MEM-A and (the gate of) the second transfer transistor MTR-A are formed on the left side of the pixel 40A in the drawing, and the floating diffusion FD is connected to the second transfer transistor MTR-A. Similarly, the memory MEM-B and (the gate of) the second transfer transistor MTR-B are formed on the right side of the pixel 40 in the drawing, and the floating diffusion FD is connected to the second transfer transistor MTR-B.

The pixel 40C is arranged on the right side of the pixel 40A in the drawing. The photodiode PD-C is provided near the center of the pixel 40C, (the gate of) the first transfer transistor TG-C is provided on the left side, and (the gate of) the first transfer transistor TG-D is provided on the right side in the drawing. An overflow transistor OFG-CD is provided on the upper side of the photodiode PD in the drawing.

The memory MEM-C and (the gate of) the second transfer transistor MTR-C are formed on the left side of the pixel 40C in the drawing, and the floating diffusion FD is connected to the second transfer transistor MTR-C. Similarly, the memory MEM-D and (the gate of) the second transfer transistor MTR-D are formed on the right side of the pixel 40 in the drawing, and the floating diffusion FD is connected to the second transfer transistor MTR-D.

The floating diffusion FD arranged in the pixel 40A and the floating diffusion FD arranged in the pixel 40B are connected in a wiring layer (not illustrated), and are configured to function as one floating diffusion FD.

Although not illustrated in Fig. 10, the reset transistor RST, the amplification transistor AMP, the selection transistor SEL, and the like are also formed around the photodiode PD. The transistors are arranged so as to be line-symmetric about the photodiode PD.

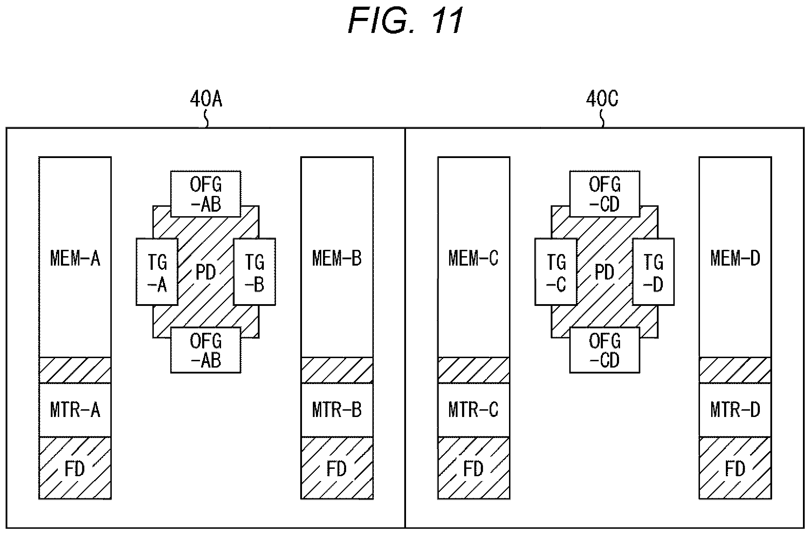

As illustrated in Fig. 11, the gate of the overflow transistor OFG may be provided at two locations. In the example illustrated in Fig. 10, the gates OFG-AB of the overflow transistors are provided above and below the photodiode PD-A, respectively, and the gates OFG-CD of the overflow transistors are provided above and below the photodiode PD-C, respectively.

### < Arrangement of wiring >

The arrangement of the wirings in the wiring layer 42 in plan view described below can be applied to any pixel 40 sharing two taps, four taps, and floating diffusion FD described above. In the following description, the arrangement of the wirings in the two adjacent pixels 40 described with reference to Figs. 9 to 11 will be described as an example.

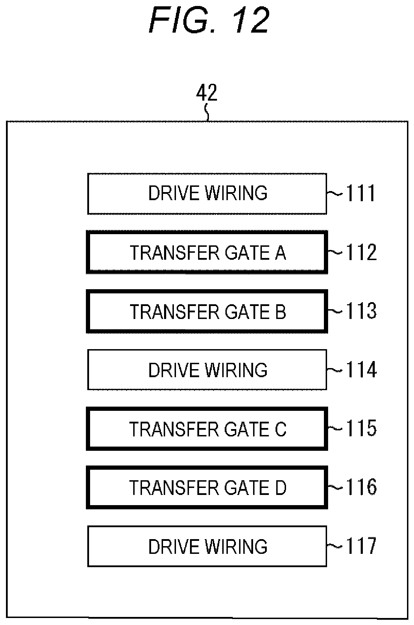

Fig. 12 is a diagram illustrating an arrangement example of the wiring in the wiring layer 42 in which the wiring of the power supply is not arranged. In the wiring illustrated in Fig. 12, a drive wiring 111, a wiring 112 of the transfer gate A, a wiring 113 of the transfer gate B, a drive wiring 114, a wiring 115 of the transfer gate C, a wiring 116 of the transfer gate D, and a drive wiring 117 are arranged in this order from the upper side in the drawing.

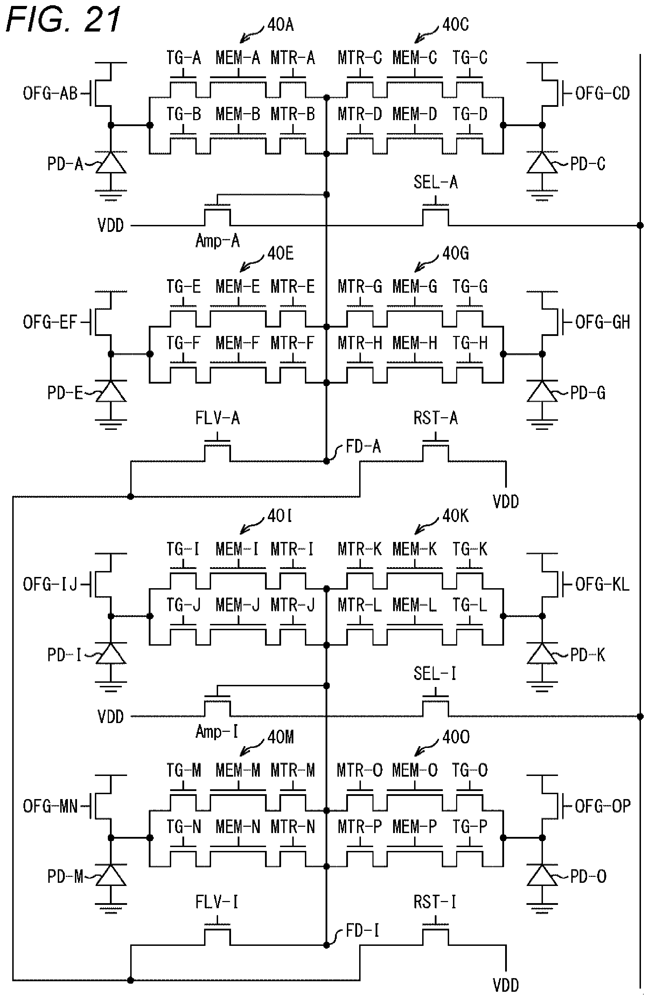

The drive wirings 111,114, and 117 are wirings for supplying a signal for driving the transistor included in the pixel 40 to the transistor. The drive wiring 111,114, and 117 are connected to a power supply circuit that supplies a voltage applied to the gate of the transistor. For example, the drive wiring 111,114, and 117 are wirings connected to gates of the second transfer transistor MTR, the overflow transistor OFG, the reset transistor RST, the amplification transistor AMP, the selection transistor SEL, and the like. In addition, a wiring of a link transistor FLV described later with reference to Fig. 21 is also included in the drive wiring.

The drive wiring also includes a wiring connected to the gate of the transfer transistor TG. Here, what kind of wiring is arranged adjacent to the wiring of the transfer gate TG will be described.

The drive wiring 111 and the wiring 113 of the transfer gate B are arranged adjacent to the wiring 112 of the transfer gate A. Since the wiring 113 of the transfer gate B is the drive wiring, the drive wiring is arranged above and below the wiring 112 of the transfer gate A. In the wiring 113 of the transfer gate B, the wiring 112 of the drive distribution transfer gate A and the drive wiring 114 are arranged adjacent to each other. Since the wiring 112 of the transfer gate A is the drive wiring, the drive wiring is arranged above and below the wiring 113 of the transfer gate B.

The drive wiring 114 and the wiring 116 of the transfer gate D are arranged adjacent to the wiring 115 of the transfer gate C. Since the wiring 116 of the transfer gate D is the drive wiring, the drive wiring is arranged above and below the wiring 115 of the transfer gate C. In the wiring 116 of the transfer gate D, the wiring 115 of the drive distribution transfer gate C and the drive wiring 117 are arranged adjacent to each other. Since the wiring 115 of the transfer gate C is the drive wiring, the drive wiring is arranged above and below the wiring 116 of the transfer gate D.

The drive wirings are arranged above and below the wiring 112 of the transfer gate A, the wiring 113 of the transfer gate B, the wiring 115 of the transfer gate C, and the wiring 116 of the transfer gate D.

Two drive wirings are arranged in the wiring 112 of the transfer gate A, two drive signals are arranged in the wiring 113 of the transfer gate B, two drive wirings are arranged in the wiring 115 of the transfer gate C, and two drive signals are arranged in the wiring 116 of the transfer gate D. That is, the number of drive wirings adjacent to the wirings of the transfer gates is the same in all the wirings of the transfer gates.

For example, in the wiring 112 of the transfer gate A, a parasitic capacitance (referred to as a parasitic capacitance 1) is generated between the wiring 112 and the drive wiring 111, and a parasitic capacitance (referred to as a parasitic capacitance 2) is generated between the wiring 112 and the wiring 113 of the transfer gate B. Similarly, in the wiring 113 of the transfer gate B, a parasitic capacitance (referred to as a parasitic capacitance 3) is generated between the wiring 113 and the wiring 112 of the transfer gate A, and a parasitic capacitance (referred to as a parasitic capacitance 4) is generated between the wiring 113 and the drive wiring 114.

In this case, since the parasitic capacitances 1 to 4 are parasitic capacitances in a case where the drive wirings are adjacent to each other, the parasitic capacitances 1 to 4 are substantially similar. That is, the parasitic capacitance in the wiring 112 of the transfer gate A and the parasitic capacitance in the wiring 113 of the transfer gate B can be made uniform.

If the wirings adjacent to the wirings 112 of the transfer gate A are wirings of a fixed voltage, and the wirings adjacent to the wirings 113 of the transfer gate B are arranged as drive wirings, the parasitic capacitance of the wirings 112 of the transfer gate A and the parasitic capacitance of the wirings 113 of the transfer gate B are different capacitances. In such a case where the ratios of the parasitic capacitances in the transfer gate are not uniform, the cross points of the pixels are not uniform, and the distance measurement accuracy may be reduced.

As in the present embodiment, the role of the wiring adjacent to the wiring of the transfer gate, in this case, the drive wiring is arranged, so that the parasitic capacitances in the wiring of the transfer gate can be made uniform, the cross points of the pixels can be made uniform, and the deterioration of the distance measurement accuracy can be prevented.

In a case where the pixel includes the vertical transistor described with reference to Fig. 7, and the wiring connected to the vertical transistor is adjacent to the wiring of the transfer gate, the wiring connected to the vertical transistor is arranged adjacent to the wiring of all the transfer gates.

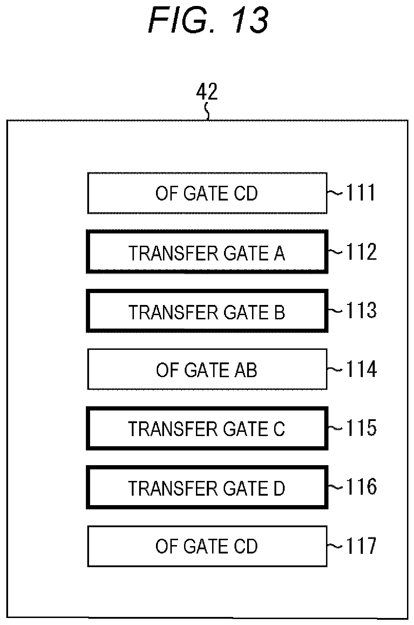

Fig. 13 illustrates a specific example of the drive wiring. The drive wiring 111 can be the wiring 111 of the gate CD (hereinafter, referred to as OF gate CD) of the overflow transistor OFG-CD. The drive wiring 114 can be the wiring 114 of the gate AB (hereinafter, referred to as OF gate AB) of the overflow transistor OFG-AB. The drive wiring 117 can be the wiring 117 of the OF gate CD of the overflow transistor OFG-CD.

In the example illustrated in Fig. 13, the wiring 112 of the transfer gate A is adjacent to the wiring 111 of the OF gate CD and the wiring 113 of the transfer gate B. The wiring 113 of the transfer gate B is adjacent to the wiring 112 of the transfer gate A and the wiring 114 of the OF gate AB. The wiring 115 of the transfer gate C is adjacent to the wiring 114 of the OF gate AB and the wiring 116 of the transfer gate D. The wiring 116 of the transfer gate D is adjacent to the wiring 115 of the transfer gate C and the wiring 117 of the OF gate CD.

Therefore, also in the arrangement example of the wiring illustrated in Fig. 13, similarly to the arrangement example of the wiring described with reference to Fig. 12, the wiring adjacent to the wiring of the transfer gate is the wiring having the same role, in this case, the drive wiring, and thus, the parasitic capacitances in the wiring of the transfer gate can be made uniform.

### <Another arrangement example of wiring>

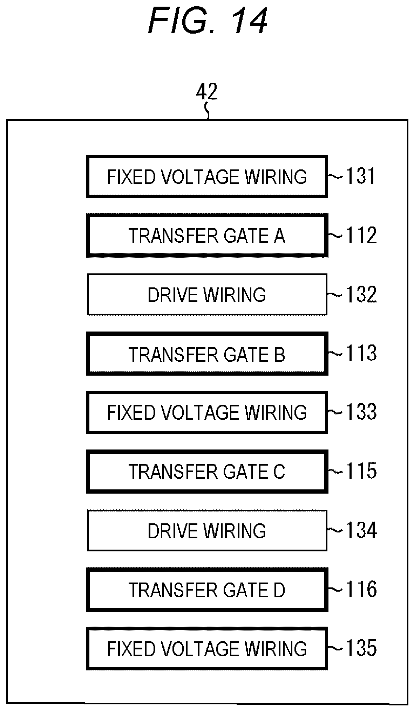

Fig. 14 is a diagram illustrating an arrangement example of the wiring in the wiring layer 42 in which the wiring of the power supply is also arranged in addition to the drive wiring. In the wiring illustrated in Fig. 14, a fixed voltage wiring 131, the wiring 112 of the transfer gate A, a drive wiring 132, the wiring 113 of the transfer gate B, a fixed voltage wiring 133, the wiring 115 of the transfer gate C, a drive wiring 134, the wiring 116 of the transfer gate D, and a fixed voltage wiring 135 are arranged in this order from the upper side in the drawing.

The fixed voltage wirings 131,133, and 135 can be a wiring through which the power supply voltage supplies a voltage of a voltage VDD or a wiring through which the power supply voltage supplies a voltage of a voltage VSS.

In the wiring 112 of the transfer gate A, the fixed voltage wiring 131 and the drive wiring 132 are arranged adjacent to each other. The drive wiring 132 and the fixed voltage wiring 133 are arranged adjacent to the wiring 112 of the transfer gate B. In the wiring 115 of the transfer gate C, the fixed voltage wiring 133 and the drive wiring 134 are arranged adjacent to each other. The drive wiring 134 and the fixed voltage wiring 135 are arranged adjacent to the wiring 116 of the transfer gate D.

In each of the wiring 112 of the transfer gate A, the wiring 113 of the transfer gate B, the wiring 115 of the transfer gate C, and the wiring 116 of the transfer gate D, the wirings are arranged such that adjacent wirings become a fixed voltage wiring and a drive wiring. That is, the number of driving lines and the number of fixed voltage lines (in this case, two) adjacent to the line of the transfer gate are the same in all the lines of the transfer gate.

In the wiring 112 of the transfer gate A, a parasitic capacitance is generated between the wiring 112 and the fixed voltage wiring 131, and a parasitic capacitance is generated between the wiring 112 and the drive wiring 132. In the wiring 113 of the transfer gate B, a parasitic capacitance is generated between the wiring 113 and the drive wiring 132, and a parasitic capacitance is generated between the wiring 112 and the fixed voltage wiring 133.

In the wiring 115 of the transfer gate C, a parasitic capacitance is generated between the wiring 115 and the fixed voltage wiring 133, and a parasitic capacitance is generated between the wiring 115 and the drive wiring 134. In the wiring 116 of the transfer gate D, a parasitic capacitance is generated between the wiring 116 and the drive wiring 134, and a parasitic capacitance is generated between the wiring 116 and the fixed voltage wiring 135.

Since the power source and the driver or the impedance are different, the parasitic capacitance generated between the power supply and the wiring of the transfer gate is also different. In any of the wirings of the transfer gates A to D, the wirings are arranged such that a parasitic capacitance with the fixed voltage wiring and a parasitic capacitance with the drive wiring are generated. Therefore, the parasitic capacitances in the wiring of the transfer gate can be made uniform, the cross points of the pixels can be made uniform, and the distance measurement accuracy can be prevented from deteriorating.

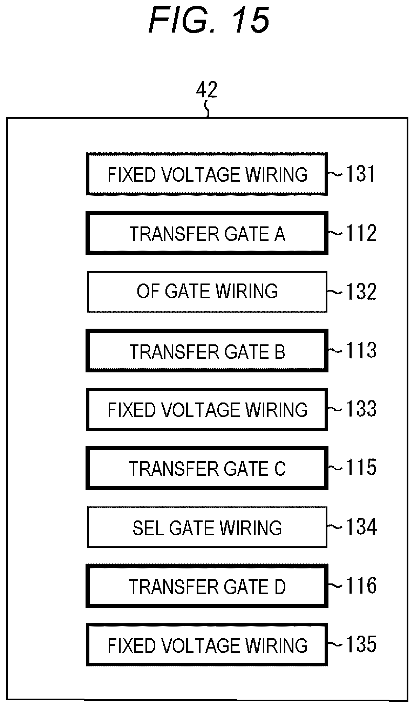

Fig. 15 illustrates a specific example of the drive wiring. The drive wiring 132 can be an OF gate wiring 132 of the overflow transistor OFG. The drive wiring 134 can be the SEL gate wiring 136 of the gate (hereinafter, referred to as a SEL gate) of the selection transistor SEL. Although not illustrated, the drive wiring 132 or the drive wiring 134 can be an RST gate wiring of the reset transistor RST, an AMP gate wiring of the amplification transistor AMP, or the like.

Also, in the arrangement example of the wiring illustrated in Fig. 15, similarly to the arrangement example of the wiring described with reference to Figs. 12 and 14, since the wiring adjacent to the wiring of the transfer gate is the wiring having the same role, in this case, the drive wiring or the fixed voltage wiring, the parasitic capacitances in the wiring of the transfer gate can be made uniform.

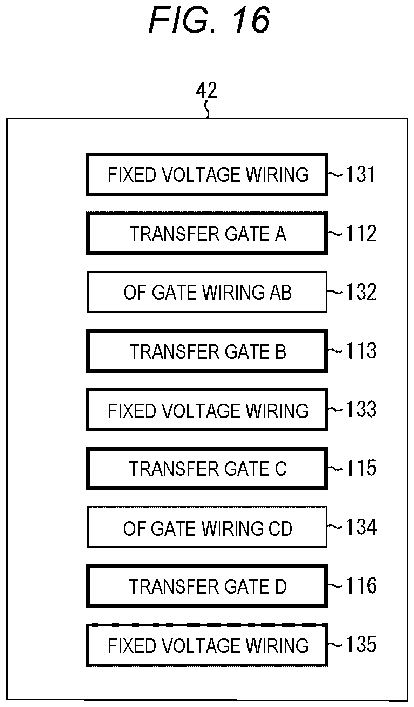

Fig. 16 further illustrates a specific example of the drive wiring. The drive wiring 132 can be the wiring 132 of the OF gate AB of the overflow transistor OFG-AB. The drive wiring 134 can be the wiring 134 of the OF gate CD of the overflow transistor OFG-CD.

Since the movement of the drive wiring varies depending on the driver, a temporal influence of the coupling becomes uniform by making the movement uniform, and the cross points can be further made uniform.

In the example illustrated in Fig. 16, the line 132 of the OF gate line AB is adjacent to the line 112 of the transfer gate A and the line 113 of the transfer gate B, and the line 134 of the OF gate line CD is adjacent to the line 115 of the transfer gate C and the line 116 of the transfer gate D. Since the drive wiring by the driver of the overflow transistor OFG is configured to be adjacent to the wirings of the transfer gates A to D, a temporal influence of the coupling is made uniform, and the cross points can be further made uniform.

In the example illustrated in Fig. 16, the wiring 132 of the OF gate wiring AB is adjacent to the wiring 112 of the transfer gate A and the wiring 113 of the transfer gate B. The transfer gate A, the transfer gate B, and the OF gate AB are gates of transistors disposed in the pixel 40A. That is, each of the wiring 112, the wiring 113, and the wiring 132 is a drive wiring, and the pixel to which these drive wirings are connected is the pixel 40A and is the same pixel.

Similarly, in the example illustrated in Fig. 16, the wiring 134 of the OF gate wiring CD is adjacent to the wiring 115 of the transfer gate C and the wiring 116 of the transfer gate D. The transfer gate C, the transfer gate D, and the OF gate CD are gates of transistors arranged in the pixel 40C. That is, each of the wiring 115, the wiring 116, and the wiring 134 is a drive wiring, and the pixel to which these drive wirings are connected is the pixel 40C and is the same pixel.

The wirings connected to the same pixel so as to be adjacent to each other in this manner, so that it is possible to reduce the influence of driving of other pixels, to make the parasitic capacitances more uniform, and to improve the distance measurement accuracy.

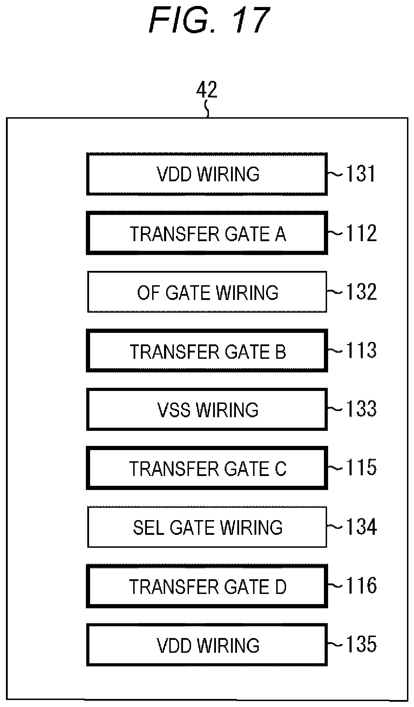

Fig. 17 illustrates a specific example of the fixed voltage wiring. Among the wirings illustrated in Fig. 17, an example is illustrated in which the OF gate wiring 132 and the SEL gate wiring 134 are arranged as the drive wiring as in the case illustrated in Fig. 15.

The fixed voltage wiring 131 can be a VDD wiring 131 that is connected to the power supply voltage VDD and supplies the voltage VDD. The fixed voltage line 133 can be a VSS line 133 that is connected to the power supply voltage VSS and supplies the voltage VSS. The fixed voltage wiring 135 can be a VDD wiring 135 that is connected to the power supply voltage VDD and supplies the voltage VDD.

Also, in the arrangement example of the wiring illustrated in Fig. 17, similarly to the arrangement example of the wiring described with reference to Figs. 12 and 14, since the wiring adjacent to the wiring of the transfer gate is the wiring having the same role, in this case, the drive wiring or the fixed voltage wiring, the parasitic capacitances in the wiring of the transfer gate can be made uniform.

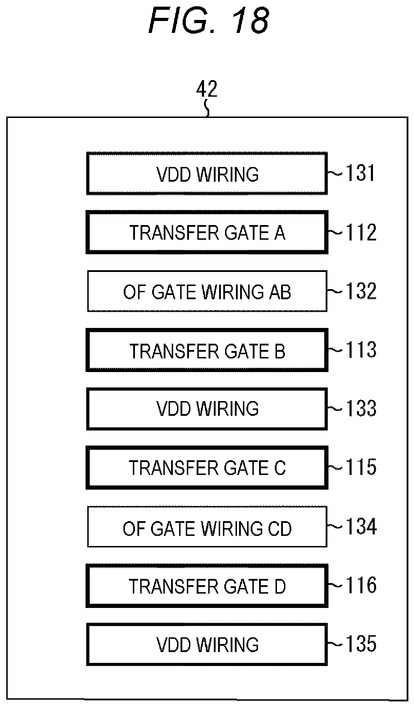

Fig. 18 further illustrates a specific example of the fixed voltage wiring. Among the wirings illustrated in Fig. 18, an example is illustrated in which the wiring 132 of the OF gate AB and the wiring 134 of the OF gate CD are arranged as in the case illustrated in Fig. 16.

The fixed voltage wiring 131 can be a VDD wiring 131 that is connected to the power supply voltage VDD and supplies the voltage VDD. The fixed voltage wiring 133 can be a VDD wiring 133 that is connected to the power supply voltage VDD and supplies the voltage VDD. The fixed voltage wiring 135 can be a VDD wiring 135 that is connected to the power supply voltage VDD and supplies the voltage VDD.

In a case where the voltage of the fixed voltage is different, the impedance is also different. Therefore, these are made uniform so that the parasitic capacitances can be made uniform, and the cross points can be further made uniform.

In the example illustrated in Fig. 18, the VDD line is adjacent to the line 112 of the transfer gate A, the line 113 of the transfer gate B, the line 115 of the transfer gate C, and the line 116 of the transfer gate D. Since the VDD wiring that supplies the voltage VDD is configured to be adjacent to the wiring of the transfer gates A to D, the impedances are uniform, and as a result, the parasitic capacitances are uniform, and the cross points can be more uniform.

In the example illustrated in Fig. 18, as described with reference to Fig. 16, since the drive wiring adjacent to the wiring of the transfer gate is also the wiring having the same role, the parasitic capacitances in the wiring of the transfer gate can be further made uniform.

### <Relationship with wiring arranged in another layer>

The arrangement example of the wirings with reference to Figs. 12 to 18 is an example, and other arrangements may be adopted as long as the parasitic capacitances generated between the adjacent wirings are made uniform. The arrangement examples of the wiring with reference to Figs. 12 to 18 are the arrangement examples of the wiring in the predetermined wiring layer, but may be applied to any wiring layer of the wiring layer in the multilayer wiring layer 42, or may be applied to a plurality of wiring layers.

In a case where the present technology is applied to a plurality of wiring layers, in Figs. 12 to 18, a case where the wiring has long sides in the lateral direction has been described as an example, but it is also possible to have a structure in which the wiring of a predetermined wiring layer in the multilayer wiring layer 42 is arranged with the wiring having long sides in the lateral direction, and the wiring of another wiring layer is the wiring having long sides in the longitudinal direction. For example, the wiring of a wiring layer 42-3 in the multilayer wiring layer 42 may have a structure in which the long side is in the lateral direction, and the wiring of a wiring layer 42-4 has the long side in the longitudinal direction.

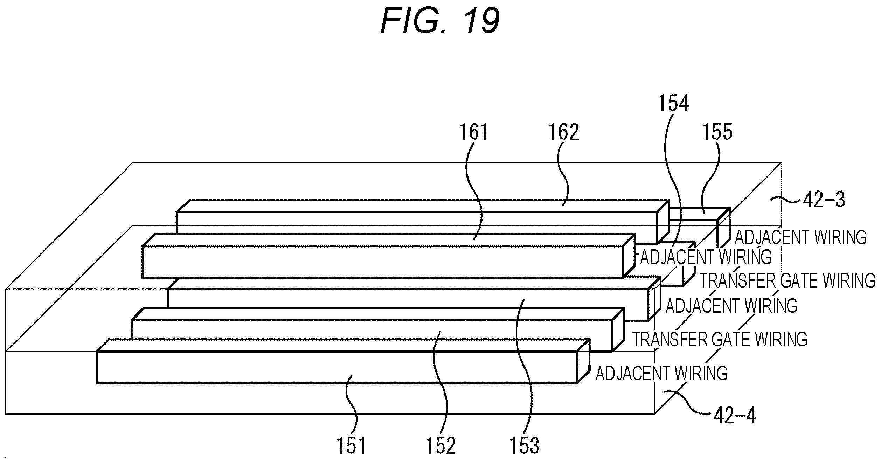

The arrangement of wirings described with reference to Figs. 12 to 18 can also be applied to wirings arranged in a plurality of wiring layers. This will be described below with reference to Fig. 19.

Fig. 19 is a diagram illustrating a case where an arrangement of wirings in which parasitic capacitances are made uniform is applied to wirings arranged in a plurality of wiring layers. In Fig. 19, wiring arranged in the wiring layer 42-3 and the wiring layer 42-4 will be described as an example.

In the wiring layer 42-4, a transfer gate wiring 152, and an adjacent wiring 151 and an adjacent wiring 153 adjacent to the transfer gate wiring 152 are arranged. A transfer gate wiring 154 is also disposed in the wiring layer 42-4, and an adjacent wiring 153 and an adjacent wiring 155 adjacent to the transfer gate wiring 154 are also disposed.

The adjacent wiring 151, the transfer gate wiring 152, the adjacent wiring 153, the transfer gate wiring 154, and the adjacent wiring 155 are arranged to satisfy any arrangement described with reference to Figs. 12 to 18.

An adjacent wiring 161 and an adjacent wiring 162 are arranged in the wiring layer 42-3 laminated on the wiring layer 42-4. The adjacent wiring 161 is arranged at a position overlapping the transfer gate wiring, a position partially overlapping the transfer gate wiring 152, or a position having no overlapping portion in plan view. The adjacent wiring 162 is arranged at a position overlapping the transfer gate wiring, a position partially overlapping the transfer gate wiring 154, or a position having no overlapping portion in plan view.

For example, in a case where the wiring 161 arranged in the wiring layer 42-3 is a drive wiring, the wiring 162 is also a drive wiring. In this case, the transfer gate wiring 152 arranged in the wiring layer 42-2 is adjacent to the wiring 161 which is a drive wiring, and the transfer gate wiring 154 arranged in the wiring layer 42-2 is adjacent to the wiring 162 which is a drive wiring. Therefore, both the transfer gate wiring 151 and the transfer gate wiring 152 have a configuration adjacent to the drive wiring, and the parasitic capacitances can be made uniform.

For example, in a case where the wiring 161 is a fixed voltage wiring, the wiring 162 is also a fixed voltage wiring. In this case, the transfer gate wiring 152 arranged in the wiring layer 42-2 is adjacent to the wiring 161 which is a fixed voltage wiring, and the transfer gate wiring 154 arranged in the wiring layer 42-2 is adjacent to the wiring 162 which is a fixed voltage wiring. Therefore, both the transfer gate wiring 151 and the transfer gate wiring 152 have a configuration adjacent to the fixed voltage wiring, and the parasitic capacitances can be made uniform.

As described above, with respect to the transfer gate wiring arranged in one wiring layer 42 of the laminated wiring layers 42, the wiring having the same role is arranged in the other wiring layer 42. In this way, the wiring can be arranged such that the parasitic capacitances are made uniform even in the vertical direction.

### <Another circuit configuration example>

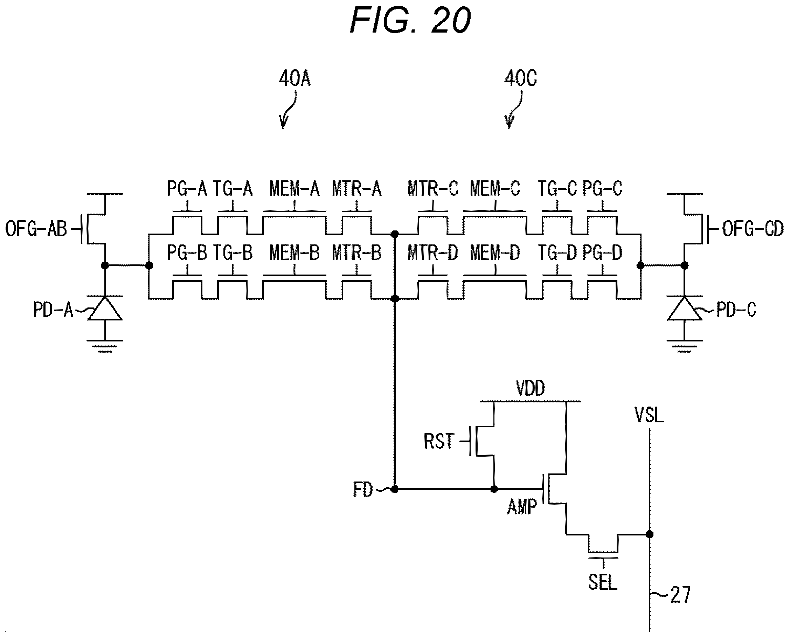

Fig. 20 is a diagram illustrating another circuit configuration example of the pixel 40. The circuit configuration of the pixel 40 shown in Fig. 20 is different in that a photogate transistor PG is added to the circuit configuration of the pixel 40 shown in Fig. 9, and the other points are similar.

The tap A included in the pixel 40A includes a photogate transistor PG-A, and the photogate transistor PG-A is provided between the photodiode PD-A and the transfer transistor TG-A. The tap B includes a photogate transistor PG-B, and the photogate transistor PG-B is provided between the photodiode PD-B and the transfer transistor TG-B.

The tap C included in the pixel 40C includes a photogate transistor PG-C, and the photogate transistor PG-C is provided between the photodiode PD-C and the transfer transistor TG-C. The tap D includes a photogate transistor PG-D, and the photogate transistor PG-D is provided between the photodiode PD-D and the transfer transistor TG-D.

In a case where the pixel 40 is provided with the photogate transistor PG, the wiring of the photogate transistor PG is also treated as the wiring of the transfer gate described above, in other words, one of the drive wirings. The parasitic capacitance generated in the wiring of the photogate transistor PG is arranged so as to be made uniform with the parasitic capacitance generated in another wiring, for example, the wiring of the transfer transistor TG.

### <Another circuit configuration example>

Fig. 21 is a diagram illustrating still another circuit configuration example of the pixel 40. The circuit of the pixel 40 shown in Fig. 21 shows 8 pixels 40 of 2 × 4.

A pixel 40A and a pixel 40C are pixels adjacent to each other in the lateral direction. The pixel 40A includes a photodiode PD-A, and is configured such that charges generated in the photodiode PD-A are distributed to the tap A and the tap B. The tap A includes a first transfer transistor TG-A, a memory MEM-A, and a second transfer transistor MTR-A. The tap B includes a first transfer transistor TG-B, a memory MEM-B, and a second transfer transistor MTR-B. An overflow transistor OFG-AB is connected to the photodiode PD-A of the pixel 40A.

The pixel 40C includes a photodiode PD-C, and is configured such that charges generated in the photodiode PD-C are distributed to the tap C and the tap D. The tap C includes a first transfer transistor TG-C, a memory MEM-C, and a second transfer transistor MTR-C. The tap D includes a first transfer transistor TG-D, a memory MEM-D, and a second transfer transistor MTR-D. An overflow transistor OFG-CD is connected to the photodiode PD-C of the pixel 40C.

A pixel 40E and a pixel 40G are pixels adjacent to each other in the lateral direction. The pixel 40E includes a photodiode PD-E, and is configured such that the charges generated in the photodiode PD-E are distributed to a tap E and a tap F. The tap E includes a first transfer transistor TG-E, a memory MEM-E, and a second transfer transistor MTR-E. The tap F includes a first transfer transistor TG-F, a memory MEM-F, and a second transfer transistor MTR-F. An overflow transistor OFG-ED is connected to a photodiode PD-E of the pixel 40E.

The pixel 40G includes a photodiode PD-G, and is configured such that charges generated in the photodiode PD-G are distributed to a tap G and a tap H. The tap G includes a first transfer transistor TG-G, a memory MEM-G, and a second transfer transistor MTR-G. The tap H includes a first transfer transistor TG-H, a memory MEM-H, and a second transfer transistor MTR-H. An overflow transistor OFG-GH is connected to a photodiode PD-G of the pixel 40G.

The pixel 40A, the pixel 40C, the pixel 40E, and the pixel 40G are connected to one floating diffusion FD-A. That is, the floating diffusion FD-A is shared by the pixel 40A, the pixel 40C, the pixel 40E, and the pixel 40G. Furthermore, a reset transistor RST-A, an amplification transistor AMP-A, and a selection transistor SEL-A are also shared by the pixel 40A, the pixel 40C, the pixel 40E, and the pixel 40G.

A pixel 40I and a pixel 40K are pixels adjacent to each other in the lateral direction. The pixel 40I includes a photodiode PD-I, and is configured such that charges generated in a photodiode PD-I are distributed to a tap I and a tap J. The tap I includes a first transfer transistor TG-I, a memory MEM-I, and a second transfer transistor MTR-I. The tap J includes a first transfer transistor TG-J, a memory MEM-J, and a second transfer transistor MTR-J. An overflow transistor OFG-IJ is connected to the photodiode PD-I of the pixel 40I.

The pixel 40K includes a photodiode PD-K, and is configured such that charges generated in the photodiode PD-K are distributed to a tap K and a tap L. The tap K includes a first transfer transistor TG-K, a memory MEM-K, and a second transfer transistor MTR-K. The tap L includes a first transfer transistor TG-L, a memory MEM-L, and a second transfer transistor MTR-L. An overflow transistor OFG-KL is connected to the photodiode PD-k of the pixel 40K.

A pixel 40M and a pixel 40O are pixels adjacent in the lateral direction. The pixel 40M includes a photodiode PD-M, and is configured such that the charges generated in the photodiode PD-M is distributed to a tap M and a tap N. The tap M includes a first transfer transistor TG-M, a memory MEM-M, and a second transfer transistor MTR-M. The tap N includes a first transfer transistor TG-N, a memory MEM-N, and a second transfer transistor MTR-N. An overflow transistor OFG-MN is connected to a photodiode PD-M of the pixel 40M.

The pixel 40O includes a photodiode PD-O, and is configured such that charges generated in the photodiode PD-O are distributed to a tap O and a tap P. The tap O includes a first transfer transistor TG-O, a memory MEM-O, and a second transfer transistor MTR-O. A tap P includes a first transfer transistor TG-P, a memory MEM-P, and a second transfer transistor MTR-P. An overflow transistor OFG-OP is connected to a photodiode PD-O of the pixel 40O.

The pixel 40I, the pixel 40K, the pixel 40M, and the pixel 40O are connected to one floating diffusion FD-I. That is, the floating diffusion FD-I is shared by the pixel 40I, the pixel 40K, the pixel 40M, and the pixel 40O. Furthermore, a reset transistor RST-I, an amplification transistor AMP-I, and a selection transistor SEL-I are also shared by the pixel 40I, the pixel 40K, the pixel 40M, and the pixel 40O.

The floating diffusion FD-A and the floating diffusion FD-I are connected to a link transistor FLV-A through a link transistor FLV-I. A reset transistor RST-A is connected in series to the link transistor FLV-A, and a reset transistor RST-I is connected in series to the link transistor FLV-I.

The wirings connected to the first transfer transistor TG, the memory MEM, the second transfer transistor MTR, the reset transistor RST, the amplification transistor AMP, the selection transistor SEL, the overflow transistor OFG, and the link transistor FLV are arranged to satisfy the arrangement of the wirings described with reference to Figs. 12 to 19. The wiring connected to the link transistor FLV corresponds to the drive wiring in the wiring described with reference to Figs. 12 to 19.

The pixel 40 having such a configuration will be further described.

### <Planar configuration example>

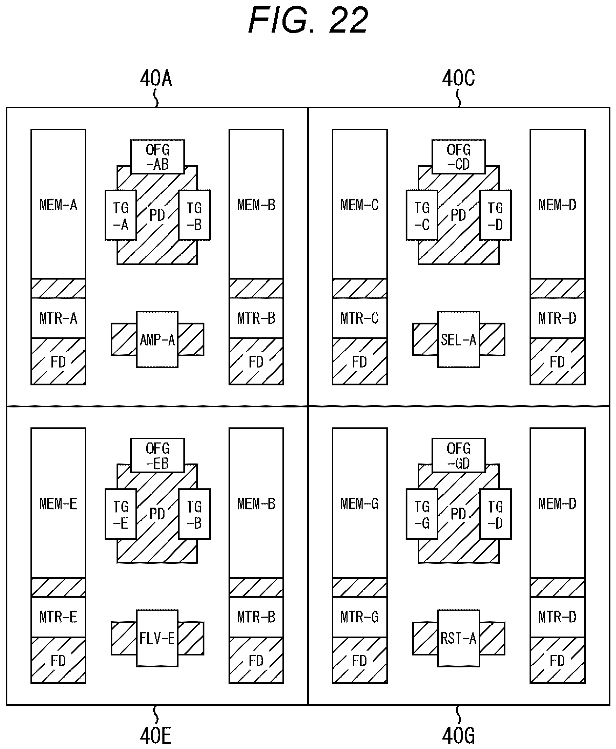

Fig. 22 illustrates a planar configuration example of the pixel 40A, the pixel 40C, the pixel 40E, and the pixel 40G illustrated in Fig. 21. Since the reset transistor RST-A, the amplification transistor RST-A, and the selection transistor SEL-A are shared by the four pixels, these transistors can be dispersedly arranged in the four pixels. Furthermore, since one link transistor FLV-A is provided for each of the four pixels, the link transistor FLV-A is also arranged in any one of the four pixels.

Since the configuration of each pixel 40 of the planar configuration example illustrated in Fig. 22 is basically similar to the configuration of the pixel 40 illustrated in Fig. 10, the description of similar portions will be omitted. In the pixel 40A, the amplification transistor AMP-A is arranged on the lower side of the center in the pixel 40A in the drawing. In the pixel 40C, a selection transistor SEL-A is arranged on the lower side of the center in the pixel 40C in the drawing.

In the pixel 40E, the link transistor FLV-A is arranged on the lower side of the center in the pixel 40E in the drawing. In the pixel 40G, the reset transistor RST-A is arranged on the lower side of the center in the pixel 40G in the drawing. In this manner, the shared transistors can be arranged in a distributed manner.

### <Other circuit configuration>

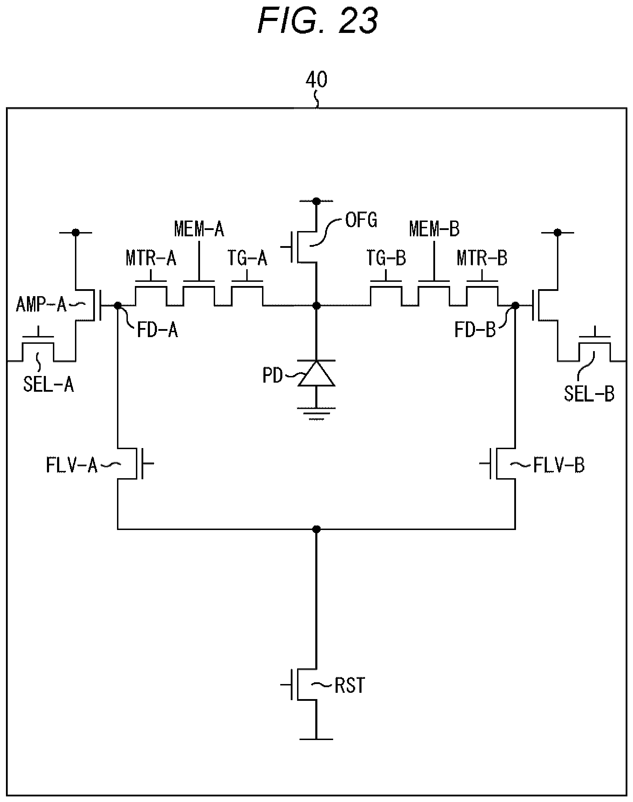

Another circuit configuration including the link transistor FLV is illustrated in Fig. 23. Fig. 23 is a diagram illustrating a circuit configuration of the pixel 40 having a configuration in which two taps of a tap A and a tap B are provided in one pixel and a floating diffusion FD is provided for each tap.

The pixel 40 illustrated in Fig. 23 includes a photodiode PD, and is configured such that charges generated in the photodiode PD are distributed to the tap A and the tap B. The tap A includes a first transfer transistor TG-A, a memory MEM-A, a second transfer transistor MTR-A, a floating diffusion FD-A, an amplification transistor AMP-A, and a selection transistor SEL-A. The tap B includes a first transfer transistor TG-B, a memory MEM-B, a second transfer transistor MTR-B, a floating diffusion FD-B, an amplification transistor AMP-B, and a selection transistor SEL-B.

One end of the link transistor FLV-A is connected to the floating diffusion FD-A, and the other end is connected to the reset transistor RST and a link transistor FLV-B. One end of the link transistor FLV-B is connected to the floating diffusion FD-B, and the other end is connected to the reset transistor RST and the link transistor FLV-A.

In a case where both the link transistor FLV-A and the link transistor FLV-B are off, each of the floating diffusion FD-A and the floating diffusion FD-B operates with a preset capacitance (base capacitance). In this case, the conversion efficiency is High.

In a case where the link transistor FLV-A is turned on and the link transistor FLV-B is turned off, the capacitance of the floating diffusion FD-A increases to a capacitance obtained by adding the capacitance in a region from the floating diffusion FD-A to the link transistor FLV-B to the base capacitance. In this case, the conversion efficiency is in a middle state.

In a case where both the link transistor FLV-A and the link transistor FLV-B are turned on, the capacitance of the floating diffusion FD-A increases to a capacitance obtained by adding the capacitance in the region from the floating diffusion FD-A to the link transistor FLV-B and the capacitance of the floating diffusion FD-B to the base capacitance. In this case, the conversion efficiency is Low.

As described above, the link transistor FLV is turned on so that the capacitance of the floating diffusion FD can be changed, and a desired conversion efficiency state can be obtained. For example, in imaging using infrared rays (IR), RN noise can be reduced by imaging in a state of conversion efficiency High. Furthermore, in the case of performing distance measurement imaging, it is possible to perform imaging in which the link transistor FLV is turned on and the saturation charge amount (Qs) of the floating diffusion FD is increased.

### <Case of being applied to CAPD pixel>

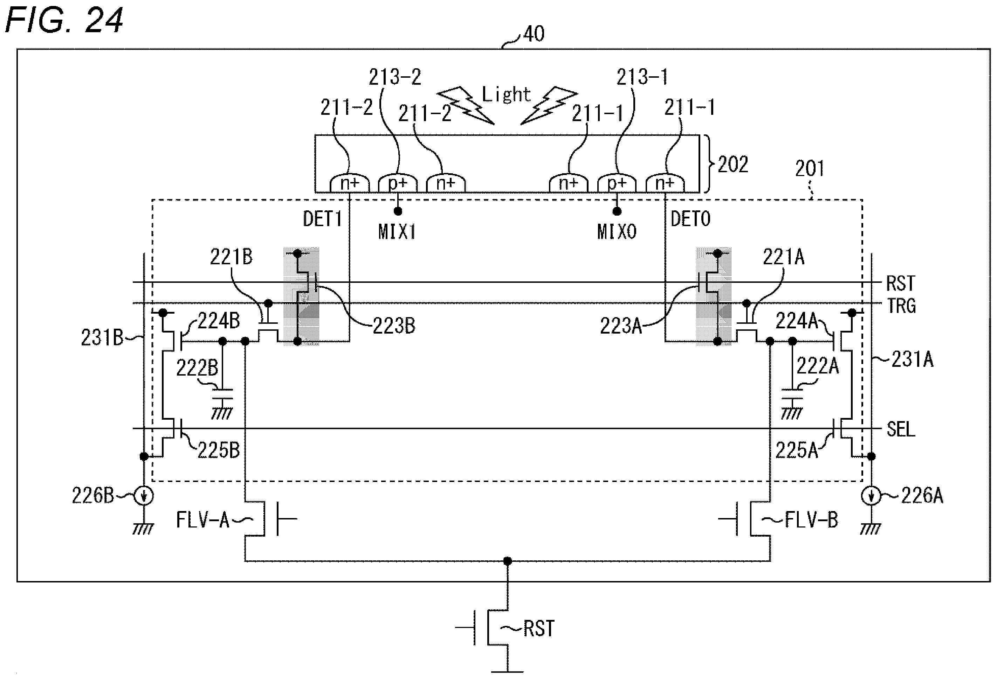

The present disclosure can also be applied to a current assisted photonic demodulator (CAPD) pixel as illustrated in Fig. 24 as a pixel to which the above-described embodiment can be applied. The CAPD pixel is a sensor capable of modulating a wide region in a substrate at high speed by directly applying a voltage to a substrate of the sensor to generate a current in the substrate.

The pixel 40 includes a transfer transistor 221A, a floating diffusion 222A, a reset transistor 223A, an amplification transistor 224A, and a selection transistor 225A with respect to a signal retrieving unit 205-1 including an N+ semiconductor region 211-1, a P+ semiconductor region 213-1, and the like.

Furthermore, the pixel 40 includes a transfer transistor 221B, a floating diffusion 222B, a reset transistor 223B, an amplification transistor 224B, and a selection transistor 225B with respect to a signal retrieving unit 205-2 including an N+ semiconductor region 211-2, a P+ semiconductor region 213-2, and the like.

The vertical drive unit 22 (Fig. 1) applies a predetermined voltage MIX0 (first voltage) to the P+ semiconductor region 213-1, and applies a predetermined voltage MIX1 (second voltage) to the P+ semiconductor region 213-2. For example, one of the voltages MIX0 and MIX1 is 1.5 V and the other is 0 V. The P+ semiconductor regions 213-1 and 213-2 are voltage application units to which the first voltage or the second voltage is applied.

The N+ semiconductor regions 211-1 and 211-2 are charge detection units that detect and accumulate charges generated by photoelectric conversion of light incident on the substrate 202.

In a case where the drive signal TRG supplied to the gate electrode becomes the active state, the transfer transistor 221A becomes a conductive state in response to this, thereby transferring the charges accumulated in the N+ semiconductor region 211-1 to the floating diffusion 222A. In a case where the drive signal TRG supplied to the gate electrode becomes the active state, the transfer transistor 221B becomes a conductive state in response to this, thereby transferring the charges accumulated in the N+ semiconductor region 211-2 to the floating diffusion 222B.

The floating diffusion 222A temporarily holds the charges supplied from the N+ semiconductor region 211-1. The floating diffusion 222B temporarily holds the charges supplied from the N+ semiconductor region 211-2.

In a case where the drive signal RST supplied to the gate electrode becomes active, the reset transistor 223A becomes conductive in response to this, thereby resetting the potential of the floating diffusion 222A to a predetermined level (reset voltage VDD). In a case where the drive signal RST supplied to the gate electrode becomes active, the reset transistor 223B becomes conductive in response to this, thereby resetting the potential of the floating diffusion 222B to a predetermined level (reset voltage VDD). Note that in a case where the reset transistors 223A and 223B are caused to enter the active states, transfer transistors 221A and 221B are also caused to enter the active states simultaneously.

A source electrode of the amplification transistor 224A is connected to the vertical signal line 231A through the selection transistor 225A, whereby a source follower circuit is formed with a load MOS of a constant current source circuit unit 226A connected to one end of the vertical signal line 231A. A source electrode of the amplification transistor 224B is connected to the vertical signal line 231B through the selection transistor 225B, whereby a source follower circuit is formed with a load MOS of a constant current source circuit unit 226B connected to one end of the vertical signal line 231B.

The selection transistor 225A is connected between the source electrode of the amplification transistor 224A and the vertical signal line 231A. In a case where the selection signal SEL supplied to the gate electrode becomes an active state, the selection transistor 225A becomes a conductive state in response to this, and outputs the pixel signal output from the amplification transistor 224A to the vertical signal line 231A.

The selection transistor 225B is connected between the source electrode of the amplification transistor 224B and the vertical signal line 231B. In a case where the selection signal SEL supplied to the gate electrode becomes active, the selection transistor 225B becomes conductive in response to this, and outputs the pixel signal output from the amplification transistor 224B to the vertical signal line 231B.

The transfer transistors 221A and 221B, the reset transistors 223A and 223B, the amplification transistors 224A and 224B, and the selection transistors 225A and 225B of the pixel 40 are controlled by, for example, the vertical drive unit 22.

In a case where the link transistor FLV described with reference to Fig. 23 is provided for the CAPD pixel having such a configuration, a configuration as illustrated in Fig. 24 is obtained. One end of the link transistor FLV-A is connected to the floating diffusion 222 A, and the other end is connected to the reset transistor RST and the link transistor FLV-B. One end of the link transistor FLV-B is connected to the floating diffusion 222B, and the other end is connected to the reset transistor RST and the link transistor FLV-A.

Also, in the CAPD pixel, the capacitance of the floating diffusion FD can be controlled by controlling on and off of the link transistor FLV-A and the link transistor FLV-B, and the conversion efficiency can be switched in a plurality of stages. For example, both the link transistor FLV-A and the link transistor FLV-B are turned on, the floating diffusion 222A and the floating diffusion 222B can be connected (linked), the capacitance of the floating diffusion 222 can be increased, and the conversion efficiency can be set to a low state.

As described above, the present technology can also be applied to the CAPD pixel.

### <Switching of conversion efficiency of pixel 40>

As described with reference to Figs. 23 and 24, the link transistor FLV is used to connect (link) the plurality of floating diffusions FD. The link transistor FLV in the circuit configuration illustrated in Fig. 21 will be described with reference to the circuit configuration example illustrated in Fig. 21 again.

The link transistor FLV-A is connected to the floating diffusion FD-A shared by the four pixels of the pixel 40A, the pixel 40C, the pixel 40E, and the pixel 40G. The link transistor FLV-I is connected to the floating diffusion FD-I shared by four pixels of the pixel 40I, the pixel 40K, the pixel 40M, and the pixel 40O.

A reset transistor RST-A is connected in series to the link transistor FLV-A. A reset transistor RST-I is connected in series to the link transistor FLV-I.

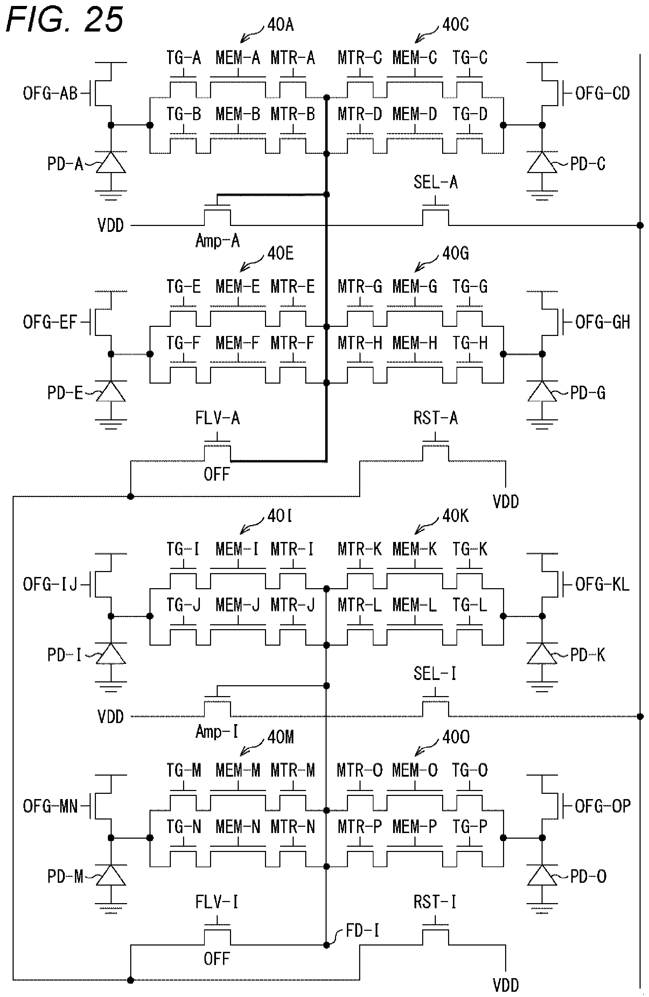

Fig. 25 is a diagram illustrating the capacitance of the floating diffusion FD in a case where both the link transistor FLV-A and the link transistor FLV-I are turned off. In Fig. 25, a portion functioning as the floating diffusion is indicated by a thick line.

In a case where both the link transistor FLV-A and the link transistor FLV-I are off, the conversion efficiency is in a high state. The capacitance of the floating diffusion FD is the capacitance of the floating diffusion FD-A, and in the example illustrated in Fig. 25, the capacitance is a capacitance in a region obtained by combining a region from the second transfer transistor MTR-A and the second transfer transistor MTR-C to the link transistor FLV-A and a region connected to the former region and a gate of the amplification transistor AMP-A.

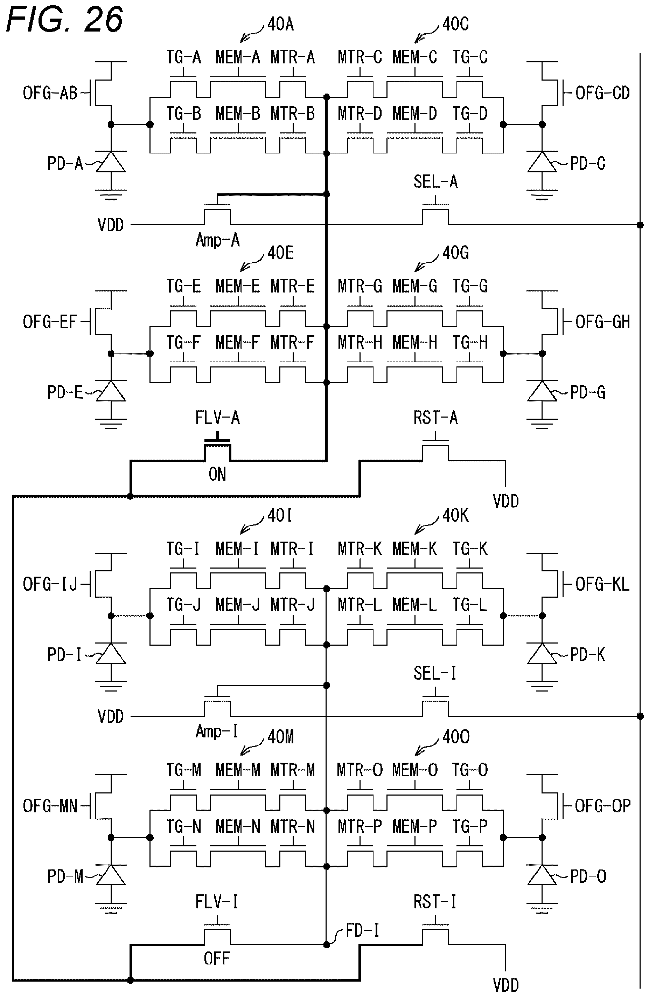

Fig. 26 is a diagram illustrating the capacitance of the floating diffusion FD in a case where the link transistor FLV-A is turned on and the link transistor FLV-I is turned off. In Fig. 26, a portion functioning as the floating diffusion is indicated by a thick line.

In a case where the link transistor FLV-A is turned on and the link transistor FLV-I is turned off, the conversion efficiency is in a middle state. The capacitance of the floating diffusion FD is a capacitance obtained by adding the capacitance of the floating diffusion FD-A (capacitance in a case where conversion efficiency is High), the capacitance in the region from the link transistor FLV-A to the reset transistor RST-A, the capacitance in the region from the link transistor FLV-A to the link transistor FLV-I, and the capacitance in the region from the link transistor FLV-I to the reset transistor RST-I.

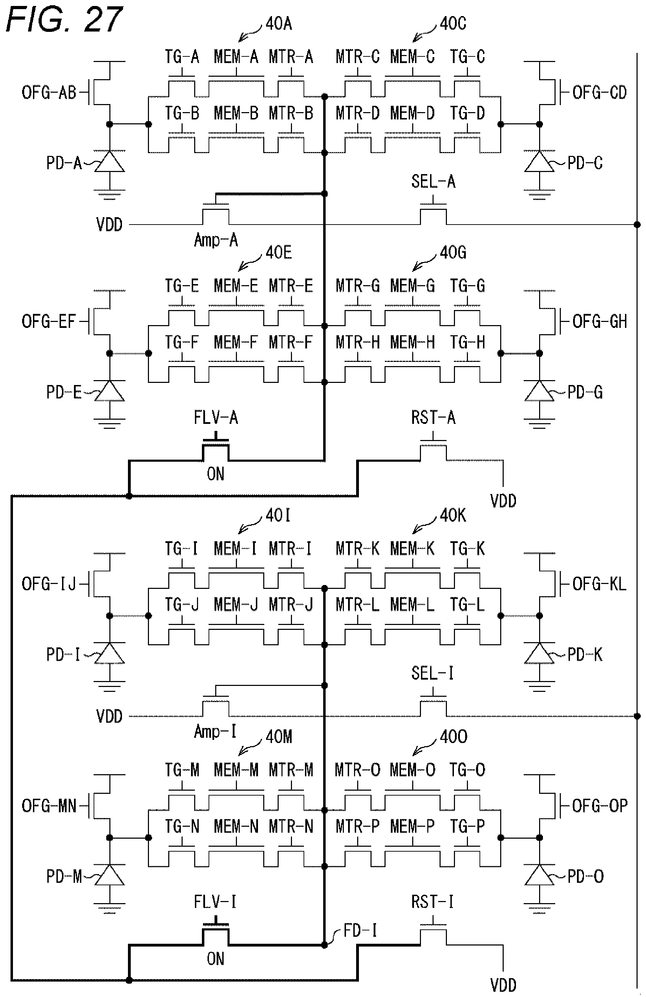

Fig. 27 is a diagram illustrating the capacitance of the floating diffusion FD in a case where both the link transistor FLV-A and the link transistor FLV-I are turned on. In Fig. 27, a portion functioning as the floating diffusion is indicated by a thick line.

In a case where both the link transistor FLV-A and the link transistor FLV-I are off, the conversion efficiency is in a low state. The capacitance of the floating diffusion FD is a capacitance obtained by adding the capacitance of the floating diffusion FD in a case where the conversion efficiency is in the Middle state and the capacitance of the floating diffusion FD-I.

In this manner, the link transistor FLV is provided between the pixels and the link transistor FLV is turned on, so that the floating diffusions FD of the adjacent pixels can be connected to each other, and the capacitance of the floating diffusion FD can be switched. A plurality of link transistors FLV is provided between adjacent pixels and on/off operation of the link transistors FLV is controlled so that a configuration can be made in which conversion efficiency at the time of converting charges generated in the photodiode PD into a voltage can be switched in a plurality of stages.

### <Another circuit configuration example including link transistor FLV>

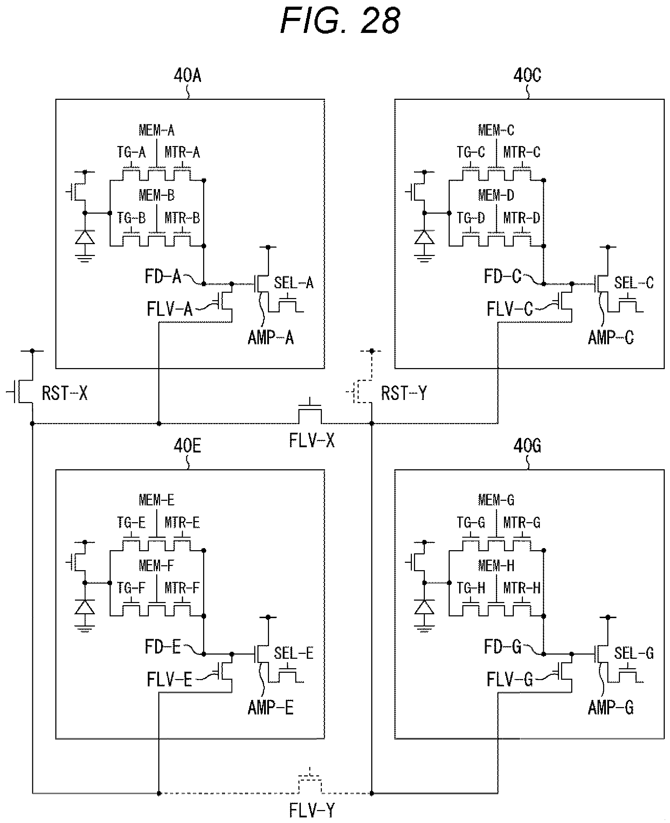

Fig. 28 is a diagram illustrating another circuit configuration of the pixel including the link transistor FLV. Fig. 28 illustrates four pixels of 2 × 2. Each pixel 40 has a 2-tap configuration, and a link transistor FLV is provided in the pixel.

The pixel 40A includes a photodiode PD-A, and is configured such that charges generated in the photodiode PD-A are distributed to the tap A and the tap B. The tap A includes a first transfer transistor TG-A, a memory MEM-A, and a second transfer transistor MTR-A. The tap B includes a first transfer transistor TG-B, a memory MEM-B, and a second transfer transistor MTR-B.

The floating diffusion FD-A, the amplification transistor AMP-A, and the selection transistor SEL-A are configured to be shared by the tap A and the tap B. An overflow transistor OFG-AB shared by the tap A and the tap B is also connected to the photodiode PD-A.

A second transfer transistor MTR-1 and a second transfer transistor MTR-B are connected to the floating diffusion FD-A. The floating diffusion FD-A is also connected to the amplification transistor AMP-A and the link transistor FLV-A.

The pixel 40C also has the similar configuration to that of the pixel 40A, and has a configuration in which the link transistor FLV-C is connected to the floating diffusion FD-C. The pixel 40E also has a configuration similar to that of the pixel 40A, and has a configuration in which a link transistor FLV-E is connected to a floating diffusion FD-E. The pixel 40G has the similar configuration to that of the pixel 40A, and has a configuration in which a link transistor FLV-G is connected to the floating diffusion FD-G.

A link transistor FLV-X is provided between the pixels 40. One end of the link transistor FLV-X is connected to the link transistor FLV-A of the pixel 40A, the link transistor FLV-E of the pixel 40E, and a reset transistor RST-X. The other end of the link transistor FLV-X is connected to the link transistor FLV-C of the pixel 40C and the link transistor FLV-G of the pixel 40G.

A reset transistor RST-Y and a link transistor FLV-Y indicated by the dotted lines in Fig. 28 may not be provided. With the provision of the reset transistor RST-Y and the link transistor FLV-Y, symmetry can be secured.

In a case where the link transistor FLV is turned on as in the above case, the floating diffusion FD can be connected (linked) to increase the capacitance. For example, in a case where the link transistor FLV-A and the link transistor FLV-E are turned on, the floating diffusion FD-A and the floating diffusion FD-E are connected.

For example, in a case where all of the link transistor FLV-A, the link transistor FLV-X, the link transistor FLV-C, the link transistor FLV-E, and the link transistor FLV-G are turned on, the floating diffusion FD-A, the floating diffusion FD-C, the floating diffusion FD-E, and the floating diffusion FD-G are connected.

As described above, with a configuration in which the link transistor FLV is provided in each pixel and the link transistor FLV is provided between the pixels, the capacitance of the floating diffusion FD, in other words, the conversion efficiency can be finely controlled by turning on and off the link transistor FLV.

For example, although details will be described later, in a case of a configuration in which different phase information is acquired in the adjacent pixels 40, the floating diffusion FD is connected and driven, making it possible to operate the floating diffusion FD and the amplification transistor AMP in common, and making it possible to suppress a gain mismatch.

As a cause of the variation in the output from the pixel 40, there is a variation in a portion that converts the charges into the voltage, that is, in this case, the floating diffusion FD. If there is variation in the floating diffusion FD for each pixel, as a result, variation occurs as an output voltage. The floating diffusion FD is shared, so that the variation can be suppressed.

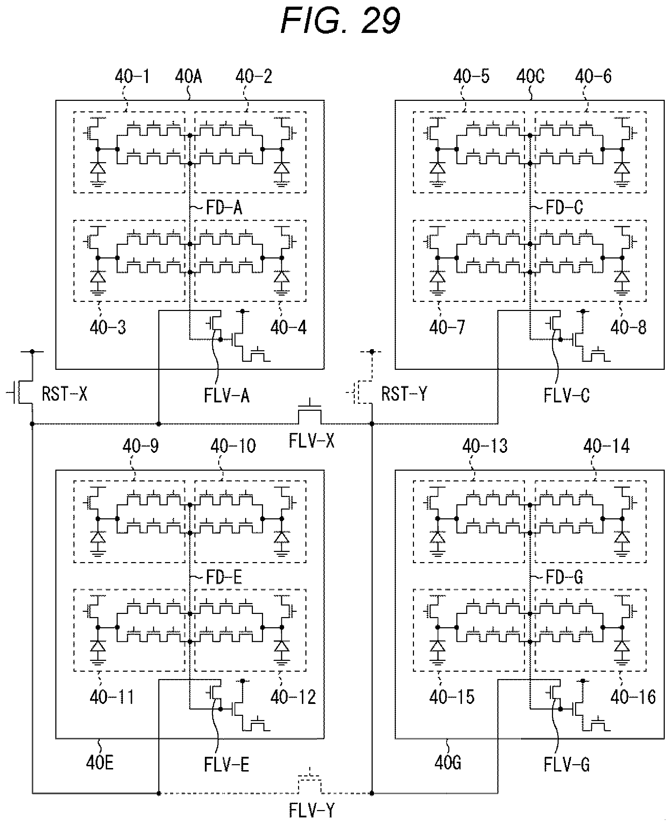

Fig. 29 illustrates a circuit configuration example in a case where the pixel 40 of the circuit configuration of Fig. 21 is applied to the circuit configuration of Fig. 28. Fig. 29 illustrates four pixel groups 40. One pixel group 40 includes four pixels of 2 × 2 in the circuit configuration illustrated in Fig. 21.

The pixel group 40A includes pixels 40-1 to 40-4. For example, a pixel 40-1 corresponds to the pixel 40A in Fig. 21, a pixel 40-2 corresponds to the pixel 40C in Fig. 21, a pixel 40-3 corresponds to the pixel 40E in Fig. 21, and a pixel 40-4 corresponds to the pixel 40G in Fig. 21. The other pixel groups 40 have a similar configuration.

The pixel group 40C includes pixels 40-5 to 40-9, the pixel group 40E includes pixels 40-9 to 40-12, and a pixel group 40G includes pixels 40-13 to 40-16.

The pixel group 40A includes a link transistor FLV-A, and one end of the link transistor FLV-A is connected to the floating diffusion FD-A in the pixel group 40A. The pixel group 40C includes a link transistor FLV-C, and one end of the link transistor FLV-C is connected to the floating diffusion FD-C in the pixel group 40C.

The pixel group 40E includes a link transistor FLV-E, and one end of the link transistor FLV-E is connected to the floating diffusion FD-E in the pixel group 40E. The pixel group 40G includes the link transistor FLV-G, and one end of the link transistor FLV-G is connected to the floating diffusion FD-G in the pixel group 40G.

The link transistor FLV-X is provided between the pixel groups 40. One end of the link transistor FLV-X is connected to the link transistor FLV-A of the pixel group 40A, the link transistor FLV-E of the pixel group 40E, and the reset transistor RST-X. The other end of the link transistor FLV-X is connected to the link transistor FLV-C of the pixel group 40C and the link transistor FLV-G of the pixel group 40G.

The reset transistor RST-Y and the link transistor FLV-Y indicated by the dotted line in Fig. 29 may not be provided. With the provision of the reset transistor RST-Y and the link transistor FLV-Y, symmetry can be secured.

As in the case described above, the link transistor FLV is turned on to connect the floating diffusion FD, increase the capacitance, and switch the conversion efficiency.

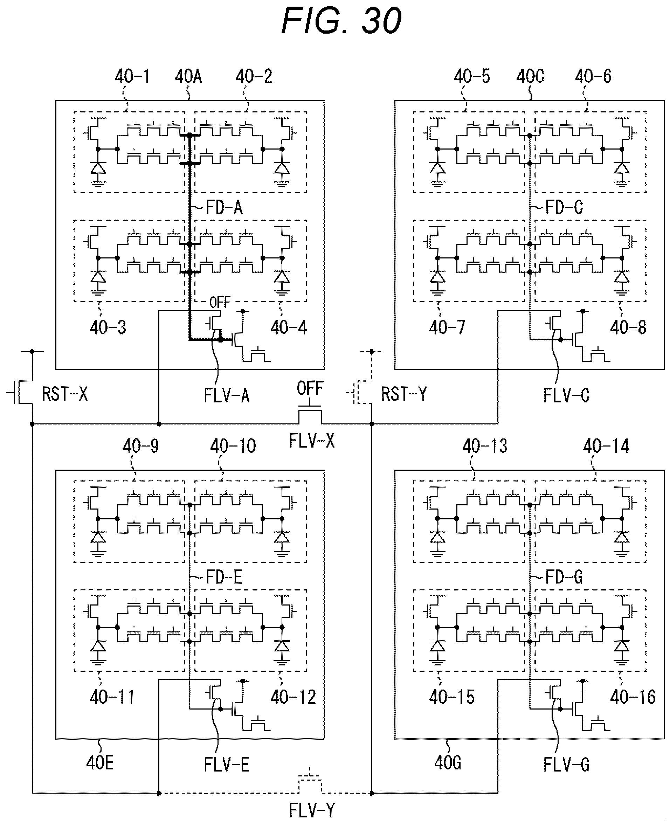

Fig. 30 is a diagram illustrating the capacitance of the floating diffusion FD in a case where all of the link transistor FLV-A, the link transistor FLV-C, the link transistor FLV-E, the link transistor FL-G, and the link transistor FLV-X are turned off. In Fig. 30, a portion functioning as the floating diffusion is indicated by a thick line. In the following description, the link transistor FLV-Y and the reset-Y are not provided or are provided, but the description will be omitted assuming that the same operation as the link transistor FLV-X and the reset transistor RST-X is performed.

In a case where all the link transistors FLV are turned off, the operation is performed with the capacitance (hereinafter, referred to as base capacity appropriately) of only the floating diffusion FD provided in each pixel group 40. In a case where attention is paid to the pixel group 40A, the capacitance of the floating diffusion FD of the pixel group 40A becomes the capacitance of the floating diffusion FD-A, and in the example illustrated in Fig. 30, the capacitance becomes a capacitance in a region obtained by combining a region from between the second transfer transistor MTR-A and the second transfer transistor MTR-C to the link transistor FLV-A, and a region connected to the former region and the gate of the amplification transistor AMP-A.

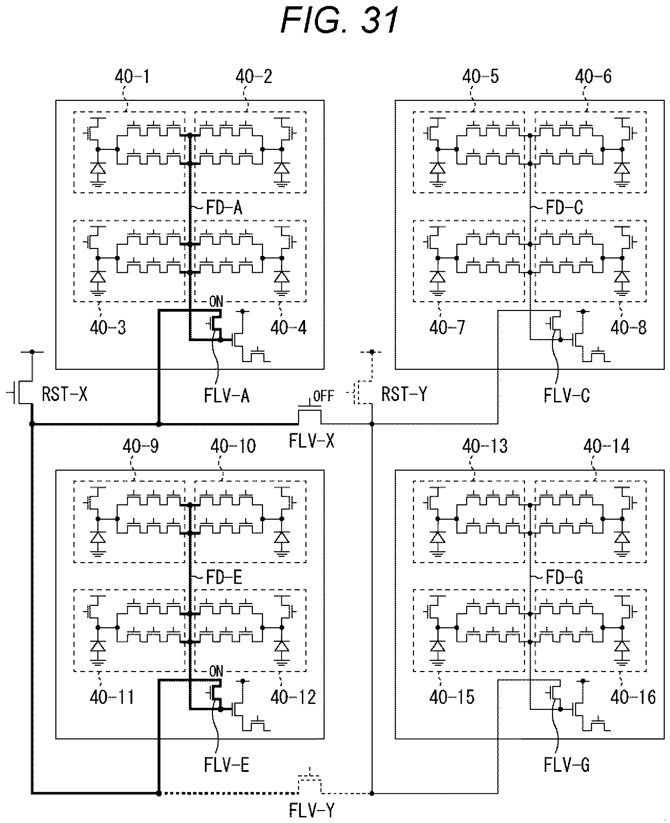

Fig. 31 is a diagram illustrating the capacitance of the floating diffusion FD in a case where the link transistor FLV-A and the link transistor FLV-E are turned on and the link transistor FLV-X is turned off. In Fig. 31, a portion functioning as the floating diffusion is indicated by a thick line. In the example illustrated in Fig. 31, the states of the link transistor FLV-C and the link transistor FL-G are not described.

Fig. 31 illustrates an example in which the floating diffusion FD of the pixel arranged in the vertical direction is connected. First, in a case where the link transistor FLV-A is turned on, the capacitance of the floating diffusion FD is the capacitance obtained by adding the capacitance (base capacitance) of the floating diffusion FD-A, a capacitance in a region from the link transistor FLV-A to the link transistor FLV-E through the reset transistor RST-A, and a capacitance in a region from the link transistor FLV-X to the link transistor FLV-A.

Furthermore, in the example illustrated in Fig. 31, since the link transistor FLV-E is also turned on, the capacitance is also added with the capacitance of the floating diffusion FD-E in the pixel group 40E.

In this way, the link transistor FLV is provided in the pixel group and the link transistor FLV is turned on, so that the floating diffusions FD of the adjacent pixels (the pixels adjacent in the vertical direction in Fig. 31) are connected to each other, the capacitance of the floating diffusion FD is changed, and the conversion efficiency can be switched.

Although not illustrated, in a case where the capacitance of the floating diffusion FD in the pixels adjacent in the vertical direction is changed, as illustrated in Fig. 26, it is also possible to perform control to turn on the link transistor FLV-A and turn off the link transistor FLV-E. Thus, the capacitance of the floating diffusion FD can be more finely controlled by the combination of the link transistor FLV to be turned on and the link transistor FLV to be turned off.

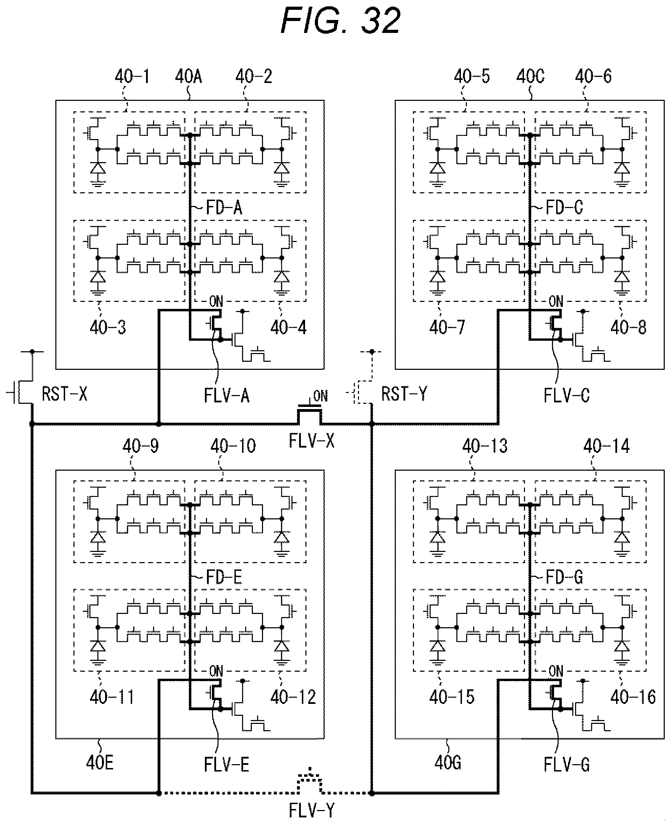

Fig. 32 is a diagram illustrating the capacitance of the floating diffusion FD in a state where the link transistor FLV-X provided between the pixels is further turned on from the state of Fig. 31, and the link transistor FLV- provided in the pixel group 40C and the link transistor FLV-G provided in the pixel group 40G are also turned on.

In addition to the capacitance of the floating diffusion FD at the time of turning on the link transistor FLV-A and the link transistor FLV-E described with reference to Fig. 31, the capacitance of the floating diffusion FD in the pixels adjacent in the horizontal direction is also added by turning on the link transistor FLV-X. That is, in the example illustrated in Fig. 31, the capacitance of the floating diffusion FD-C of the pixel group 40C and the capacitance of the floating diffusion FD-G of the pixel group 40G are added.

In addition, a capacitance in a region from the link transistor FLV-X to the link transistor FLV-C and a capacitance in a region from the link transistor FLV-X to the link transistor FLV-G are also added.

In this manner, the link transistor FLV is provided in the pixel group and the link transistor FLV is turned on, so that the floating diffusions FD of adjacent pixels (pixels adjacent in the vertical direction and the pixels adjacent in the lateral direction in Fig. 32) are connected to each other, and the capacitance of the floating diffusion FD can be changed.

A plurality of combination patterns of link transistors FLV can be provided in which a plurality of link transistors FLV is provided and the link transistors FLV to be turned on and the link transistors FLV to be turned off can be provided, and the capacitance of the floating diffusion FD can be finely set, in other words, a plurality of stages of conversion efficiency can be provided.

### <Another configuration providing link transistor FLV>

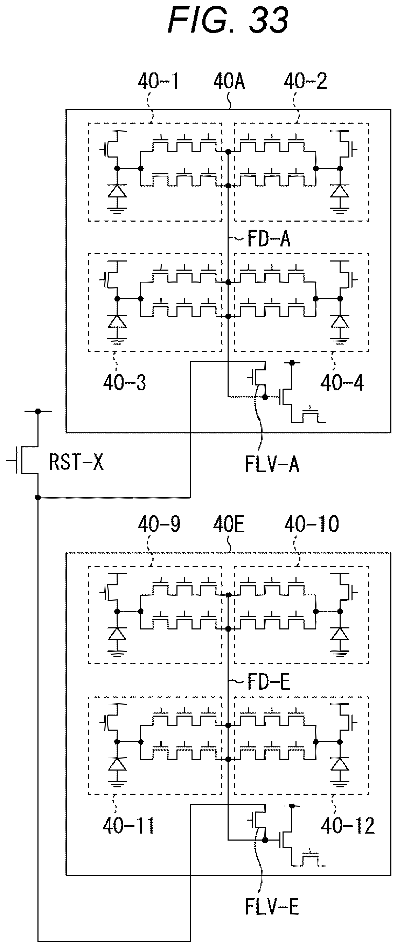

Fig. 33 is a diagram illustrating a circuit configuration example of a pixel in a case where the link transistor FLV is provided. In the example described with reference to Fig. 32 and the like, the case where the link transistor FLV is provided for four pixels (pixel group) of 2 × 2 has been described as an example. However, as illustrated in Fig. 33, the link transistor FLV may be provided for two pixels (pixel group) of 1 × 2 arranged in the vertical direction.

In the circuit configuration example illustrated in Fig. 33, the link transistor FLV-A is provided in the pixel group 40A, and the link transistor FLV-E is provided in the pixel group 40E adjacent in the vertical direction. One end of the link transistor FLV-A and one end of the link transistor FLV-E are connected. Further, the link transistor FLV-A and the link transistor FLV-E are connected in series with the reset transistor RST-X.

As described above, the floating diffusion FD may be connected between the pixels (pixel groups) arranged in the vertical direction, the capacitance may be switched, and the conversion efficiency may be switched.

Note that the number of pixels arranged in the vertical direction to be linked is not limited to two, and a configuration in which the link transistor FLV is provided for two or more pixels and two or more floating diffusions FD are connected can be adopted.

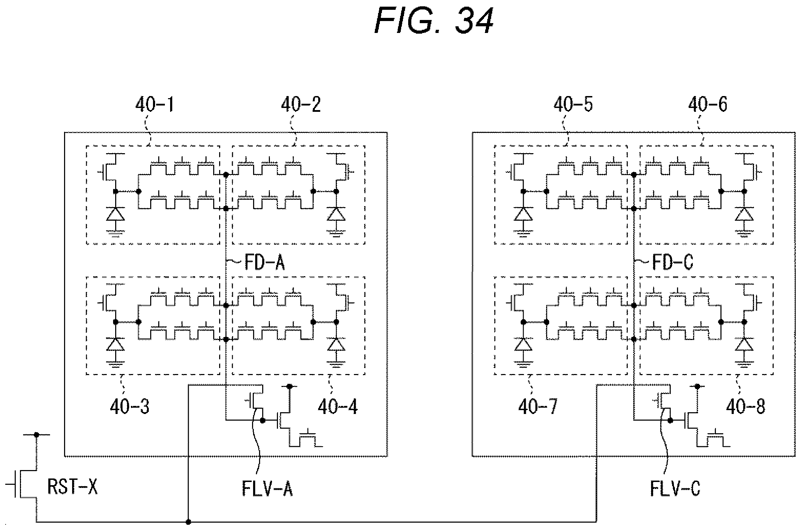

Fig. 34 is a diagram illustrating a circuit configuration example of a pixel in a case where the link transistor FLV is provided. As illustrated in Fig. 34, the link transistor FLV may be provided for two pixels (pixel group) of 2 x 1 arranged in the lateral direction.

In the circuit configuration example illustrated in Fig. 34, the link transistor FLV-A is provided in the pixel group 40A, and the link transistor FLV-C is provided in the pixel group 40C adjacent in the horizontal direction. One end of the link transistor FLV-A and one end of the link transistor FLV-C are connected. Further, the link transistor FLV-A and the link transistor FLV-C are connected in series with the reset transistor RST-X.

As described above, the floating diffusion FD may be connected between the pixels (pixel groups) arranged in the lateral direction, the capacitance may be switched, and the conversion efficiency may be switched.

Note that the number of pixels arranged in the lateral direction to be linked is not limited to two, and a configuration in which the link transistor FLV is provided for two or more pixels and two or more floating diffusions FD are connected can be adopted.

### <Another configuration of link transistor provided between pixels>

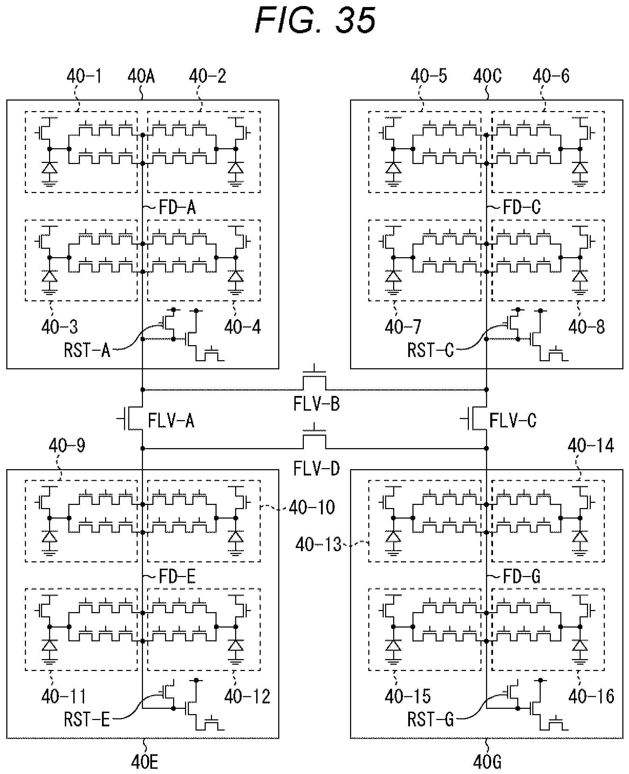

Fig. 35 is a diagram illustrating another circuit configuration example of the pixel including the link transistor FLV between the pixels. In the example illustrated in Fig. 35, a reset transistor RST-A is provided in the pixel group 40A, a reset transistor RST-C is provided in the pixel group 40C, a reset transistor RST-E is provided in the pixel group 40E, and a reset transistor RST-G is provided in the pixel group 40G.

A link transistor FLV-A, a link transistor FLV-B, a link transistor FLV-C, and a link transistor FLV-D are provided between the pixel groups 40.

In the example illustrated in Fig. 35, a reset transistor RST is provided in each pixel group 40, and a link transistor FLV is provided between the pixel groups 40.

In a case where the link transistor FLV-A is turned on, the floating diffusion FD-A in the pixel group 40A and the floating diffusion FD-E in the pixel group 40E are connected. In a case where the link transistor FLV-B is turned on, the floating diffusion FD-A in the pixel group 40A and the floating diffusion FD-C in the pixel group 40C are connected.

In a case where the link transistor FLV-C is turned on, the floating diffusion FD-C in the pixel group 40C and the floating diffusion FD-G in the pixel group 40G are connected. In a case where the link transistor FLV-D is turned on, the floating diffusion FD-E in the pixel group 40E and the floating diffusion FD-G in the pixel group 40G are connected.

In this manner, a plurality of link transistors FLV is provided for connecting the floating diffusions FD in the pixels adjacent in the vertical direction and the horizontal direction between the pixels (pixel groups), so that the capacitance can be switched, and the conversion efficiency can be switched. In addition, different phases (signals obtained from I pixel and Q pixel to be described later) can be read by the same floating diffusion FD.

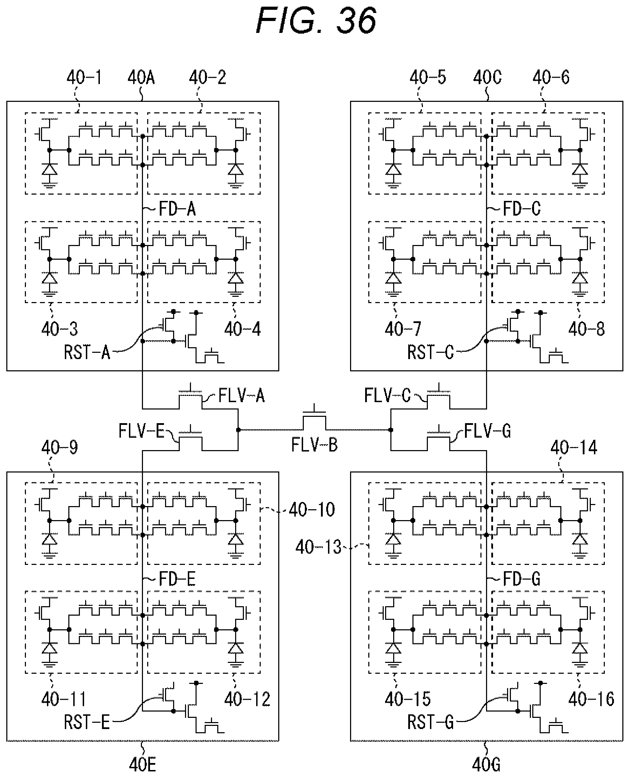

Fig. 36 is a diagram illustrating another circuit configuration example of the pixel including the link transistor FLV between the pixels. In the example illustrated in Fig. 36, as in the example shown in Fig. 35, a reset transistor RST-A is provided in the pixel group 40A, a reset transistor RST-C is provided in the pixel group 40C, a reset transistor RST-E is provided in the pixel group 40E, and a reset transistor RST-G is provided in the pixel group 40G.

A link transistor FLV-A, a link transistor FLV-B, a link transistor FLV-C, a link transistor FLV-E, and a link transistor FLV-G are provided between the pixel groups 40.

In the example illustrated in Fig. 36, a reset transistor RST is provided in each pixel group 40, and a link transistor FLV is provided between the pixel groups 40.

In a case where the link transistor FLV-A is turned on and the link transistor FLV-E is turned on, the floating diffusion FD-A in the pixel group 40A and the floating diffusion FD-E in the pixel group 40E are connected. In a case where the link transistor FLV-C is turned on and the link transistor FLV-G is turned on, the floating diffusion FD-C in the pixel group 40C and the floating diffusion FD-G in the pixel group 40G are connected.

In a case where the link transistor FLV-A, the link transistor FLV-B, and the link transistor FLV-C are turned on, the floating diffusion FD-A in the pixel group 40A and the floating diffusion FD-C in the pixel group 40C are connected. In a case where the link transistor FLV-E, the link transistor FLV-B, and the link transistor FLV-G are turned on, the floating diffusion FD-E in the pixel group 40E and the floating diffusion FD-G in the pixel group 40G are connected.

In a case where all of the link transistor FLV-A, the link transistor FLV-B, the link transistor FLV-C, the link transistor FLV-E, and the link transistor FLV-G are turned off, for example, the pixel group 40A is in a state of operating with the capacitance of only the floating diffusion FD-A. This state is set to a state of conversion efficiency High.

In a case where the link transistor FLV-A and the link transistor FLV-E are turned on, for example, the pixel group 40A is in a state of operating with a capacitance obtained by adding the floating diffusion FD-A and the floating diffusion FD-E. This state is referred to as a conversion efficiency Middle state.

In a case where all of the link transistor FLV-A, the link transistor FLV-B, the link transistor FLV-C, the link transistor FLV-E, and the link transistor FLV-G are turned on, the floating diffusion FD-A, the floating diffusion FD-C, the floating diffusion FD-E, and the floating diffusion FD-G operate with a capacitance obtained by adding the respective capacitances of the floating diffusion FD-A, the floating diffusion FD-C, the floating diffusion FD-E, and the floating diffusion FD-G. This state is set to a state of conversion efficiency Low.

As described above, in a case where on/off operation of the link transistor FLV is controlled, the pixel in the circuit configuration illustrated in Fig. 36 can be configured to be able to switch conversion efficiency in three stages.

In this manner, further, a plurality of link transistors FLV is provided for connecting the floating diffusions FD in the pixels adjacent in the vertical direction and the horizontal direction between the pixels (pixel groups), so that the capacitance can be switched, and the conversion efficiency can be switched. In addition, different phases can be read by the same floating diffusion FD.

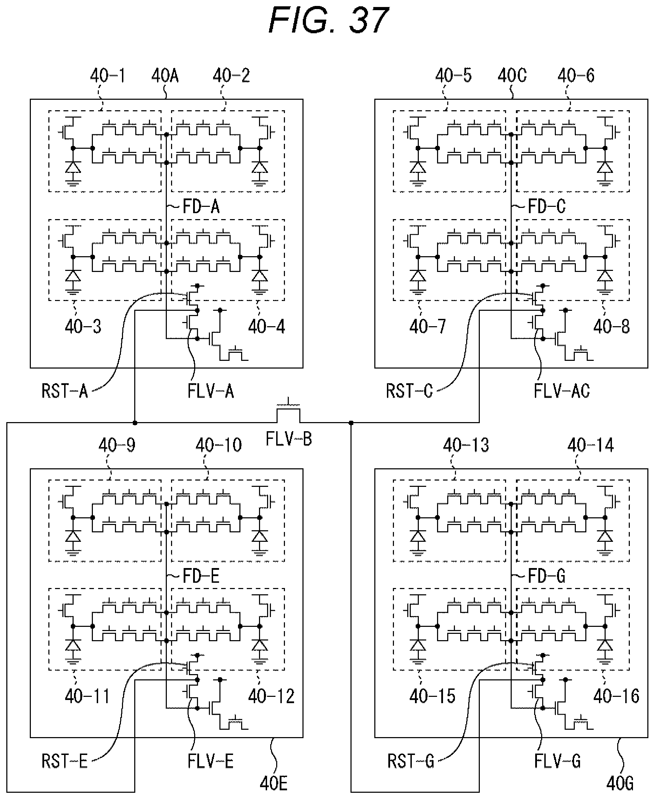

Fig. 37 is a diagram illustrating a circuit configuration example of a pixel including the link transistor FLV in the pixel. In the example illustrated in Fig. 37, a reset transistor RST and a link transistor FLV are provided in each pixel group 40.

In the example illustrated in Fig. 37, a reset transistor RST-A and a link transistor FLV-A are provided in the pixel group 40A. In the pixel group 40C, a reset transistor RST-C and a link transistor FLV-C are provided.

In the pixel group 40E, a reset transistor RST-E and a link transistor FLV-E are provided. In the pixel group 40G, a reset transistor RST-G and a link transistor FLV-G are provided. A link transistor FLV-B is provided between the pixel groups.

The operation of the pixel in the circuit configuration illustrated in Fig. 37 is basically similar to the operation of the pixel in the circuit configuration illustrated in Fig. 36. In a case where the link transistor FLV-A is turned on and the link transistor FLV-E is turned on, the floating diffusion FD-A in the pixel group 40A and the floating diffusion FD-E in the pixel group 40E are connected. In a case where the link transistor FLV-C is turned on and the link transistor FLV-G is turned on, the floating diffusion FD-C in the pixel group 40C and the floating diffusion FD-G in the pixel group 40G are connected.

In a case where the link transistor FLV-A, the link transistor FLV-B, and the link transistor FLV-C are turned on, the floating diffusion FD-A in the pixel group 40A and the floating diffusion FD-C in the pixel group 40C are connected. In a case where the link transistor FLV-E, the link transistor FLV-B, and the link transistor FLV-G are turned on, the floating diffusion FD-E in the pixel group 40E and the floating diffusion FD-G in the pixel group 40G are connected.

In a case where all of the link transistor FLV-A, the link transistor FLV-B, the link transistor FLV-C, the link transistor FLV-E, and the link transistor FLV-G are turned off, for example, the pixel group 40A is in a state of operating with the capacitance of only the floating diffusion FD-A. This state is set to a state of conversion efficiency High.

In a case where the link transistor FLV-A and the link transistor FLV-E are turned on, for example, the pixel group 40A is in a state of operating with a capacitance obtained by adding the floating diffusion FD-A and the floating diffusion FD-E. This state is referred to as a conversion efficiency Middle state.

In a case where all of the link transistor FLV-A, the link transistor FLV-B, the link transistor FLV-C, the link transistor FLV-E, and the link transistor FLV-G are turned on, the floating diffusion FD-A, the floating diffusion FD-C, the floating diffusion FD-E, and the floating diffusion FD-G operate with a capacitance obtained by adding the respective capacitances of the floating diffusion FD-A, the floating diffusion FD-C, the floating diffusion FD-E, and the floating diffusion FD-G. This state is set to a state of conversion efficiency Low.

As described above, in a case where on/off operation of the link transistor FLV is controlled, the pixel in the circuit configuration illustrated in Fig. 36 can be configured to be able to switch conversion efficiency in three stages.

In this manner, further, a plurality of link transistors FLV is provided for connecting the floating diffusions FD in the pixels adjacent in the vertical direction and the horizontal direction between the pixels (pixel groups), so that the capacitance can be switched, and the conversion efficiency can be switched. In addition, different phases can be read by the same floating diffusion FD.

### <Application to I pixel and Q pixel>

The above-described embodiment can also be applied to the I pixel and the Q pixel. For example, in a case where the pixel 40 includes a tap A and a tap B, a detection signal having a phase of 0° is acquired in the tap A, and a detection signal having a phase of 180° is acquired in the tap B. In this manner, an in-phase component with respect to a modulated wave of light is referred to as I pixel data, and a pixel for acquiring the I pixel data is referred to as an I pixel.

In a case where the pixel 40 is configured to include a tap C and a tap D, a detection signal having a phase of 90° is acquired in the tap C, and a detection signal having a phase of 270° is acquired in the tap D. As described above, a quadrature component with respect to a modulated wave of light is referred to as Q pixel data, and a pixel for acquiring the Q pixel data is referred to as a Q pixel.

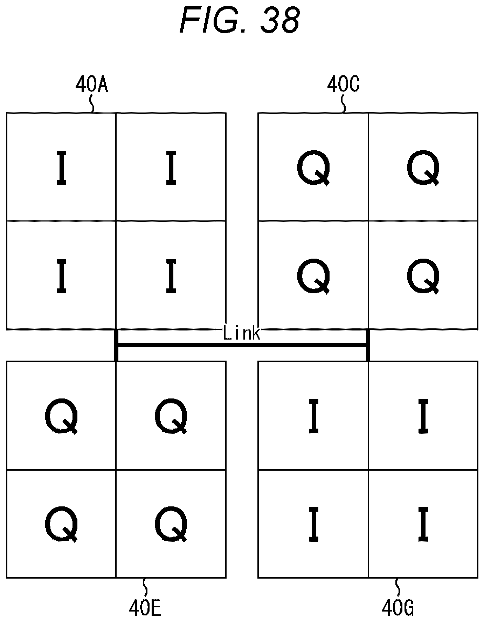

Fig. 38 is a diagram illustrating an arrangement example of the I pixel and the Q pixel. The pixel group 40A corresponds to, for example, the pixel group 40A illustrated in Fig. 37, and includes four I pixels. Referring again to Fig. 37, the pixel group 40A includes pixels 40-1 to 40-4. Each of the pixels 40-1 to 40-4 is configured to function as an I pixel.

A pixel group 40C illustrated in Fig. 38 corresponds to, for example, the pixel group 40C illustrated in Fig. 37, and includes four Q pixels. Referring again to Fig. 37, the pixel group 40C includes pixels 40-5 to 40-8. Each of the pixels 40-5 to 40-8 is configured to function as a Q pixel.

The pixel group 40E corresponds to, for example, the pixel group 40E illustrated in Fig. 37, and includes four Q pixels. Referring again to Fig. 37, the pixel group 40E includes pixels 40-9 to 40-12. Each of the pixels 40-9 to 40-12 is configured to function as a Q pixel.

The pixel group 40G illustrated in Fig. 38 corresponds to, for example, the pixel group 40G illustrated in Fig. 37, and includes four I pixels. Referring again to Fig. 37, the pixel group 40G includes pixels 40-13 to 40-16. Each of the pixels 40-13 to 40-16 is configured to function as an I pixel.

In the example illustrated in Fig. 38, a pixel group including four pixels of 2 × 2 includes I pixels or Q pixels. An I pixel group including I pixels and a Q pixel group including Q pixels are arranged in a staggered manner.

With the configuration in which the floating diffusion FD is shared by the plurality of I pixels included in the I pixel group, it is possible to suppress variations in output voltages output from different I pixels. In addition, the floating diffusion FD is shared by the plurality of Q pixels included in the Q pixel group, so that it is possible to suppress variations in output voltages output from different Q pixels.

Furthermore, since the wirings of the two first transfer transistors TG included in the I pixel and the Q pixel are arranged such that the parasitic capacitances are made uniform as described with reference to Figs. 12 to 19, it is possible to suppress variations at the time of reading the transfer transistors. Therefore, the distance measurement accuracy can be improved.

The link transistor FLV is provided at a position connecting the I pixel group 40A, the Q pixel group 40C, the Q pixel group 40E, and the I pixel group 40G. In a case where the link transistor FLV is turned on, the I pixel group 40A, the Q pixel group 40C, the Q pixel group 40E, and the I pixel group 40G are connected, and the floating diffusion FD in each pixel group is connected as indicated by a thick line illustrated with Link in the drawing. The configuration of the Link can be applied to any of the configurations described above.

Although the adjacent I pixel and Q pixel acquire different phase information, in the case of such a configuration, the floating diffusion FD is connected and driven, making it possible to operate the floating diffusion FD and the amplification transistor AMP in common, and making it possible to suppress a gain mismatch.

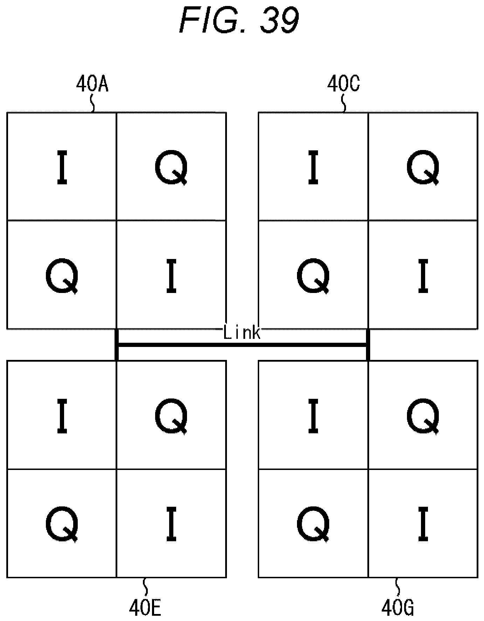

Fig. 39 is a diagram illustrating another arrangement example of the I pixel and the Q pixel. The pixel group 40A corresponds to, for example, the pixel group 40A illustrated in Fig. 37, and includes two I pixels and two Q pixels. Referring again to Fig. 37, the pixel group 40A includes pixels 40-1 to 40-4. The pixel 40-1 and the pixel 40-4 function as the I pixels, and the pixel 40-2 and the pixel 40-3 function as the Q pixels. In the pixel group 40A, the I pixel and the Q pixel are arranged in a staggered manner.

A pixel group 40C illustrated in Fig. 39 corresponds to, for example, the pixel group 40C illustrated in Fig. 37, and includes two I pixels and two Q pixels. Referring again to Fig. 37, the pixel group 40C includes pixels 40-5 to 40-8. The pixel 40-5 and the pixel 40-8 function as the I pixels, and the pixel 40-6 and the pixel 40-7 function as the Q pixels. In the pixel group 40C, the I pixel and the Q pixel are arranged in a staggered manner.

The pixel group 40E corresponds to, for example, the pixel group 40E illustrated in Fig. 37, and includes two I pixels and two Q pixels. Referring again to Fig. 37, the pixel group 40E includes pixels 40-9 to 40-12. The pixel 40-9 and the pixel 40-12 function as the I pixels, and the pixel 40-10 and the pixel 40-11 function as the Q pixels. In the pixel group 40E, the I pixels and the Q pixels are arranged in a staggered manner.

The pixel group 40G corresponds to, for example, the pixel group 40G illustrated in Fig. 37, and includes two I pixels and two Q pixels. Referring again to Fig. 37, the pixel group 40G includes pixels 40-9 to 40-12. The pixel 40-9 and the pixel 40-12 function as the I pixels, and the pixel 40-10 and the pixel 40-11 function as the Q pixels. In the pixel group 40G, the I pixels and the Q pixels are arranged in a staggered manner.

In the example illustrated in Fig. 39, a pixel group including four pixels of 2 × 2 includes I pixels and Q pixels, and the I pixels and the Q pixels are arranged in a staggered manner.

The link transistor FLV is provided at a position connecting the pixel group 40A, the pixel group 40C, the pixel group 40E, and the pixel group 40G. In a case where the link transistor FLV is turned on, the pixel group 40A, the pixel group 40C, the pixel group 40E, and the pixel group 40G are connected, and the floating diffusion FD in each pixel group is connected as indicated by a thick line illustrated with Link in the drawing.

Although the adjacent I pixel and Q pixel acquire different phase information, in the case of such a configuration, the floating diffusion FD is connected and driven, making it possible to operate the floating diffusion FD and the amplification transistor AMP in common, and making it possible to suppress a gain mismatch.

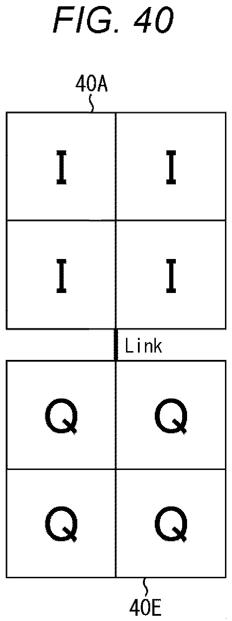

Fig. 40 is a diagram illustrating another configuration example including the link transistor FLV including the I pixels and the Q pixels. The configuration described above with reference to Fig. 38 has been described by taking the case of being linked by the four pixel groups of 2 × 2 as an example. However, as illustrated in Fig. 40, the configuration may be such that two pixel groups of 1 × 2 are linked.

The example illustrated in Fig. 40 illustrates an example in which a pixel group 40A and a pixel group 40E arranged in the vertical direction with respect to the pixel group 40A are linked. The pixel 40A includes four I pixels, and the pixel 40E includes four Q pixels. In this manner, a configuration can be provided in which two pixel groups of the I pixel group 40A including the I pixels adjacent in the vertical direction and the Q pixel group 40E including the Q pixels are linked.

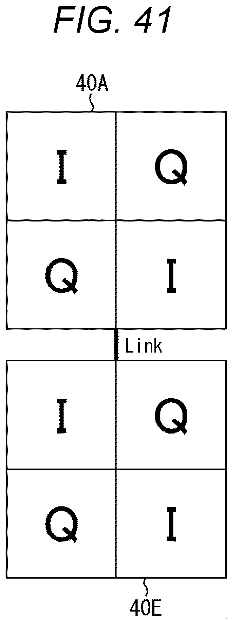

Fig. 41 is a diagram illustrating another configuration example of the pixels including the I pixels and the Q pixels and including the link transistor FLV. The configuration described above with reference to Fig. 39 has been described by taking the case of being linked by the four pixel groups of 2 × 2 as an example. However, as illustrated in Fig. 41, the configuration may be such that two pixel groups of 1 × 2 are linked.

The example illustrated in Fig. 41 illustrates an example in which a pixel group 40A and a pixel group 40E arranged in the vertical direction with respect to the pixel group 40A are linked. Furthermore, the pixel 40A includes two I pixels and two Q pixels, and the I pixels and the Q pixels are arranged in a staggered manner. The pixel 40E includes two I pixels two Q pixels, and the I pixels and the Q pixels are arranged in a staggered manner.

As described above, a configuration can be provided in which two pixels of the pixel group 40A including the I pixel and the Q pixel adjacent in the vertical direction and the pixel group 40E including the I pixels and the Q pixels are linked.

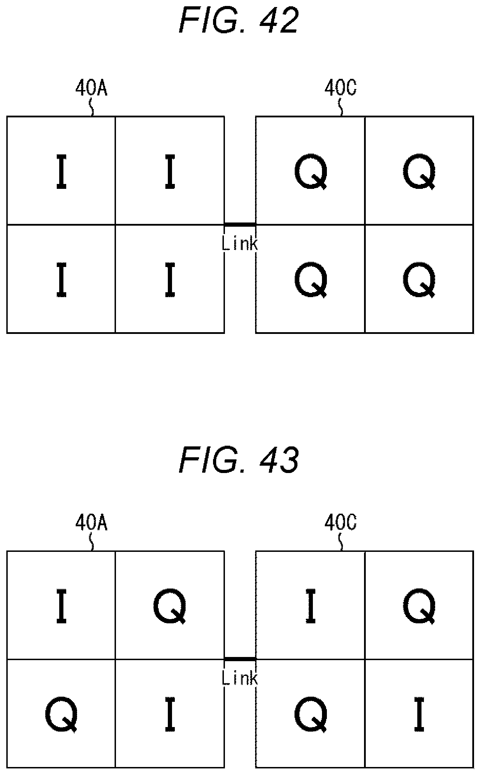

Fig. 42 is a diagram illustrating another configuration example including the I pixels and the Q pixels and including the link transistor FLV. The configuration described above with reference to Fig. 38 has been described by taking the case of being linked by the four pixel groups of 2 × 2 as an example. However, as illustrated in Fig. 42, the configuration may be such that two pixel groups of 2 × 1 are linked.

The example illustrated in Fig. 42 illustrates an example in which a pixel group 40A and a pixel group 40C arranged in the lateral direction with respect to the pixel group 40A are linked. The pixel 40A includes four I pixels. The pixel 40C includes four Q pixels.

In this manner, a configuration can be provided in which two pixel groups of the I pixel group 40A including the I pixels adjacent in the lateral direction and the Q pixel group 40C including the Q pixels are linked.

Fig. 43 is a diagram illustrating another configuration example including the link transistor FLV including the I pixels and the Q pixels. The configuration described above with reference to Fig. 39 has been described by taking the case of being linked by the four pixel groups of 2 × 2 as an example. However, as illustrated in Fig. 43, the configuration may be such that two pixel groups of 2 × 1 are linked.

The example illustrated in Fig. 42 illustrates an example in which a pixel group 40A and a pixel group 40C arranged in the lateral direction with respect to the pixel group 40A are linked. The pixel 40A includes two I pixels and two Q pixels, and the I pixels and the Q pixels are arranged in a staggered manner. The pixel 40C includes two I pixels two Q pixels, and the I pixels and the Q pixels are arranged in a staggered manner.

As described above, a configuration can be provided in which two pixels of the pixel group 40A including the I pixel and the Q pixel adjacent in the lateral direction and the pixel group 40C including the I pixels and the Q pixels are linked.

### <Planar configuration example>

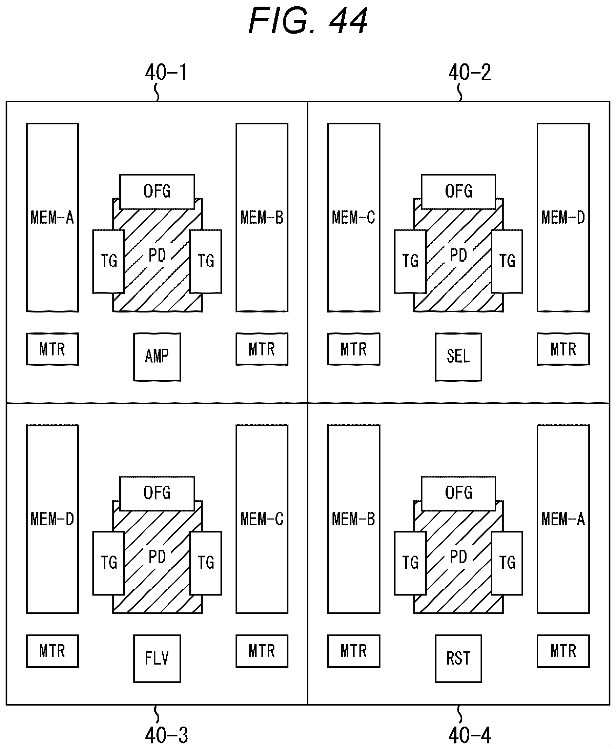

For example, Fig. 44 illustrates a planar configuration example of the pixel 40 in a case where the I pixels and the Q pixels are arranged in a staggered manner as in the pixel 40A and the pixel 40C illustrated in Fig. 43.

Fig. 44 illustrates a planar configuration example of the pixel 40A illustrated in Fig. 43. The pixel 40-1 is an I pixel, the pixel 40-2 is a Q pixel, the pixel 40-3 is a Q pixel, and the pixel 40-4 is an I pixel. The circuit configuration of one pixel 40 has, for example, a circuit configuration as illustrated in Fig. 3, and the planar configuration has, for example, a circuit configuration as illustrated in Fig. 4.

The pixel 40 has two taps and two memories MEM. The pixel 40-1 includes a memory MEM-A and a memory MEM-B. The pixel 40-2 includes a memory MEM-C and a memory MEM-D. The pixel 40-3 includes a memory MEM-A and a memory MEM-B. The pixel 40-4 includes a memory MEM-C and a memory MEM-D. The I pixel includes a memory MEM-A and a memory MEM-B, and the Q pixel includes a memory MEM-C and a memory MEM-D.

For example, it is assumed that the memory MEM-A included in the I pixel accumulates the detection signal having the phase of 0° and the memory MEM-B accumulates the detection signal having the phase of 180°. It is assumed that the memory MEM-C included in the Q pixel accumulates the detection signal having the phase of 90°, and the memory MEM-D accumulates the detection signal having the phase of 270°.

The pixel 40-1 is arranged in the order of the memory MEM-A and the memory MEM-B from the left. The pixel 40-2 is arranged in the order of the memory MEM-A and the memory MEM-B from the left. The pixel 40-3 is arranged in the order of the memory MEM-D and the memory MEM-C from the left. The pixel 40-4 is arranged in the order of the memory MEM-B and the memory MEM-A from the left.

In a case where the pixel 40-1 and the pixel 40-4, which are I pixels, are viewed, the pixel 40-1 is arranged in the order of the memory MEM-A and the memory MEM-B from the left, and the pixel 40-4 is arranged in the order of the memory MEM-B and the memory MEM-A from the left. In a case where only the arrangement of the memories is viewed, since the pixel 40-1 and the pixel 40-4 are arranged in this order from the left, the memory MEM-A, the memory MEM-B, the memory MEM-B, and the memory MEM-A are arranged in this order.

In a case where the pixel 40-2 and the pixel 40-3, which are Q pixels, are viewed, the pixel 40-2 is arranged in the order of the memory MEM-C and the memory MEM-D from the left, and the pixel 40-4 is arranged in the order of the memory MEM-D and the memory MEM-C from the left. In a case where only the arrangement of the memories is viewed, since the pixel 40-3 and the pixel 40-2 are arranged in this order from the left, the memory MEM-D, the memory MEM-C, the memory MEM-C, and the memory MEM-D are arranged in this order.

In a case where attention is paid to the pixel 40-1 of the I pixel and the pixel 40-2 of the Q pixel adjacent in the horizontal direction, the memory MEM is arranged such that the memory MEM-B and the memory MEM-C are adjacent to each other. Similarly, in a case where attention is paid to the pixel 40-4 of the I pixel and the pixel 40-3 of the Q pixel adjacent in the horizontal direction, the memories MEM are arranged such that the memory MEM-B and the memory MEM-C are adjacent to each other. As described above, the memories MEM in the pixels 40 adjacent in the lateral direction are arranged such that the combination of the phases of the phase signals to be detected is the same.

In a case where attention is paid to the pixel 40-1 of the I pixel and the pixel 40-3 of the Q pixel adjacent in the vertical direction, the memory MEM-A and the memory MEM-D are adjacent to each other, and the memory MEM-B and the memory MEM-C are adjacent to each other. Similarly, in a case where attention is paid to the pixel 40-4 of the I pixel and the pixel 40-2 of the Q pixel adjacent in the vertical direction, the memory MEM-B and the memory MEM-C are adjacent to each other, and the memory MEM-A and the memory MEM-D are adjacent to each other. As described above, the memories MEM in the vertically adjacent pixels 40 are arranged such that the combination of the phases of the phase signals to be detected is the same.

As described above, the arrangement of the memories MEM is nested, so that the characteristics of the adjacent I pixel and Q pixel can be made similar, and as a result, the distance measurement accuracy can be improved.

### <Number of times of distance measurement>

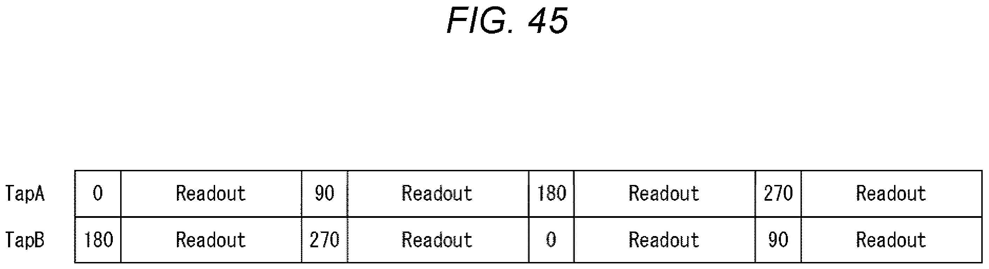

A distance measuring method in the pixel 40 having two taps will be described. First, a conventional distance measuring method will be described with reference to Fig. 45. Here, a method referred to as a two-tap four-phase will be described as an example. A case where a distance to a predetermined object is measured using irradiation light having four phase differences by two taps or by receiving light with four phase differences is referred to as a two-tap four-phase.

In the pixel including the tap A and the tap B (in the figure, TapA and TapB), first, exposure for acquiring a phase signal having a phase of 0° is performed on the tap A, and then, the phase signal having the phase of 0° is read. On the other hand, in the tap B, exposure for acquiring the phase signal having a phase of 180° is performed, and then the phase signal having the phase of 180° is read. In this manner, the first accumulation and reading are performed.

Next, in the tap A, the exposure for acquiring the phase signal having a phase of 90° is performed, and then the phase signal having the phase of 90° is read. On the other hand, in the tap B, exposure for acquiring a phase signal having a phase of 270° is performed, and then the phase signal having the phase of 270° is read. In this manner, the second accumulation and reading are performed.

Next, in the tap A, the exposure for acquiring the phase signal having the phase of 180° is performed, and then the phase signal having the phase of 180° is read. On the other hand, in the tap B, exposure for acquiring the phase signal having the phase of 0° is performed, and then the phase signal having the phase of 0° is read. In this manner, the third accumulation and reading are performed.

Next, in the tap A, the exposure for acquiring the phase signal having the phase of 270° is performed, and then the phase signal having the phase of 270° is read. On the other hand, in the tap B, exposure for acquiring the phase signal having the phase of 90° is performed, and then the phase signal having the phase of 90° is read. Thus, the fourth accumulation and reading are performed.

Conventionally, in order to generate one distance measurement image, accumulation and reading are performed four times.

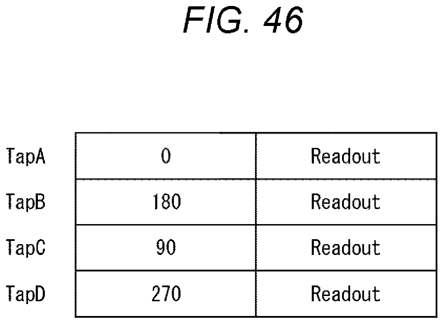

Fig. 46 is a diagram illustrating a distance measuring method to which the present technology is applied. For example, a distance measuring method performed in the pixel 40-1 and the pixel 40-2 (I pixel and Q pixel) illustrated in Fig. 44 will be described as an example.

In the tap A (a side including the memory MEM-A) of the pixel 40-1, exposure for acquiring a phase signal having a phase of 0° is performed, and then the phase signal having the phase of 0° is read. At the same timing, in the tap B (a side including the memory MEM-B) of the pixel 40-1, exposure for acquiring the phase signal having the phase of 180° is performed, and then, the phase signal having the phase of 180° is read.

In a case where such exposure and reading are performed on the pixel 40-1 (I pixel) side, exposure for acquiring a phase signal having a phase of 90° is performed on the tap C (side including the memory MEM-C) of the pixel 40-2, and then, the phase signal having the phase of 90° is read. At the same timing, in the tap D (side including the memory MEM-D) of the pixel 40-2, exposure for acquiring the phase signal having the phase of 270° is performed, and then, the phase signal having the phase of 270° is read.

In the distance measuring method to which the present technology is applied, phase signals having the phase of 0°, the phase of 90°, the phase of 180°, and the phase of 270° are acquired by one-time exposure and reading. It may be referred to as a two-tap one- phase, and phase signals of four different phases are acquired in one phase. Therefore, the operation required for distance measurement can be speeded up.

### <Distance measurement operation>

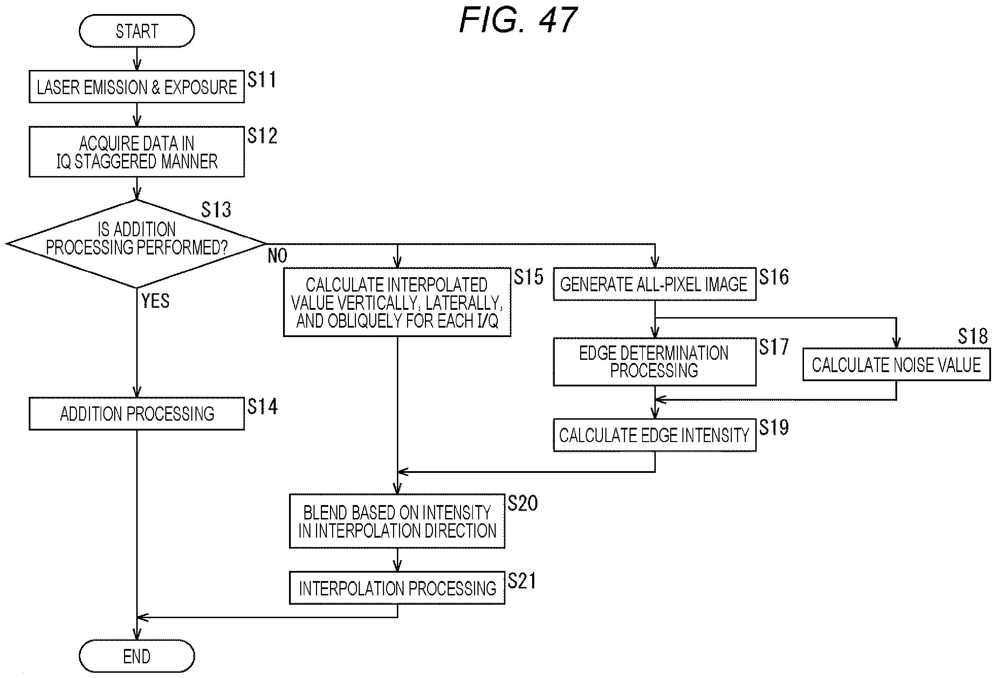

The operation of the pixel 40 having the above-described circuit configuration will be described with reference to a flowchart of Fig. 47.

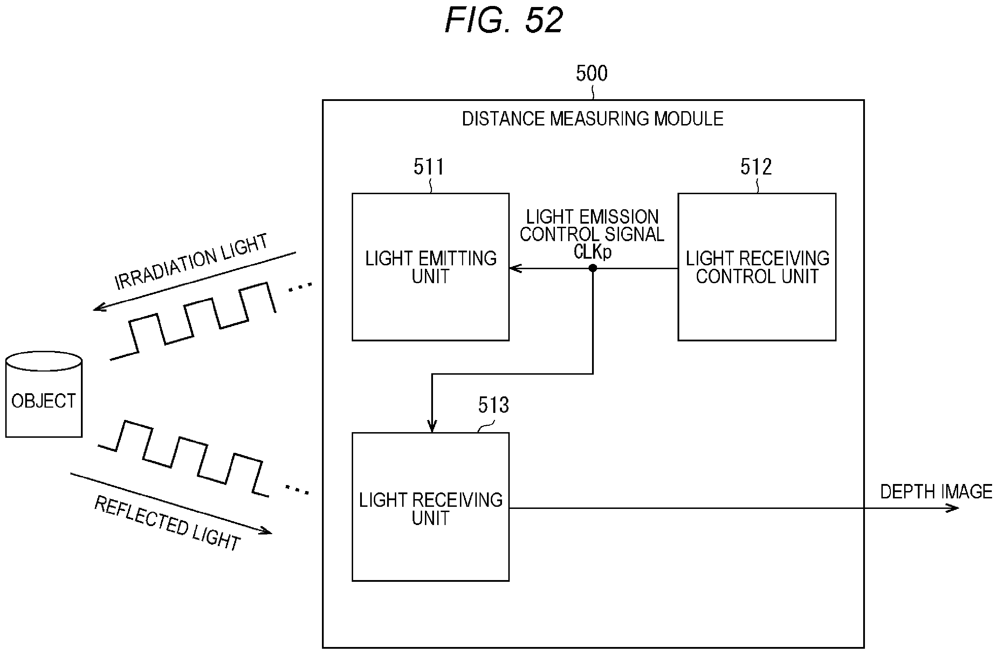

In step S11, a laser is emitted from a light emitting unit 511 (Fig. 52), and exposure is started. In step S12, data (detection signals) is acquired from each of the I pixel and the Q pixel arranged in a staggered manner. As described with reference to Fig. 46, this operation is performed by exposure and reading once in each of the I pixel and the Q pixel.

In step S13, it is determined whether or not to perform addition processing. If it is determined in step S13 that the addition processing is performed, the processing proceeds to step S14.

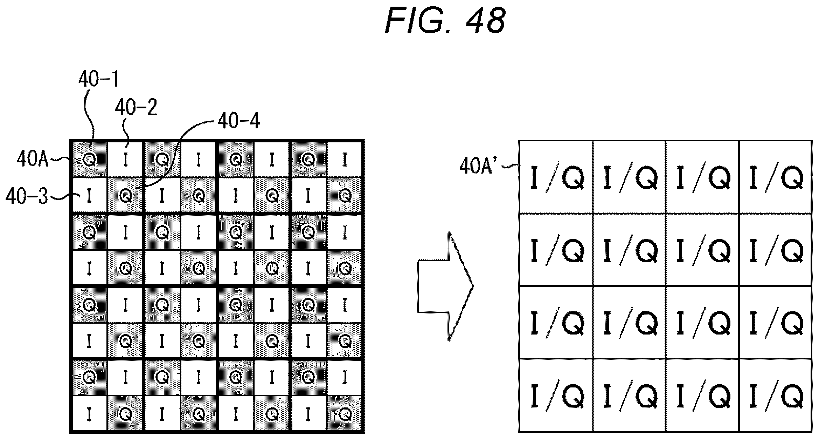

In step S14, addition processing is performed. The addition processing will be described with reference to Fig. 48. As illustrated in a left diagram of Fig. 48, I pixels and Q pixels are arranged in a staggered manner on the pixel array unit 21. In a left diagram of Fig. 48, four pixels of 2 × 2 located on the upper left side are a Q pixel 40-1, an I pixel 40-2, an I pixel 40-3, and a Q pixel 40-4.

For example, Q pixel data is obtained from the Q pixel 40-1, but I pixel data is not obtained. Furthermore, for example, I pixel data is obtained from the I pixel 40-2, but Q pixel data is not obtained. Since the I pixels and the Q pixels are arranged in a staggered manner, in a case of focusing on one pixel, only one of the I pixel data and the Q pixel data is obtained.

In the addition processing, the four pixel groups 40A of 2 × 2 are converted into one pixel 40A', and the pixel 40A' after the conversion is in a state in which both the I pixel data and the Q pixel data are acquired, so that the processing is performed.

The pixels 40-1 to 40-4 of 2 x 2 in the left diagram of Fig. 48 are converted into I/Q pixels 40A' by addition processing as illustrated in the right diagram of Fig. 48. Specifically, a value obtained by adding the Q pixel data of the Q pixel 40-1 and the Q pixel data of the Q pixel 40-4 is generated as the Q pixel data of the I/Q pixel 40A'. Furthermore, a value obtained by adding the I pixel data of the I pixel 40-2 and the I pixel data of the I pixel 40-3 is generated as the I pixel data of the I/Q pixel 40A'.

Through the addition processing in step S14, the pixel 40A' having both the I pixel data and the Q pixel data is generated. The addition processing is performed on all the pixels 40 on the pixel array unit 21, so that the pixel 40A' having both I pixel data and Q pixel data is generated.

According to the addition processing, since the four pixels 40 of 2 x 2 are converted into one pixel 40', the resolution after conversion is lower than the resolution before conversion. Although the resolution is reduced, the amount of data handled is reduced, so that power consumption can be reduced. For this reason, for example, in a case where the mode in which the power consumption is desired to be reduced is set, it can be configured such that it is determined to perform the addition processing in step S13.

On the other hand, in a case where the addition processing is not performed, processing as described later is performed, thereby making it possible to set a state in which one pixel has I pixel data and Q pixel data without reducing the resolution. For example, in a case where a mode for maintaining the resolution is set, it can be configured such that it is determined not to perform the addition processing in step S13.

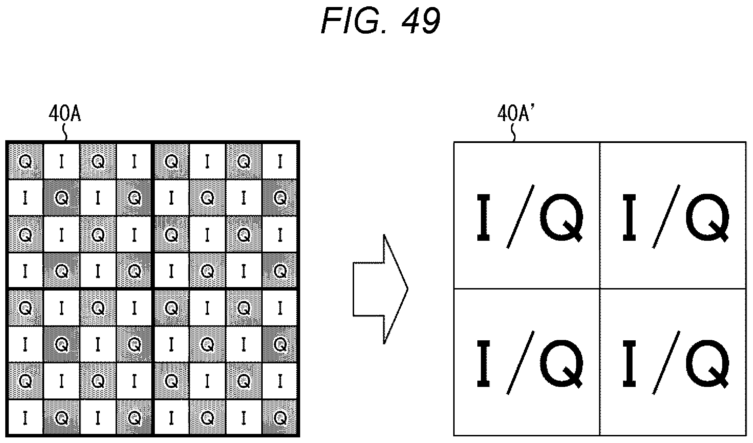

The addition processing described with reference to Fig. 48 has been described with an example in which the four pixels of 2 x 2 are converted into one pixel. However, as illustrated in Fig. 49, a pixel group 40A including 16 pixels of 4 x 4 may be converted into one pixel 40A'. In this case, although the resolution is lower than that in the example illustrated in Fig. 48, the power consumption can be further reduced.

The description is not limited to the case where one pixel after conversion is generated from 16 pixels of 4 x 4, which are generated from four pixels of 2 × 2, and the number of pixels may be other than four pixels and 16 pixels. Furthermore, here, it has been described that the I pixel data or the Q pixel data is generated by addition, but the I pixel data or the Q pixel data may be generated by calculation other than addition, for example, obtaining an average value.

Returning to the description with reference to the flowchart illustrated in Fig. 47, in a case where it is determined in step S13 that the addition processing is not performed, the processing proceeds to step S15 and step S16. Although step S15 and step S16 will be described as processing performed in parallel, it is also possible to configure such that the remaining processing is executed after either processing is completed.

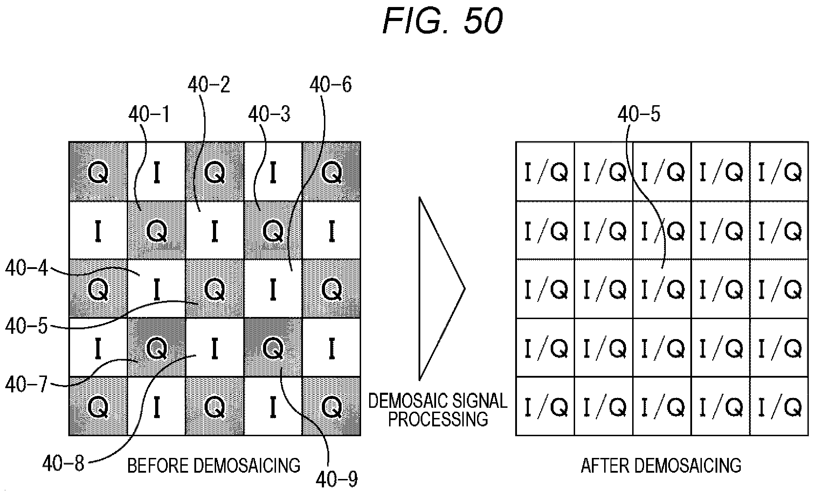

In step S15, interpolation values in vertical, horizontal, and oblique directions are calculated for each of the I pixel and the Q pixel. This processing will be described with reference to Fig. 50. A left diagram in Fig. 50 illustrates the I pixels and the Q pixels arranged in a staggered manner. A case where the interpolation value of the I pixel data is calculated for the Q pixel 40-5 located at the center among the pixels illustrated in the left diagram of Fig. 50 will be described as an example.

A Q pixel 40-1 is located on the upper left of the Q pixel 40-5, an I pixel 40-2 is located on the upper side, and a Q pixel 40-3 is located on the upper right. An I pixel 40-4 is located on the left with respect to the Q pixel 40-5, and an I pixel 40-6 is located on the right. A Q pixel 40-7 is located at the lower left of the Q pixel 40-5, an I pixel 40-8 is located below, and a Q pixel 40-9 is located at the lower right.

The interpolation value in the vertical direction for the Q pixel 40-5 is obtained by calculating an average value of the I pixel data of the I pixel 40-2 and the I pixel data of the I pixel 40-8 positioned vertically with respect to the Q pixel 40-5. The interpolation value in the horizontal direction with respect to the Q pixel 40-5 is obtained by calculating an average value of the I pixel data of the I pixel 40-4 and the I pixel data of the I pixel 40-6 positioned on the left and right with respect to the Q pixel 40-5.

The interpolation value in the oblique direction with respect to the Q pixel 40-5 is obtained by calculating an average value of the I pixel data of the I pixel 40-2 and the I pixel data of the I pixel 40-4 in an oblique positional relationship with respect to the Q pixel 40-5. Alternatively, the interpolation value is obtained by calculating an average value of the I pixel data of the I pixel 40-6 and the I pixel data of the I pixel 40-8 that are in an oblique positional relationship with respect to the Q pixel 40-5. Alternatively, an interpolation value may be obtained from an average value of I pixel data of four I pixels of the I pixel 40-2, the I pixel 40-4, the I pixel 40-6, and the I pixel 40-8.

The processing in step S15 is performed in all the I pixels and the Q pixels arranged on the pixel array unit 21, so that the interpolation value of the Q pixel in the vertical direction, the interpolation value of the Q pixel in the horizontal direction, and the interpolation value of the Q pixel in the oblique direction are obtained in all the I pixels, and the interpolation value of the I pixel in the vertical direction, the interpolation value of the I pixel in the horizontal direction, and the interpolation value of the I pixel in the oblique direction are obtained in all the Q pixels.

The obtained interpolation value is temporarily stored until the processing in steps S16 to S19 ends and the processing proceeds to step S20.

In step S16, an all-pixel image is generated. The all-pixel image is an image in which both I pixel data and Q pixel data are present in all pixels. However, the all-pixel image generated in step S16 is not a final distance measurement image, but is an image before the I pixel data and the Q pixel data are corrected by processing to be described later, and is an image generated for correction.

Referring to the image before demosaicing illustrated in the left diagram of Fig. 50, for example, since the Q pixel 40-5 has Q pixel data but has no I pixel data before demosaicing, I pixel data in the Q pixel 40-5 is generated. As an example, this generation is generated by obtaining an average value.

In a case where the I pixel data for the Q pixel 40-5 is generated, an average value of the I pixel data of the I pixel 40-2, the I pixel 40-4, the I pixel 40-6, and the I pixel 40-8 located around the Q pixel 40-5 is calculated. Such processing is performed, so that, as illustrated in the right diagram of Fig. 50, the pixel 40-5 becomes an I/Q pixel 40-5 having I pixel data and Q pixel data.

Note that the I pixel data or the Q pixel data can be obtained by calculation other than the average value. Furthermore, also, in the case of obtaining the average value, the average value can be obtained by using not only four pixels around a pixel to be processed but also 12 pixels.

The processing in step S16 is performed in all the I pixels and Q pixels arranged on the pixel array unit 21, so that Q pixel data is generated in all the I pixels and I pixel data is obtained in all the Q pixels.

Using the processing result of step S16, the processing of step S17 and the processing of step S18 are performed in parallel. Note that, although step S17 and step S18 will be described as processing performed in parallel, it is also possible to configure such that the remaining processing is executed after either processing is completed.

In step S17, edge determination processing is performed. The edge determination processing is performed by using the data interpolated in step S16 out of the I pixel data and the Q pixel data of the I/Q pixel 40 to be processed. For example, in a case where the I/Q pixel 40-5 is treated as a processing measure, since the I pixel data has been interpolated, the interpolated I pixel data is used, and it is determined in which direction the edge exists.

In a case where the I/Q pixel 40 obtained by interpolating the Q pixel data is to be processed, the Q pixel data is used, and it is determined in which direction the edge exists.

In step S18, a noise value is calculated. A noise value in the I/Q pixel to be processed is calculated. For example, in a case where the I/Q pixel 40-5 is to be processed, a noise value in the I/Q pixel 40-5 is calculated.

In step S19, the edge intensity is calculated. As the edge intensity, the intensity in the direction in which the edge is present is calculated from the edge of the I pixel data or the Q pixel data of the I/Q pixel 40 to be processed. The edge intensity is used as a blending ratio at the time of performing blending to be described later.

In a case where the edge intensity is calculated, a noise value calculated in step S18 is used to determine the reliability of the edge detected in step S17. In a case where the noise value is large, the edge detected in the I/Q pixel is considered to have low reliability, and the edge intensity in the detected edge direction is calculated to be a low value. In a case where the noise value is large, the edge detected in the I/Q pixel is determined to have high reliability, and the edge intensity of the detected edge is calculated to be a high value.

For example, in a case where the edge of the I/Q pixel 40-5 is in the vertical direction and the noise value is small, calculation is performed in step S19 such that the edge intensity in the vertical direction increases.

In a case where the edge intensity is calculated in step S19, the processing proceeds to step S20. In step S20, blending processing is executed based on the intensity in the interpolation direction.

The interpolation value in the longitudinal direction, the interpolation value in the lateral direction, and the interpolation value in the oblique direction of the I pixel data or the Q pixel data calculated in step S15 are blended according to the edge intensity (blending ratio), and the I pixel data or the Q pixel data of the I pixel 40 or the Q pixel 40 to be processed is calculated.

For example, in a case where the Q pixel 40-5 is to be processed, the noise value of the Q pixel 40-5 is small, and it has been detected that there is an edge in the vertical direction, I pixel data is generated by blending in which a value to be multiplied by the interpolation value in the vertical direction is set to be large. For example, blending is performed such that the interpolation value in the vertical direction is multiplied by 0.8, the interpolation value in the horizontal direction is multiplied by 0.1, and the interpolation value in the oblique direction is multiplied by 0.1.

The I pixel data or the Q pixel data calculated in step S20 is interpolated. With the interpolation, as illustrated in a right diagram of Fig. 50, all the pixels on the pixel array unit 21 can be I/Q pixels provided with I pixel data and Q pixel data.

In this manner, demosaic processing of generating the I pixel data and the Q pixel data by the addition processing or demosaic processing of generating the I pixel data and the Q pixel data by processing different from the addition processing is executed. As described with reference to Fig. 46, since this processing is performed by light emission, exposure, and reading of a laser at one time, a time required for generating one phase can be shortened.

### <Another arrangement example of I pixel and Q pixel>

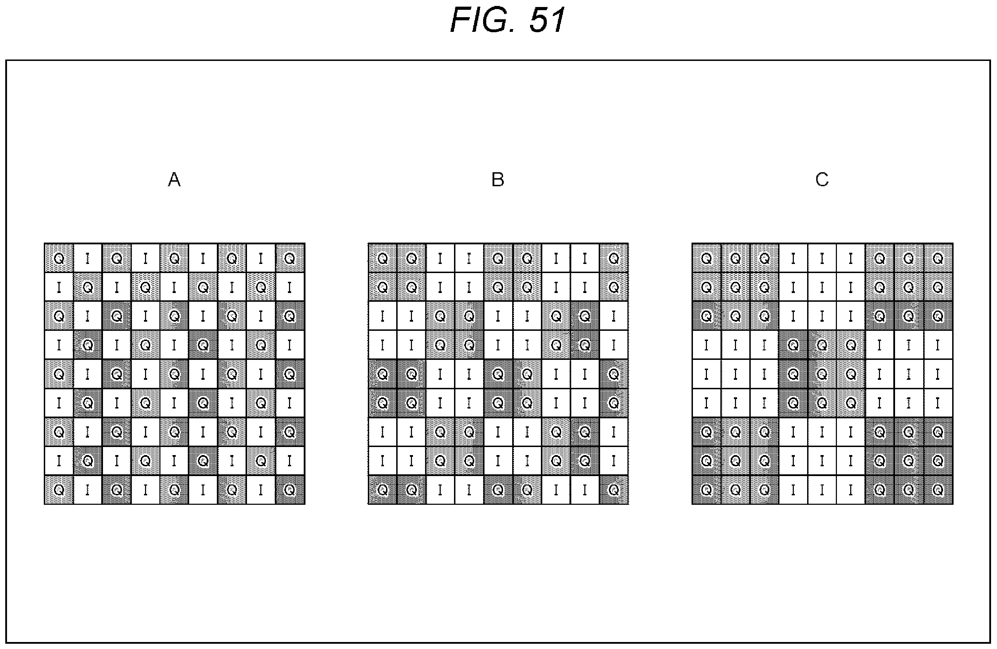

Fig. 51 is a diagram illustrating another pattern example in a case where the I pixels and the Q pixels are arranged in a staggered manner. A of Fig. 51 illustrates a pattern in which the I pixels and the Q pixels described above are alternately arranged one by one in each of the vertical direction and the horizontal direction.

B of Fig. 51 illustrates a pattern in which a pixel group of the Q pixels of four pixels of 2 x 2 and a pixel group of the I pixels of four pixels of 2 x 2 are alternately arranged in each of the vertical direction and the horizontal direction.

C of Fig. 51 illustrates a pattern in which a pixel group of the Q pixels of nine pixels of 3 x 3 and a pixel group of the I pixels of nine pixels of 3 x 3 are alternately arranged in each of the vertical direction and the horizontal direction.

As described above, the present technology can also be applied to a pattern in which a pixel group including a predetermined number, for example, 1, 4, or 9 I pixels and a pixel group including a predetermined number of Q pixels are alternately arranged.

### <Configuration example of distance measuring module>

Fig. 52 is a block diagram illustrating a configuration example of a distance measuring module that outputs distance measurement information using the above-described imaging element 10.

A distance measuring module 500 includes a light emitting unit 511, a light emission control unit 512, and a light receiving unit 513.

The light emitting unit 511 has a light source that emits light of a predetermined wavelength, and emits irradiation light of which brightness varies periodically to irradiate an object. For example, the light emitting unit 511 includes a light emitting diode that emits infrared light having a wavelength of 780 nm or more as a light source, and generates irradiation light in synchronization with a rectangular wave light emission control signal CLKp supplied from the light emission control unit 512.

Note that the light emission control signal CLKp is not limited to a rectangular wave as long as it is a periodic signal. For example, the light emission control signal CLKp may be a sine wave.

The light emission control unit 512 supplies the light emission control signal CLKp to the light emitting unit 511 and the light receiving unit 513 to control an irradiation timing of the irradiation light. The frequency of the light emission control signal CLKp is, for example, 20 megahertz (MHz). Note that the frequency of the light emission control signal CLKp is not limited to 20 megahertz, and may be 5 megahertz, 100 megahertz, or the like.

The light receiving unit 513 receives reflected light reflected from an object, calculates distance information for each pixel according to a light reception result, generates a depth image in which a depth value corresponding to a distance to the object (subject) is stored as a pixel value, and outputs the depth image.

### <Configuration example of electronic device>

The imaging element 10 can be applied not only to the distance measuring module as described above but also to various electronic devices such as an imaging device such as a digital still camera or a digital video camera having a distance measuring function, and a smartphone having a distance measuring function, for example.

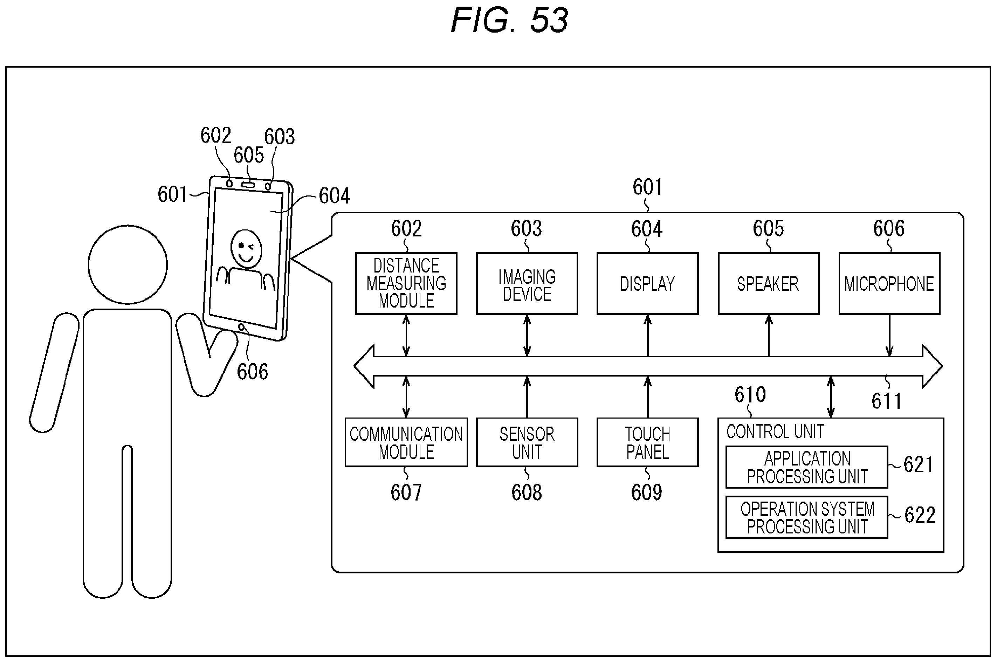

Fig. 53 is a block diagram depicting a configuration example of a smartphone serving as an electronic device to which the present technology is applied.

As illustrated in Fig. 53, a smartphone 601 includes a distance measuring module 602, an imaging device 603, a display 604, a speaker 605, a microphone 606, a communication module 607, a sensor unit 608, a touch panel 609, and a control unit 610 which are connected through a bus 611. Furthermore, the control unit 610 has functions as an application processing unit 621 and an operation system processing unit 622 by the CPU executing a program.

The distance measuring module 500 in Fig. 52 is applied to the distance measuring module 602. For example, the distance measuring module 602 is arranged in front of the smartphone 601, and performs distance measurement for the user of the smartphone 601, so that the depth value of the surface shape of the face, hand, finger, or the like of the user can be output as a distance measurement result.

The imaging device 603 is arranged on the front surface of the smartphone 601, and performs imaging of the user of the smartphone 601 as a subject to obtain an image in which the user is imaged. Note that, although not depicted, the imaging device 603 may also be arranged on a rear surface of the smartphone 601.

The display 604 displays an operation screen for performing processing by the application processing unit 621 and the operation system processing unit 622, an image captured by the imaging device 603, and the like. The speaker 605 and the microphone 606 output the voice of the other party and collect the voice of the user, for example, when making a call using the smartphone 601.

The communication module 607 performs network communication via the Internet, a public telephone line network, a wide area communication network for a wireless mobile body such as a so-called 4G line or a 5G line, a communication network such as a wide area network (WAN) or a local area network (LAN), near field communication such as Bluetooth (registered trademark) or near field communication (NFC), or the like. The sensor unit 608 senses speed, acceleration, proximity and the like, and the touch panel 609 obtains a touch operation by the user on an operation screen displayed on the display 604.

The application processing unit 621 performs processing for providing various services by the smartphone 601. For example, the application processing unit 621 can perform processing of creating a face by computer graphics virtually reproducing the expression of the user on the basis of the depth value supplied from the distance measuring module 602 and displaying the created face on the display 604. Furthermore, the application processing unit 621 can perform processing of creating three-dimensional shape data of any three-dimensional object on the basis of the depth value supplied from the distance measuring module 602, for example.

The operation system processing unit 622 performs processing for achieving basic functions and operations of the smartphone 601. For example, the operation system processing unit 622 can perform processing of authenticating the user's face, and unlocking the smartphone 601 on the basis of the depth value supplied from the distance measuring module 602. Furthermore, the operation system processing unit 622 can perform, for example, processing of recognizing a gesture of the user on the basis of the depth value supplied from the distance measuring module 602, and processing of inputting various operations according to the gesture.

In the smartphone 601 configured as described above, the above-described distance measuring module 500 is applied as the distance measuring module 602, for example, so that processing of measuring and displaying the distance to a predetermined object, processing of creating and displaying three-dimensional shape data of the predetermined object, and the like can be performed.

### < Application example to mobile body>

The technology according to the present disclosure (the present technology) can be applied to various products. For example, the technology of the present disclosure may be achieved in the form of a device to be mounted on a mobile object of any kind, such as an automobile, an electric vehicle, a hybrid electric vehicle, a motorcycle, a bicycle, a personal mobility, an airplane, a drone, a vessel, or a robot.

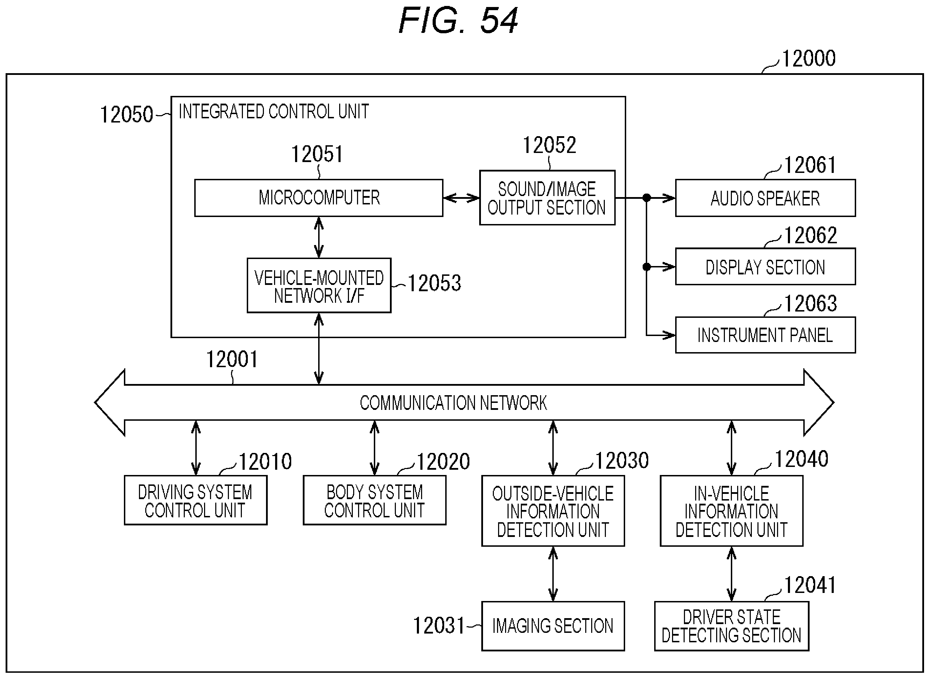

Fig. 54 is a block diagram illustrating a schematic configuration example of a vehicle control system which is an example of a moving body control system to which the technology according to the present disclosure can be applied.

The vehicle control system 12000 includes a plurality of electronic control units connected to each other via a communication network 12001. In the example illustrated in Fig. 54, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of Fig. 54, an audio speaker 12061, a display section 12062, and an instrument panel 12063 are illustrated as the output device. The display section 12062 may, for example, include at least one of an on-board display and a head-up display.

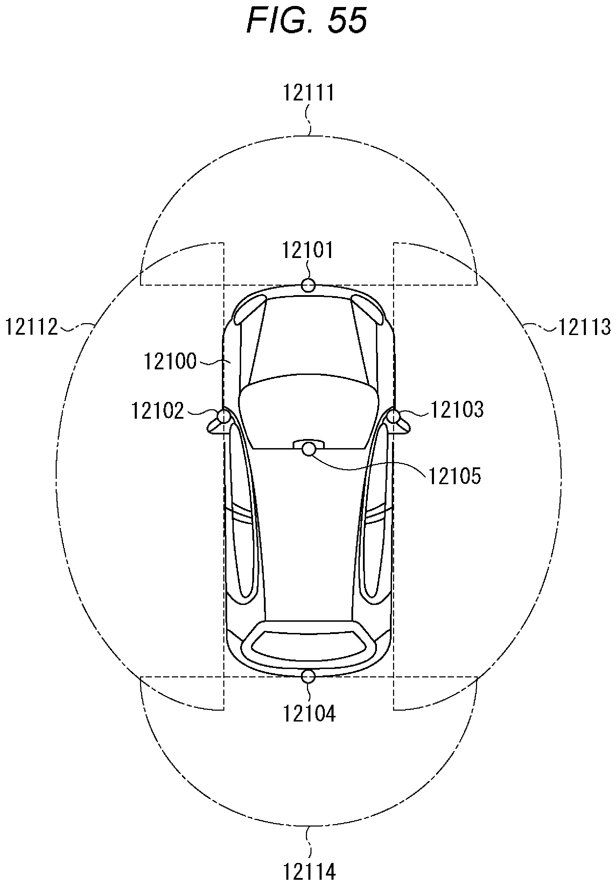

Fig. 55 is a diagram illustrating an example of the installation position of the imaging section 12031.

In Fig. 55, imaging sections 12101, 12102, 12103, 12104, and 12105 are included as the imaging section 12031.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Note that, Fig. 55 illustrates an example of imaging ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

In the present specification, the system represents the entire device including a plurality of devices.

Note that the effects described in the present description are merely examples and are not limited, and other effects may be provided.

Note that the embodiments of the present technology are not limited to the above-described embodiments, and various changes can be made without departing from the gist of the present technology.

Note that the present technology can also have the following configurations.
(1) An imaging element including:
   a photoelectric conversion unit configured to perform photoelectric conversion;
   first and second charge storage units configured to store a charge obtained by the photoelectric conversion unit;
   a first transfer unit configured to transfer the charge from the photoelectric conversion unit to the first charge storage unit;
   a second transfer unit configured to transfer the charge from the photoelectric conversion unit to the second charge storage unit; and
   a wiring layer provided with a plurality of wirings,
   in which a first wiring connected to the first transfer unit and a second wiring connected to the second transfer unit are arranged in the wiring layer,
   a drive wiring configured to supply a drive signal or/and a fixed voltage wiring configured to supply a predetermined voltage are arranged, and
   the number of the drive wirings or/and the fixed voltage wirings adjacent to the first wiring, and the number of the drive wirings or/and the fixed voltage wirings adjacent to the second wiring are the same.
(2) The imaging element according to (1),
   in which the drive wiring is a wiring that supplies a drive signal to an overflow transistor, a reset transistor, an amplification transistor, or a selection transistor.
(3) The imaging element according to (1) or (2),
   in which the drive wiring is a wiring that supplies a fixed voltage to an overflow transistor, a reset transistor, or an amplification transistor.
(4) The imaging element according to any one of (1) to (3),
   in which the drive line adjacent to the first wiring and the drive wiring adjacent to the second wiring are wirings that supply drive signals of transistors having the same function.
(5) The imaging element according to any one of (1) to (4),
   in which the fixed voltage wiring adjacent to the first wiring and the fixed voltage wiring adjacent to the second wiring are wirings that supply the same voltage.
(6) The imaging element according to any one of (1) to (5),
   in which the first wiring, and the drive wiring or/and the fixed voltage wiring adjacent to the first wiring are connected to a first pixel, and
   the second wiring, and the drive wiring or/and the fixed voltage wiring adjacent to the second wiring are connected to a second pixel.
(7) The imaging element according to any one of (1) to (6),
   in which the drive wiring also includes the first wiring, the second wiring, or a wiring of a photogate transistor.
(8) The imaging element according to any one of (1) to (7),
   in which the number includes the drive wiring or/and the fixed voltage wiring disposed in a wiring layer different from a wiring layer in which the first wiring and the second wiring are disposed and adjacent to the first wiring or the second wiring.
(9) The imaging element according to any one of (1) to (8),
   in which a wiring connected to a vertical transistor is adjacent to the first wiring, and a wiring connected to the vertical transistor is adjacent to the second wiring.
(10) The imaging element according to (2),
   in which the first wiring and the wiring of the overflow transistor are connected to the same power supply.
(11) The imaging element according to any one of (1) to (10), further including a floating diffusion,
   in which the floating diffusion is shared by a pixel group including a plurality of pixels, and
   the imaging element further includes a link transistor that connects the floating diffusion arranged in an adjacent pixel group.
(12) The imaging element according to (11),
   in which the drive wiring also includes a wiring connected to the link transistor.
(13) The imaging element according to (11) or (12),
   in which a reset transistor is connected in series to the link transistor.
(14) The imaging element according to any one of (11) to (13), in which the link transistor is provided in the pixel group.
(15) The imaging element according to any one of (11) to (14),
   in which the link transistor is provided between the pixel groups.
(16) The imaging element according to any one of (11) to (15),
   in which the pixel is an I pixel that acquires an in-phase component signal for a modulated wave of light, or a Q pixel that acquires a quadrature component signal for a modulated wave of light.
(17) The imaging element according to (16),
   in which in one phase, phase signals having a phase of 0° and a phase of 180° are acquired in the I pixel, and phase signals having a phase of 90° and a phase of 270° are acquired in the Q pixel.
(18) The imaging element according to (16) or (17),
   in which I pixel data from the I pixel included in a pixel group including a predetermined number of I pixels and Q pixels is added to generate the I pixel data in a case where the pixel group is set to one pixel, and Q pixel data from the Q pixel is added to generate the Q pixel data in a case where the pixel group is set to one pixel.
(19) The imaging element according to (16) to (18),
   in which the Q pixel data is generated in the I pixel by generating the Q pixel data in a vertical direction, the Q pixel data in a horizontal direction, and the Q pixel data in an oblique direction by using the Q pixel data from the Q pixel adjacent to the I pixel, and blending the Q pixel data with a blend ratio based on an edge direction set according to reliability calculated from noise information in the I pixel, and
   the I pixel data is generated in the Q pixel by generating the I pixel data in the vertical direction, the I pixel data in the horizontal direction, and the I pixel data in the oblique direction by using the I pixel data from the I pixel adjacent to the Q pixel, blending the I pixel data with a blend ratio based on an edge direction set according to reliability calculated from noise information in the Q pixel.
(20) A distance measuring device according to another aspect of the present technology including: a light emitting unit that emits irradiation light; and a light receiving element that receives reflected light obtained by reflecting light from the light emitting unit to an object, in which the light receiving element includes: a photoelectric conversion unit configured to perform photoelectric conversion; first and second charge storage units configured to store a charge obtained by the photoelectric conversion unit; a first transfer unit configured to transfer the charge from the photoelectric conversion unit to the first charge storage unit; a second transfer unit configured to transfer the charge from the photoelectric conversion unit to the second charge storage unit; and a wiring layer provided with a plurality of wirings, in which a first wiring connected to the first transfer unit and a second wiring connected to the second transfer unit are arranged in the wiring layer, and a drive wiring configured to supply a drive signal or/and a fixed voltage wiring configured to supply a predetermined voltage are arranged therein, and the number of the drive wirings or/and the fixed voltage wirings adjacent to the first wiring, and the number of the drive wirings or/and the fixed voltage wirings adjacent to the second wiring are the same.

### REFERENCE SIGNS LIST

- 10: Imaging element
- 21: Pixel array unit
- 22: Vertical drive unit
- 23: Column processing unit
- 24: Horizontal drive unit
- 25: System control unit
- 26: Pixel drive line
- 27: Vertical signal line
- 28: Signal processing unit
- 29: Data storage unit
- 31: Power supply circuit
- 32: Power supply circuit
- 40: Pixel
- 41: Semiconductor substrate
- 42: Wiring layer
- 43: Antireflection film
- 44: Pixel boundary
- 45: Inter-pixel light shielding film
- 46: Planarization film
- 47: On-chip lens
- 50: Pixel
- 51: Semiconductor region
- 52: Semiconductor region
- 53: Hafnium oxide film
- 54: Aluminum oxide film
- 55: Silicon oxide film
- 61: Inter-pixel isolation portion
- 71: Uneven structure portion
- 111: Drive wiring
- 112: Wiring
- 113: Wiring
- 114: Drive wiring
- 115: Wiring
- 116: Wiring
- 117: Drive wiring
- 131: Fixed voltage wiring
- 132: Drive wiring
- 133: Fixed voltage wiring
- 134: Drive wiring
- 135: Fixed voltage wiring
- 136: SEL gate wiring
- 151: Adjacent wiring
- 152: Transfer gate wiring
- 153: Adjacent wiring
- 154: Transfer gate wiring
- 155: Adjacent wiring
- 161: Adjacent wiring
- 162: Adjacent wiring
- 205: Signal retrieving unit
- 221: Transfer transistor
- 222: Floating diffusion
- 223: Reset transistor
- 224: Amplification transistor
- 225: Selection transistor
- 226: Constant current source circuit unit
- 231: Vertical signal line

## Claims

1. An imaging element comprising:
a photoelectric conversion unit configured to perform photoelectric conversion;
first and second charge storage units configured to store a charge obtained by the photoelectric conversion unit;
a first transfer unit configured to transfer the charge from the photoelectric conversion unit to the first charge storage unit;
a second transfer unit configured to transfer the charge from the photoelectric conversion unit to the second charge storage unit; and
a wiring layer provided with a plurality of wirings,
wherein a first wiring connected to the first transfer unit and a second wiring connected to the second transfer unit are arranged in the wiring layer,
a drive wiring configured to supply a drive signal or/and a fixed voltage wiring configured to supply a predetermined voltage are arranged therein, and
the number of the drive wirings or/and the fixed voltage wirings adjacent to the first wiring, and the number of the drive wirings or/and the fixed voltage wirings adjacent to the second wiring are the same.

2. The imaging element according to claim 1,
wherein the drive wiring is a wiring that supplies a drive signal to an overflow transistor, a reset transistor, an amplification transistor, or a selection transistor.

3. The imaging element according to claim 1,
wherein the drive wiring is a wiring that supplies a fixed voltage to an overflow transistor, a reset transistor, or an amplification transistor.

4. The imaging element according to claim 1,
wherein the drive line adjacent to the first wiring and the drive wiring adjacent to the second wiring are wirings that supply drive signals of transistors having the same function.

5. The imaging element according to claim 1,
wherein the fixed voltage wiring adjacent to the first wiring and the fixed voltage wiring adjacent to the second wiring are wirings that supply the same voltage.

6. The imaging element according to claim 1,
wherein the first wiring, and the drive wiring or/and the fixed voltage wiring adjacent to the first wiring are connected to a first pixel, and
the second wiring, and the drive wiring or/and the fixed voltage wiring adjacent to the second wiring are connected to a second pixel.

7. The imaging element according to claim 1,
wherein the drive wiring further includes the first wiring, the second wiring, or a wiring of a photogate transistor.

8. The imaging element according to claim 1,
wherein the number includes the drive wiring or/and the fixed voltage wiring disposed in a wiring layer different from a wiring layer in which the first wiring and the second wiring are disposed and adjacent to the first wiring or the second wiring.

9. The imaging element according to claim 1,
wherein a wiring connected to a vertical transistor is adjacent to the first wiring, and a wiring connected to the vertical transistor is adjacent to the second wiring.

10. The imaging element according to claim 2,
wherein the first wiring and the wiring of the overflow transistor are connected to the same power supply.

11. The imaging element according to claim 1, further comprising a floating diffusion,
wherein the floating diffusion is shared by a pixel group including a plurality of pixels, and
the imaging element further comprises a link transistor that connects the floating diffusion arranged in an adjacent pixel group.

12. The imaging element according to claim 11,
wherein the drive wiring further includes a wiring connected to the link transistor.

13. The imaging element according to claim 11,
wherein a reset transistor is connected in series to the link transistor.

14. The imaging element according to claim 11,
wherein the link transistor is provided in the pixel group.

15. The imaging element according to claim 11,
wherein the link transistor is provided between the pixel groups.

16. The imaging element according to claim 11,
wherein the pixel is an I pixel that acquires an in-phase component signal for a modulated wave of light, or a Q pixel that acquires a quadrature component signal for a modulated wave of light.

17. The imaging element according to claim 16,
wherein in one phase, phase signals having a phase of 0° and a phase of 180° are acquired in the I pixel, and phase signals having a phase of 90° and a phase of 270° are acquired in the Q pixel.

18. The imaging element according to claim 16,
wherein I pixel data from the I pixel included in a pixel group including a predetermined number of I pixels and Q pixels is added to generate the I pixel data in a case where the pixel group is set to one pixel, and Q pixel data from the Q pixel is added to generate the Q pixel data in a case where the pixel group is set to one pixel.

19. The imaging element according to claim 16,
wherein the Q pixel data is generated in the I pixel by generating the Q pixel data in a vertical direction, the Q pixel data in a horizontal direction, and the Q pixel data in an oblique direction by using the Q pixel data from the Q pixel adjacent to the I pixel, and blending the Q pixel data with a blend ratio based on an edge direction set according to reliability calculated from noise information in the I pixel, and
the I pixel data is generated in the Q pixel by generating the I pixel data in the vertical direction, the I pixel data in the horizontal direction, and the I pixel data in the oblique direction by using the I pixel data from the I pixel adjacent to the Q pixel, blending the I pixel data with a blend ratio based on an edge direction set according to reliability calculated from noise information in the Q pixel.

20. A distance measuring device comprising:
a light emitting unit that emits irradiation light; and
a light receiving element that receives reflected light obtained by reflecting light from the light emitting unit to an object,
wherein the light receiving element includes: a photoelectric conversion unit configured to perform photoelectric conversion; first and second charge storage units configured to store a charge obtained by the photoelectric conversion unit; a first transfer unit configured to transfer the charge from the photoelectric conversion unit to the first charge storage unit; a second transfer unit configured to transfer the charge from the photoelectric conversion unit to the second charge storage unit; and a wiring layer provided with a plurality of wirings, in which a first wiring connected to the first transfer unit and a second wiring connected to the second transfer unit are arranged in the wiring layer, and a drive wiring configured to supply a drive signal or/and a fixed voltage wiring configured to supply a predetermined voltage are arranged therein, and the number of the drive wirings or/and the fixed voltage wirings adjacent to the first wiring, and the number of the drive wirings or/and the fixed voltage wirings adjacent to the second wiring are the same.
